# EUROPEAN PATENT SPECIFICATION

(11) **EP 2 157 478 B1**
(45) Date of publication and mention of the grant of the patent: **29.05.2013**
(21) Application number: 09168022.3
(22) Date of filing: 18.08.2009
(51) Int. Cl.: G03F 7/32, G03F 7/031, G03F 7/032

(54) **Method of producing lithographic printing plate**
Verfahren zur Herstellung einer Flachdruckplatte
Procédé de fabrication d'une plaque d'impression lithographique

(30) Priority: 22.08.2008 JP 2008214249; 16.02.2009 JP 2009032894
(43) Date of publication of application: 24.02.2010
(73) Proprietor: Fujifilm Corporation, Minato-ku Tokyo 106-8620 (JP)
(72) Inventor: Kuramoto, Mamoru, Haibara-gun Shizuoka (JP); Kawauchi, Ikuo, Haibara-gun Shizuoka (JP); Adachi, Keiichi, Haibara-gun Shizuoka (JP); Hirano, Mitsunori, Haibara-gun Shizuoka (JP); Wariishi, Koji, Haibara-gun Shizuoka (JP)
(74) Representative: Grünecker, Kinkeldey, Stockmair & Schwanhäusser

(56) References cited:
- EP-A1- 1 172 699
- EP-A1- 1 199 606
- EP-A1- 1 862 301
- EP-A2- 1 216 830
- EP-A2- 1 947 514

## Description

### BACKGROUND OF THE INVENTION

### Field of the Invention

The present invention relates to a method of producing a lithographic printing plate and more particularly relates to a method of producing a lithographic printing plate that exhibits a high processing capacity and that can be processed with a single processing liquid.

### Description of the Related Art

A lithographic printing plate typically comprises an oleophilic image area that is ink receptive during the printing process and a hydrophilic nonimage area that is fountain solution receptive during the printing process. Lithographic printing is a method that utilizes the fact that water and printing ink repel each other: differences in the ink attachment behavior are produced on the surface of the lithographic printing plate by using the oleophilic image areas on the lithographic printing plate as ink receptive areas and using the hydrophilic nonimage areas on the lithographic printing plate as fountain solution receptive areas (areas not receptive to ink). After ink uptake has been brought about only in the image areas, the ink is transferred to the receiving medium, e.g., paper.

A lithographic printing plate precursor (PS plate) comprising an oleophilic photosensitive resin layer (photosensitive layer, image recording layer) disposed on a hydrophilic support has heretofore been widely used to produce the aforementioned lithographic printing plate. Platemaking is typically carried out by a nonimage region formation method in which the lithographic printing plate precursor is exposed to light through an original image, for example, a lith film, after which the areas forming the image areas of the image recording layer remain while the unwanted image recording layer outside these areas is dissolved and removed by an alkaline developing solution or an organic solvent, thus yielding the lithographic printing plate.

This platemaking process with a conventional lithographic printing plate precursor requires a post-photoexposure step in which the unwanted image recording layer is dissolved and removed using, for example, a development liquid. Environmental and safety issues here include the generation of less waste solution and the ability to carry out processing using a development liquid that is nearer to the neutral region. In particular, the disposal of waste solutions generated in association with wet processes has in recent years become a matter of great interest for the industrial sector as a whole out of concern for the environment and the desire to address the issues cited above has grown ever stronger.

At the same time, digital technology, in which the image data is electronically processed, stored, and output using a computer, has become widespread during the last few years, and various new image output methods have entered into practice in association with this digital technology. Accompanying this, interest has been growing in computer-to-plate (CTP) technology, in which the digitized image data is carried by a highly convergent beam of radiation, for example, laser light, and the lithographic printing plate precursor is subjected to a scanning photoexposure with this light in order to directly produce the lithographic printing plate without going through lith film. As a consequence, the appearance of lithographic printing plate precursors adapted to this technology has become a technical problem of the utmost importance.

As noted above, lowering the basicity of the development liquid and simplifying the processing sequence have become even more strongly desired than in the past based on the twin considerations of (i) concern for the environment and (ii) meeting demands for lowering space requirements and lowering the running costs. However, the conventional development processing sequence as described above has consisted of three steps, i.e., development with a basic aqueous solution having a pH of at least 11 followed by rinsing off the base with a water rinse bath and then treatment with a gum solution based on a hydrophilic resin. As a consequence, an automatic developer by itself takes up a great deal of space, while problems also still remain in terms of environmental and running cost issues, for example, the issue of the development waste solution, the waste solution from the water rinse, and treatment of the gum waste solution.

In contrast to this, the development method provided in Japanese Patent Application Publication No. H 11-65126 comprises processing with a development liquid that contains alkali metal carbonate and bicarbonate and that has a pH of 8.5 to 11.5 and a conductivity of 3 to 30 mS/cm. However, this method requires a water rinse step and a gum solution treatment step and thus does not fully address the environmental and running cost issues.

Processing with a pH 11.9 to 12.1 processing liquid that contains a water-soluble polymer compound is described in the examples of EP 1868036 A. However, in its native state the printing plate yielded by this processing has a pH 12 base adhering on the plate surface. Not only does this create problems with regard to worker safety, but the image areas gradually dissolve when the time interval after printing plate preparation up to printing becomes prolonged, which causes a decline in the printing durability and a decline in ink receptivity. Processing with a pH 3 to 9 processing liquid that contains a water-soluble polymer compound is described in Japanese Translation of PCT No. 2007-538279. However, since this processing liquid does not contain a base component, the polymer of the photosensitive layer must be rendered hydrophilic in order to provide developability, which leads to a substantial decline in the printing durability.

A method is provided in Japanese Patent No. 3,784,931 in which development is carried out with an aqueous solution of alkali metal carbonate and bicarbonate. This method, however, is provided with a gum solution treatment step and thus does not address the environmental concerns cited above and does not provide a solution with regard to lowering the running costs or saving on space. A modality is described in WO 2007/144096 in which a gum treatment step is not carried out after development using a pH 9.5 to 14 base solution, but this modality is still unsatisfactory with regard to development processability, plate surface stickiness after development, development scum, and fitness for repeated running.

In addition, since EP 1868036 A and WO 2007/14496 concern modalities in which a gum solution treatment step is not carried out, in each case the surface protection performance is poor, i.e., the nonimage areas are easily contaminated by external agents, and a particular problem has been print scumming that is produced when the nonimage areas of the plate are held with bare hands post-development (also referred to hereafter as fingerprint scumming).

EP-A1-1862301 relates to an image recording material which is preferably used as a negative working planographic printing plate precursor which allows direct plate-making, in which the precursor is directly made into a printing plate using a laser based on digital signals outputted from a computer or the like.

EP-A2-1216850 relates to a negative photosensitive lithographic printing plate which is suitable for drawing with a laser beam.

EP-A1-1172699 relates to a plate-making method of a lithographic printing plate comprising the steps of exposure of a photosensitive lithographic printing plate and development with a developing solution.

EP-A1-1199606 relates to a plate making method of a lithographic printing plate comprising exposing imagewise a photosensitive lithographic printing plate and developing the exposed printing plate with a developing solution.

EP-A2-1947514 relates to a method for preparation of a lithographic printing plate comprising exposing with laser a lithographic printing plate precursor and subjecting the exposed lithographic printing plate precursor to development processing.

### DISCLOSURE OF THE INVENTION

### Problem to be solved by the Invention

Accordingly, an object of the present invention is to provide a method of producing a lithographic printing plate that overcomes the previously described drawbacks to the prior art. A specific object of the present invention is to provide a method of producing a safe lithographic printing plate that exhibits an excellent developability and an excellent processing performance. A further object of the present invention is to provide a method of producing a lithographic printing plate which enables single liquid processing and in which the obtained plate does not exhibit an impaired printing durability, does not exhibit a decline in printing durability even when the printing plate is stored after development before printing, and can inhibit the appearance of fingerprint scumming. This single liquid processing means that the development processing and gumming treatment, which are the minimal requirements in the standard process, are carried out at the same time in a single liquid.

### Means to Solve the Problem

As a result of intensive investigations, the present inventor discovered that the previously cited objects are achieved by a lithographic printing plate production method having the structure described in the following. The present invention was achieved based on this discovery.

Accordingly, the present invention is a method of producing a lithographic printing plate, comprising:
imagewise photoexposing a negative-working lithographic printing plate precursor that has an image-recording layer containing the (i), (ii), (iii), and (iv) described below on a hydrophilic support; and
treating thereafter the imagewise-photoexposed negative-working lithographic printing plate precursor with an aqueous solution that has a pH of 8.5 to 10.8 and that contains a low molecular weight hydroxycarboxylic acid ion having a molecular weight of no greater than 500, wherein the low molecular weight hydroxycarboxylic acid ion is an ion of a hydroxycarboxylic acid that has at least one carboxylic acid group and at least two hydroxyl groups, a basic pH buffer, and a surfactant:
   (i) sensitizing dye
   (ii) polymerization initiator
   (iii) an addition-polymerizable compound that has an ethylenically unsaturated double bond
   (iv) binder polymer.

The aqueous solution used by the present invention may also contain a water-soluble resin. The low molecular weight hydroxycarboxylic acid ion present in the aqueous solution used by the present invention can be exemplified by the ions of hydroxycarboxylic acids that have at least two carboxylic acid groups and can be specifically exemplified by a tartaric acid ion. Other examples of the low molecular weight hydroxycarboxylic acid ion contained in the aqueous solution used by the present invention are the ions of hydroxycarboxylic acids that have at least one carboxylic acid group and at least two hydroxyl groups. Additional specific examples are the ions of hydroxycarboxylic acids that have at least four hydroxyl groups.

Amphoteric surfactants are an example of the surfactant contained in the aqueous solution used by the present invention.

The pH buffer contained in the aqueous solution used by the present invention can be exemplified by (a) a carbonate ion and a bicarbonate ion, (b) a borate ion, (c) a water-soluble amine compound and an ion of this water-soluble amine compound, and combinations of the preceding. The use is preferred among the preceding of (a) the carbonate ion and bicarbonate ion.

In an exemplary embodiment of the method of the present invention for producing a lithographic printing plate, the sensitizing dye (i) in the negative-working lithographic printing plate precursor has an absorption maximum in the wavelength range from 350 nm to 450 nm. Imagewise photoexposure can be carried out in the method of the present invention for producing a lithographic printing plate using a laser that emits light at from 350 nm to 450 nm.

The (iv) binder polymer in the negative-working lithographic printing plate precursor used by the present invention can be exemplified by binder polymer having an acid group (e.g., the carboxylic acid group) in side chain position. This negative-working lithographic printing plate precursor can also be exemplified by a negative-working lithographic printing plate precursor that has a protective layer on the image-recording layer. A protective layer containing acid-modified polyvinyl alcohol is an exemplary embodiment of such a protective layer.

Using the aqueous solution described in the preceding, the inventive method of producing a lithographic printing plate can be carried out by a single liquid process.

The present invention is additionally directed to the lithographic printing plate obtained by the production method described in the preceding.

### Effect of the Invention

The platemaking method of the present invention can provide a lithographic printing plate that is resistant to fingerprint scumming, i.e., even when a fingerprint has been applied to the plate, scumming during printing either does not occur or is inhibited. The platemaking method of the present invention provides an excellent scumming inhibition and an excellent processing performance, provides resistance to the appearance of development scum, and eliminates post-development stickiness by the plate surface.

In addition, the lithographic printing plate yielded by the present invention has an excellent printing durability and does not suffer from a decline in printing durability even when the plate is stored after development prior to printing.

Moreover, the present invention, by making possible single liquid development using a weakly basic processing liquid, provides other advantages, such as high safety, simplification of the process sequence, and responsiveness to environmental concerns, the desire for space savings, and the desire for lower running costs.

### Brief Description of the Drawings

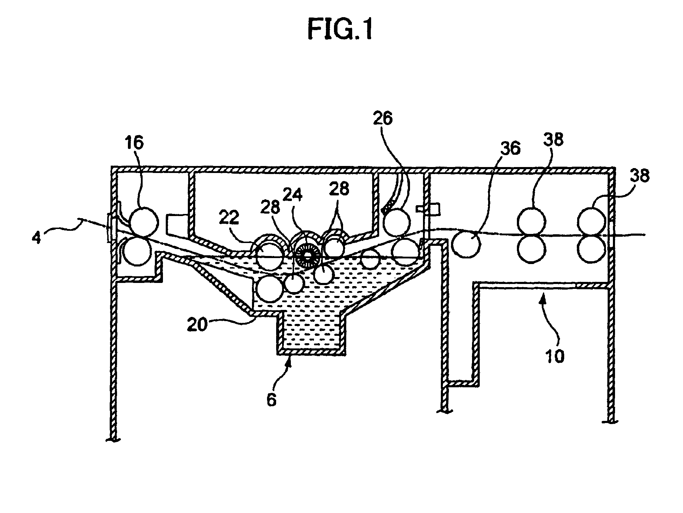

Figure 1 is a descriptive diagram that shows the structure of an automatic developer apparatus.

### Mode for Carrying Out the Invention

### The negative-working lithographic printing plate precursor

The structure of the negative-working lithographic printing plate precursor of the present invention will be described in sequence.

### The support

The support in the lithographic printing plate precursor used by the present invention will be described first.

Any support that has a hydrophilic surface can be used as the support under consideration, but a dimensionally stable sheet is preferred, for example, paper; plastic-laminated paper (the plastic can be exemplified by polyethylene, polypropylene, polystyrene, and so forth); a sheet of a metal such as aluminum (including aluminum alloys), zinc, copper, and so forth, or of an alloy of the preceding (for example, alloys with silicon, copper, manganese, magnesium, chromium, zinc, lead, bismuth, or nickel); plastic film, e.g., of cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, and so forth; and paper or plastic film on which any of the aforementioned metals or alloys has been laminated or vapor-deposited. Aluminum sheet is particularly preferred among the preceding supports because it exhibits a substantial dimensional stability while also being inexpensive. Also preferred is composite sheet comprising aluminum sheet bonded on a polyethylene terephthalate film, as described in Japanese Examined Patent Publication No. S48-18327. The support thickness is generally about 0.05 mm to 1 mm.

When the support has a surface of a metal and particularly of aluminum, the surface is preferably treated, as described below, for example, by a graining treatment; by immersion in an aqueous solution of, for example, sodium silicate, potassium fluozirconate, a phosphate salt, and so forth; or by anodic oxidation.

### The graining treatment

The following methods can be used for the graining treatment method: electrochemical graining, in which graining is performed electrochemically in a hydrochloric acid or nitric acid electrolyte bath, and mechanical graining such as wire brush graining (the aluminum surface is abraded with metal wire), ball graining (the aluminum surface is grained with abrasive balls and an abrasive), and brush graining (the surface is grained using a nylon brush and an abrasive). A single such graining method or a combination of these graining methods may be used. For example, methods for carrying out mechanical graining, chemical etching, and electrolytic graining are described in Japanese Patent Application Publication No. S56-28893.

The electrochemical method, in which chemical graining is performed in a hydrochloric acid or nitric acid electrolyte bath, is a specific method for producing an effective surface roughness, and a suitable current density is in the range of 100 C/dm² to 400 C/dm². More specifically, electrolysis is preferably carried out at a temperature of 20 to 100°C for a time of 1 second to 30 minutes at a current density of 100 C/dm² to 400 C/dm² in an electrolyte bath containing 0.1 to 50% hydrochloric acid or nitric acid.

The aluminum support grained in the described manner is chemically etched using acid or base. A lengthy period of time is required to break down the microstructure when acid is used as the etchant. This problem can be ameliorated by the use of base as the etchant. Bases suitable for use can be exemplified by sodium hydroxide, sodium carbonate, sodium aluminate, sodium metasilicate, sodium phosphate, potassium hydroxide, lithium hydroxide, and so forth. A preferred concentration range is 1 to 50%; a preferred temperature range is 20 to 100°C; and preferred conditions produce 5 to 20 g/m³ for the amount of aluminum dissolution.

After etching, an acid rinse is carried out in order to remove the smut remaining on the surface. The acid used can be exemplified by nitric acid, sulfuric acid, phosphoric acid, chromic acid, hydrofluoric acid, hydrofluoboric acid, and so forth. Contact with 15 to 65 mass% sulfuric acid at 50 to 90°C as described in Japanese Patent Application Publication No. S53-12739 and the base etch described in Japanese Patent Publication No. S48-28123 are preferred examples of the desmutting method in particular after an electrochemical surface roughening treatment.

A preferred surface roughness (Ra) for an aluminum support is 0.3 to 0.7 µm.

### The anodic oxidation treatment

The aluminum support grained as described above may additionally be subjected to an anodic oxidation treatment. This anodic oxidation treatment can be carried out by a method heretofore employed in the pertinent technical field.

In specific terms, an anodic oxidation film can be formed on the surface of the aluminum support when direct or alternating current is passed through the aluminum in an aqueous solution or nonaqueous solution of, for example, sulfuric acid, phosphoric acid, chromic acid, oxalic acid, sulfamic acid, benzenesulfonic acid, and so forth, or a combination of at least two of the preceding.

The anodic oxidation treatment conditions cannot be rigorously specified because they vary substantially as a function of the electrolyte bath used, but the following ranges are generally suitable: electrolyte bath concentration = 1 to 80%, bath temperature = 5 to 70°C, current density = 0.5 to 60 A/dm², voltage = 1 to 100 V, and electrolysis time = 10 to 100 seconds.

The following are particularly preferred methods for the anodic oxidation treatment under consideration: anodic oxidation at high current densities in sulfuric acid as described in British Patent No. 1,412,768 (Specification); anodic oxidation using a phosphoric acid electrolysis bath as described in US 3,511,661 (Specification).

The anodic oxidation film is preferably 1 to 10 g/m². The plate is easily damaged at less than 1 g/m², while large amounts of power are required for production at above 10 g/m², making this economically disadvantageous. 1.5 to 7 g/m² is preferred while 2 to 5 g/m² is more preferred.

A sealing treatment may additionally be performed after the support has been subjected to the graining treatment and anodic oxidation treatment. The sealing treatment is carried out, for example, using a steam bath or by immersing the support in hot water or in a hot water solution containing inorganic salt or organic salt. The support may also be subjected to a surface treatment, e.g., a silicate treatment with an alkali metal silicate salt or immersion in an aqueous solution of, for example, potassium fluozirconate or a phosphate salt.

The lithographic printing plate precursor is formed by coating an image recording layer, for example, a photopolymerizable photosensitive composition, on the support (when the support is aluminum sheet, the support is preferably aluminum sheet that has been subjected to a suitable surface treatment as described above), followed as necessary by the application of a protective layer. However, an organic or inorganic undercoat layer may optionally be provided prior to application of the image recording layer, and a sol-gel treatment - in which functional groups capable of undergoing a radical addition reaction are covalently bonded to the support surface, as described in Japanese Patent Application Publication No. H 7-159983 - may also optionally be executed prior to application of the image recording layer.

The substance forming the organic undercoat layer can be exemplified by water-soluble resins, for example, polyvinylphosphonic acid, polymers and copolymers that have the sulfonic acid group in side change position, polyacrylic acid, yellow dyes, amine salts, and so forth.

In specific terms, the organic compound used in an organic undercoat layer can be selected from, for example, carboxymethyl cellulose; dextrin; gum arabic; organic phosphonic acids, e.g., amino-functional phosphonic acids such as 2-aminoethylphosphonic acid as well as possibly substituted phenylphosphonic acid, naphthylphosphonic acid, alkylphosphonic acid, glycerophosphonic acid, polyvinylphosphonic acid, methylenediphosphonic acid, and ethylenediphosphonic acid; organic phosphoric acids such as possibly substituted phenylphosphoric acid, naphthylphosphoric acid, alkylphosphoric acid, and glycerophosphoric acid; organic phosphinic acids such as possibly substituted phenylphosphinic acid, naphthylphosphinic acid, alkylphosphinic acid, and glycerophosphinic acid; amino acids such as glycine and β-alanine; and the hydrochlorides of hydroxyl-functional amines, such as triethanolamine hydrochloride. Mixtures of two or more of the preceding may also be used.

The organic undercoat layer can be provided by the following methods: coating the support with a solution comprising an organic compound as described above dissolved in water or an organic solvent (e.g., methanol, ethanol, methyl ethyl ketone, and so forth) or a mixed solvent of the preceding, and drying; immersing the support in a solution comprising an organic compound as described above dissolved in water or an organic solvent (e.g., methanol, ethanol, methyl ethyl ketone, and so forth) or a mixed solvent of the preceding in order to adsorb the organic compound and thereafter rinsing with, e.g., water, and drying. In the former method, a 0.005 to 10 mass% organic compound solution can be applied by various techniques. For example, bar coater application, spin application, spray coating, curtain coating, and so forth, may be used. In the case of the latter method, the solution concentration is 0.01 to 20 mass% and preferably is 0.05 to 5 mass%; the immersion temperature is 20 to 90°C and preferably is 25 to 50°C; and the immersion time is 0.1 second to 20 minutes and preferably 2 seconds to 1 minute.

The solution employed for this can also be used in the pH range of 1 to 12, achieved by adjusting the pH with a base (e.g., ammonia, triethylamine, potassium hydroxide, and so forth) or acid (hydrochloric acid, phosphoric acid, and so forth). A yellow dye can also be added in order to improve the tone reproducibility of the lithographic printing plate precursor.

The post-drying coating rate by the organic undercoat layer is suitably 2 to 200 mg/m² and is preferably 5 to 100 mg/m². A satisfactory printing durability may not be obtained when this coating rate is less than 2 mg/m², and the same also holds true for a coating rate larger than 200 mg/m².

The material used for the inorganic undercoat layer can be exemplified by inorganic salts such as cobalt acetate, nickel acetate, potassium fluotitanate, and so forth. The method of providing the inorganic undercoat layer is the same as described above for the organic undercoat layer.

Based on a consideration of improving the printing durability, the undercoat layer preferably contains a polymer or copolymer that has at least one of the phosphonic acid group, phosphoric acid group, or sulfonic acid group in side chain position. In the case of the copolymer, the content of the polymerized component containing such a group is preferably 10 to 90 mol% and more preferably is 20 to 50 mol%. In addition, the copolymer preferably has an ethylenically unsaturated bond in side chain position. The content of the polymerized component having an ethylenically unsaturated bond in side chain position is preferably 10 to 90 mol% and more preferably is 15 to 40 mol%.

### The image recording layer

The image recording layer (also referred to hereafter as the photosensitive layer) of the lithographic printing plate precursor used by the present invention contains the following as its fundamental components: (i) sensitizing dye, (ii) photopolymerization initiator, (iii) an addition-polymerizable compound that has an ethylenically unsaturated double bond, and (iv) binder polymer.

### The sensitizing dye

The sensitizing dye used by the present invention is a dye that can transmit the energy of the absorbed light to the photopolymerization initiator by energy transfer or electron transfer.

The absorption wavelength is not particularly limited as long as the sensitizing dye has the aforementioned functionality and may be selected as appropriate in accordance with the wavelength of the laser used for photoexposure, but a sensitizing dye that has an absorption maximum in the wavelength range from 360 nm to 450 nm is particularly preferred for use in the present invention. Such a sensitizing dye can be exemplified by the merocyanine dyes represented by general formula (2) below, the benzopyrans, coumarins represented by general formula (3) below, the aromatic ketones represented by general formula (4) below, and the anthracenes represented by general formula (5) below.

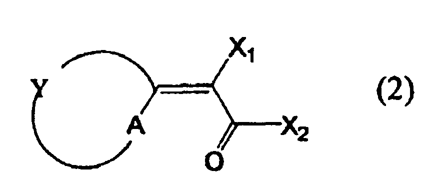

In formula (2) above, A represents a sulfur atom or NR₆ wherein R₆ represents a monovalent nonmetal atomic group; Y represents a nonmetal atomic group that forms the basic nucleus of the dye in cooperation with an adjacent A and an adjacent carbon atom; and X₁ and X₂ each independently represent a monovalent nonmetal atomic group wherein X₁ and X₂ may be bonded to each other to form the acidic nucleus of the dye.

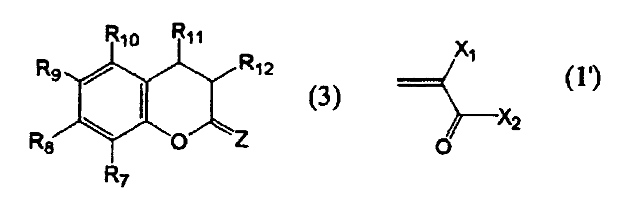

In formula (3), = Z represents the oxo group, thioxo group, imino group, or the alkylidene group represented by the partial structural formula (1') above; X₁ and X₂ have the same definition as for general formula (2); and R₇ to R₁₂ each independently represent a monovalent nonmetal atomic group.

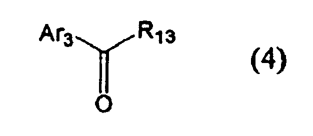

In formula (4), Ar₃ represents a possibly substituted aromatic group or heteroaromatic group and R₁₃ represents a monovalent nonmetal atomic group. Aromatic groups and heteroaromatic groups are preferred for R₁₃, and Ar₃ and R₁₃ may be bonded to one another to form a ring.

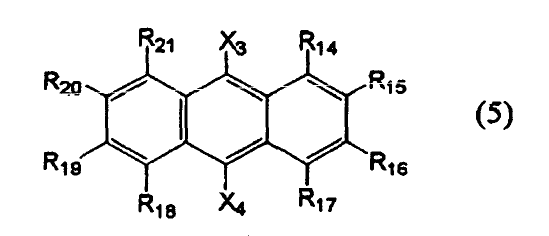

In formula (5), X₃, X₄, and R₁₄ to R₂₁ each independently represent a monovalent nonmetal atomic group. Electron-donating groups having a negative Hammett substituent constant are preferred for X₃ and X₄.

The following are preferred examples of the monovalent nonmetal atomic group represented by X₁ to X₄ and R₆ to R₂₁ in general formulas (2) through (5): the hydrogen atom, alkyl (for example, methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, s-butyl, t-butyl, isopentyl, neopentyl, 1-methylbutyl, isohexyl, 2-ethylhexyl, 2-methylhexyl, cyclohexyl, cyclopentyl, 2-norbornyl, chloromethyl, bromomethyl, 2-chloroethyl, trifluoromethyl, methoxymethyl, methoxyethoxyethyl, allyloxymethyl, phenoxymethyl, methylthiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonooxypropyl, phosphonatooxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propynyl, 2-butynyl, 3-butynyl, and so forth), aryl (for example, phenyl, biphenyl, naphthyl, tolyl, xylyl, mesityl, cumenyl, chlorophenyl, bromophenyl, chloromethylphenyl, hydroxyphenyl, methoxyphenyl, ethoxyphenyl, phenoxyphenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxyphenylcarbonyl, phenoxycarbonylphenyl, N-phenylcarbamoylphenyl, nitrophenyl, cyanophenyl, sulfophenyl, sulfonatophenyl, phosphonophenyl, phosphonatophenyl, and so forth), heteroaryl (for example, groups derived from heteroaryl rings such as thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthyridine, quinazoline, cinnoline, pteridine, carbazole, carboline, phenanthrene, acridine, perimidine, phenanthroline, phthalazine, phenarsazine, phenoxazine, furazan, and so forth), alkenyl (for example, vinyl, 1-propenyl, 1-butenyl, cinnamyl, 2-chloro-1-ethenyl, and so forth), alkynyl (for example, ethynyl, 1-propynyl, 1-butynyl, trimethylsilylethynyl, and so forth), halogen atoms (-F, -Br, -Cl, -I), the hydroxyl group, alkoxy, aryloxy, the mercapto group, alkylthio, arylthio, alkyldithio, aryldithio, the amino group, N-alkylamino, N,N-dialkylamino, N-arylamino, N,N-diarylamino, N-alkyl-N-arylamino, acyloxy, carbamoyloxy, N-alkylcarbamoyloxy, N-arylcarbamoyloxy, N,N-dialkylcarbamoyloxy, N,N-diarylcarbamoyloxy, N-alkyl-N-arylcarbamoyloxy, alkylsulfoxy, arylsulfoxy, acylthio, acylamino, N-alkylacylamino, N-arylacylamino, the ureido group, N'-alkylureido, N',N'-dialkylureido, N'-arylureido, N',N'-diarylureido, N'-alkyl-N'-arylureido, N-alkylureido, N-arylureido, N'-alkyl-N-alkylureido, N'-alkyl-N-arylureido, N',N'-dialkyl-N-alkylureido, N',N'-dialkyl-N-arylureido, N'-aryl-N-alkylureido, N'-aryl-N-arylureido, N',N'-diaryl-N-alkylureido, N',N'-diaryl-N-arylureido, N'-alkyl-N'-aryl-N-alkylureido, N'-alkyl-N'-aryl-N-arylureido, alkoxycarbonylamino, aryloxycarbonylamino, N-alkyl-N-alkoxycarbonylamino, N-alkyl-N-aryloxycarbonylamino, N-aryl-N-alkoxycarbonylamino, N-aryl-N-aryloxycarbonylamino, the formyl group, acyl, the carboxyl group, alkoxycarbonyl, aryloxycarbonyl, the carbamoyl group, N-alkylcarbamoyl, N,N-dialkylcarbamoyl, N-arylcarbamoyl, N,N-diarylcarbamoyl, N-alkyl-N-arylcarbamoyl, alkylsufinyl, arylsulfinyl, alkylsulfonyl, arylsulfonyl, the sulfo group (-SO₃H) and its conjugate base (referred to below as the sulfonato group), alkoxysulfonyl, aryloxysulfonyl, sulfinamoyl, N-alkylsulfinamoyl, N,N-dialkylsulfinamoyl, N-arylsulfinamoyl, N,N-diarylsulfinamoyl, N-alkyl-N-arylsulfinamoyl, sulfamoyl, N-alkylsulfamoyl, N,N-dialkylsulfamoyl, N-arylsulfamoyl, N,N-diarylsulfamoyl, N-alkyl-N-arylsulfamoyl, the phosphono group (-PO₃H₂) and its conjugate base (referred to below as the phosphonato group), dialkylphosphono (-PO₃(alkyl)₂), diarylphosphono (-PO₃(aryl)₂), alkylarylphosphono (-PO₃(alkyl)(aryl)), monoalkylphosphono (-PO₃H(alkyl)) and its conjugate base (referred to below as the alkylphosphonato group), monoarylphosphono (-PO₃H(aryl)) and its conjugate base (referred to below as the arylphosphonato group), phosphonooxy (-OPO₃H₂) and its conjugate base (referred to below as the phosphonatooxy group), dialkylphosphonooxy (-OPO₃H(alkyl)₂), diarylphosphonooxy (-OPO₃(aryl)₂), alkylarylphosphonooxy (-OPO₃(aryl)(alkyl)), monoalkylphosphonooxy (-OPO₃H(alkyl)) and its conjugate base (referred to below as the alkylphosphonatooxy group), monoarylphosphonooxy (-OPO₃H(aryl)) and its conjugate base (referred to below as the arylphosphonatooxy group), the cyano group, the nitro group, and so forth. The following are particularly preferred among the monovalent nonmetal atomic groups cited above: the hydrogen atom, alkyl groups, aryl groups, halogen atoms, alkoxy groups, and acyl groups.

5-, 6-, and 7-membered nitrogenous or sulfur-containing heterocycles are examples of the basic nucleus of the dye that is formed in general formula (2) by Y in cooperation with the adjacent A and the adjacent carbon atom, and 5- and 6-membered heterocycles are preferred.

Suitable examples of the nitrogenous heterocycle are the nitrogenous heterocycles known to constitute the basic nucleus in the merocyanine dyes described in, for example, L. G. Brooker et al., J. Am. Chem. Soc., 73, 5326-5358 (1951) and in the references cited therein. The following are specific examples: thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), 4-(2-thienyl)thiazole, and so forth), benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxy-benzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole, 5-ethoxycarbonylbenzothiazole, and so forth), naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole, 7-methoxynaphtho[1,2]thiazole, and so forth), thianaphtheno-'7',6',4,5-thiazoles (for example, 4'-methoxythianaphtheno-7',6',4,5-thiazole and so forth), oxazoles (for example, 4-methyloxazole, 5-methyloxazole, 4-phenyloxazole, 4,5-diphenyloxazole, 4-ethyloxazole, 4,5-dimethyloxazole, 5-phenyloxazole, and so forth), benzoxazoles (benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, 6-hydroxybenzoxazole, and so forth), naphthoxazoles (for example, naphtho[1,2]oxazole, naphtho[2,1]oxazole, and so forth), selenazoles (for example, 4-methylselenazole, 4-phenylselenazole, and so forth), benzoselenazoles (for example, benzoselenazole, 5-chlorobenzoselenazole, 5-methoxybenzoselenazole, 5-hydroxybenzoselenazole, tetrahydrobenzoselenazole, and so forth), naphthoselenazoles (for example, naphtho[1,2]selenazole, naphtho[2,1]selenazole, and so forth), thiazolines (for example, thiazoline, 4-methylthiazoline, and so forth), quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, 8-hydroxyquinoline, and so forth), isoquinolines (for example, isoquinoline, 3,4-dihydroisoquinoline, and so forth), benzimidazoles (for example, 1,3-diethylbenzimidazole, 1-ethyl-3-phenylbenzimidazole, and so forth), 3,3-dialkylindolenines (for example, 3,3-dimethylindolenine, 3,3,5-trimethylindolenine, 3,3,7-trimethylindolenine, and so forth), pyridines (for example, pyridine, 5-methylpyridine, and so forth), and so forth.

The sulfur-containing heterocycles can be exemplified by the dithiol substructures in the dyes in, for example, Japanese Patent Application Publication No. H 3-296759.

Specific examples are benzodithiols (for example, benzodithiol, 5-t-butylbenzodithiol, 5-methylbenzodithiol, and so forth), naphthodithiols (for example, naphtho[1,2]dlthiol, naphtho[2,1]dithiol, and so forth), dithiols (for example, 4,5-dimethyldithiols, 4-phenyldlthiols, 4-methoxycarbonyldlthiols, 4,5-dimethoxycarbonyldithiols, 4,5-ditrifluoromethyldithiol, 4,5-dicyanodithiol, 4-methoxycarbonylmethyldithiol, 4-carboxymethyldithiol, and so forth), and so forth.

The nomenclature used in the preceding description of the heterocycles has used the name of the parent heterocycle skeleton both for the sake of convenience and in keeping with customary usage; however, when the heterocycle forms the basic skeleton substructure in the sensitizing dye, it is introduced in the form of the alkylidene-type substituent, which is lowered by one degree of unsaturation, such as 3-substituted-2(3H)-benzothiazolylidene for the example of the benzothiazole skeleton.

Among sensitizing dyes that have an absorption maximum in the 350 nm to 450 nm wavelength region, dyes represented by the following general formula (1) are preferred for their high sensitivity.

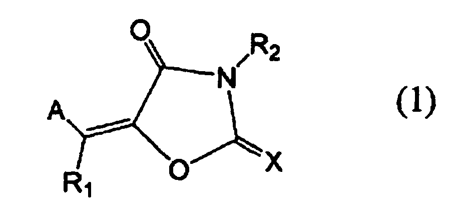

In general formula (1), A represents a possibly substituted aromatic ring or heterocycle and X represents the oxygen atom, sulfur atom, or N-(R₃). R₁, R₂, and R₃ each independently represent a monovalent nonmetal atomic group; A and R₁ may be bonded to each to form an aliphatic or aromatic ring; or R₂ and R₃ may be bonded to each other to form an aliphatic or aromatic ring.

General formula (1) is described more particularly in the following. R₁, R₂, and R₃ each independently represent a monovalent nonmetal atomic group and preferably represent a substituted or unsubstituted alkyl group, substituted or unsubstituted alkenyl group, substituted or unsubstituted aryl group, the residue of a substituted or unsubstituted aromatic heterocycle, a substituted or unsubstituted alkoxy group, a substituted or unsubstituted alkylthio group, the hydroxyl group, or a halogen atom.

Preferred specific examples of R¹, R², and R³ are provided. Preferred examples of the alkyl are C₁₋₂₀ straight chain alkyl, branched alkyl, and cyclic alkyl, wherein specific examples thereof are methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, s-butyl, t-butyl, isopentyl, neopentyl, 1-methylbutyl, isohexyl, 2-ethylhexyl, 2-methylhexyl, cyclohexyl, cyclopentyl, and 2-norbornyl. More preferred thereamong are C₁₋₁₂ straight chain alkyl, C₃₋₁₂ branched alkyl, and C₅₋₁₀ cyclic alkyl.

A monovalent nonmetal atomic group, excluding hydrogen, can be used for the substituent on the substituted alkyl, and preferred examples of this substituent are as follows: halogen atoms (-F, -Br, -Cl, -I), the hydroxyl group, alkoxy, aryloxy, the mercapto group, alkylthio, arylthio, alkyldithio, aryldithio, the amino group, N-alkylamino, N,N-dialkylamino, N-arylamino, N,N-diarylamino, N-alkyl-N-arylamino, acyloxy, carbamoyloxy, N-alkylcarbamoyloxy, N-arylcarbamoyloxy, N,N-dialkylcarbamoyloxy, N,N-diarylcarbamoyloxy, N-alkyl-N-arylcarbamoyloxy, alkylsulfoxy, arylsulfoxy, acylthio, acylamino, N-alkylacylamino, N-arylacylamino, the ureido group, N'-alkylureido, N',N'-dialkylureido,

N'-arylureido, N',N'-diarylureido, N'-alkyl-N'-arylureido, N-alkylureido, N-arylureido, N'-alkyl-N-alkylureido, N'-alkyl-N-arylureido, N',N'-dialkyl-N-alkylureido, N',N'-dialkyl-N-arylureido, N'-aryl-N-alkylureido, N'-aryl-N-arylureido, N',N'-diaryl-N-alkylureldo, N',N'-diaryl-N-arylureldo, N'-alkyl-N'-aryl-N-alkylureido, N'-alkyl-N'-aryl-N-arylureido, alkoxycarbonylamino, aryloxycarbonylamino, N-alkyl-N-alkoxycarbonylamino, N-alkyl-N-aryloxycarbonylamino, N-aryl-N-alkoxycarbonylamino, N-aryl-N-aryloxycarbonylamino, acyl, the carboxyl group, alkoxycarbonyl, aryloxycarbonyl, the carbamoyl group, N-alkylcarbamoyl, N,N-dialkylcarbamoyl, N-arylcarbamoyl, N,N-diarylcarbamoyl, N-alkyl-N-arylcarbamoyl, alkylsufinyl, arylsulfinyl, alkylsulfonyl, arylsulfonyl, the sulfo group (-SO₃H) and its conjugate base (referred to below as the sulfonato group), alkoxysulfonyl, aryloxysulfonyl, sulfinamoyl, N-alkylsulfinamoyl, N,N-dialkylsulfinamoyl, N-arylsulfinamoyl, N,N-diarylsulfinamoyl, N-alkyl-N-arylsulfinamoyl, sulfamoyl, N-alkylsulfamoyl, N,N-dialkylsulfamoyl, N-arylsulfamoyl, N,N-diarylsulfamoyl, N-alkyl-N-arylsulfamoyl, the phosphono group (-PO₃H₂) and its conjugate base (referred to below as the phosphonato group),
dialkylphosphono (-PO₃(alkyl)₂), diarylphosphono (-PO₃(aryl)₂), alkylarylphosphono (-PO₃(alkyl)(aryl)), monoalkylphosphono (-PO₃H(alkyl)) and its conjugate base (referred to below as the alkylphosphonato group), monoarylphosphono (-PO₃H(aryl)) and its conjugate base (referred to below as the arylphosphonato group), phosphonooxy (-OPO₃H₂) and its conjugate base (referred to below as the phosphonatooxy group), dialkylphosphonooxy (-OPO₃(alkyl)₂), diarylphosphonooxy (-OPO₃(aryl)₂), alkylarylphosphonooxy (-OPO₃(alkyl)(aryl)), monoalkylphosphonooxy (-OPO₃H(alkyl)) and its conjugate base (referred to below as the alkylphosphonatooxy group), monoarylphosphonooxy (-OPO₃H(aryl)) and its conjugate base (referred to below as the arylphosphonatooxy group), the cyano group, the nitro group, aryl, heteroaryl groups, alkenyl, and alkynyl.

The alkyl moiety in these substituents is specifically exemplified by the previously described alkyl. The following are specific examples of the aryl: phenyl, biphenyl, naphthyl, tolyl, xylyl, mesityl, cumenyl, chlorophenyl, bromophenyl, chloromethylphenyl, hydroxyphenyl, methoxyphenyl, ethoxyphenyl, phenoxyphenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxycarbonylphenyl, phenoxycarbonylphenyl, N-phenylcarbamoylphenyl, nitrophenyl, cyanophenyl, sulfophenyl, sulfonatophenyl, phosphonophenyl, phosphonatophenyl, and so forth.

The heteroaryl group is a group means a monocyclic or polycyclic aromatic ring system that contains at least one type selected from the nitrogen atom, oxygen atom, and sulfur atom, and particularly preferred examples of heteroaryl rings among the heteroaryl groups are as follows: thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthyridine, quinazoline, cinnoline, pteridine, carbazole, carboline, phenanthrene, acridine, perimidine, phenanthroline, phthalazine, phenarsazine, phenoxazine, furazan, phenoxazine derived from the heteroaryl. These groups may additionally be a condensed ring system with benzene or may bear a substituent.

The alkenyl is exemplified by vinyl, 1-propenyl, 1-butenyl, cinnamyl, 2-chloro-1-ethenyl, and so forth. The alkynyl is exemplified by ethynyl, 1-propynyl, 1-butynyl, trimethylsilylethynyl, and so forth. G¹ in the acyl group (G¹CO-) can be exemplified by the hydrogen atom and the preciously described alkyl and aryl. More preferred among these substituents are halogen atoms (-F, -Br, -Cl, -I), alkoxy, aryloxy, alkylthio, arylthio, N-alkylamino, N,N-dialkylamino, acyloxy, N-alkylcarbamoyloxy, N-arylcarbamoyloxy, acylamino, acyl, the carboxyl group, alkoxycarbonyl, aryloxycarbonyl, carbamoyl, N-alkylcarbamoyl, N,N-dialkylcarbamoyl, N-arylcarbamoyl, N-alkyl-N-arylcarbamoyl, the sulfo group, sulfonato, sulfamoyl, N-alkylsulfamoyl, N,N-dialkylsulfamoyl, N-arylsulfamoyl, N-alkyl-N-arylsulfamoyl, phosphono, phosphonato, dialkylphosphono, diarylphosphono, monoalkylphosphono, alkylphosphonato, monoarylphosphono, arylphosphonato, phosphonooxy, phosphonatooxy, and aryl.

The alkylene moiety in the substituted alkyl is, for example, the divalent organic residue obtained by removing any one of the hydrogen atoms on the C₁₋₂₀ alkyl described above, and preferred examples thereof are C₁₋₁₂ straight chain alkylene, C₃₋₁₂ branched alkylene, and C₅₋₁₀ cyclic alkylene.

The following are specific examples of substituted alkyl preferred for R¹_{,} R², and R³ and obtained by combining alkylene with a substituent as described above: chloromethyl, bromomethyl, 2-chloroethyl, trifluoromethyl, methoxymethyl, methoxyethoxyethyl, allyloxymethyl, phenoxymethyl, methylthiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfobutyl, sulfonatopropyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonooxypropyl, phosphonatooxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propynyl, 2-butynyl, 3-butynyl, and so forth.

Specific examples of aryl groups preferred for R¹, R², and R³ are aryl groups in which from one to three benzene rings form a condensed ring system and aryl groups in which a benzene ring forms a condensed ring system with a 5-membered heterocycle. Specific examples here are phenyl, naphthyl, anthryl, phenanthryl, indenyl, acenaphthenyl, and fluorenyl, wherein phenyl and naphthyl are more preferred thereamong.

Specific examples of substituted aryl groups preferred for R¹, R², and R³ are substituted aryl groups that have a monovalent nonmetal atomic group (excluding the hydrogen atom) as a substituent on a ring-forming carbon atom present in an aryl group as described above. Examples of preferred substituents are the previously described alkyl and substituted alkyl and the substituents previously cited for the substituted alkyl. Preferred examples of the substituted aryl are as follows: biphenyl, tolyl, xylyl, mesityl, cumenyl, chlorophenyl, bromophenyl, fluorophenyl, chloromethylphenyl, trifluoromethylphenyl, hydroxyphenyl, methoxyphenyl, methoxyethoxyphenyl, allyloxyphenyl, phenoxyphenyl, methylthiophenyl, tolylthiophenyl, ethylaminophenyl, diethylaminophenyl, morpholinophenyl, acetyloxyphenyl, benzyloxyphenyl, N-cyclohexylcarbamoyloxyphenyl, N-phenylcarbamoyloxyphenyl, acetylaminophenyl, N-methylbenzoylaminophenyl, carboxyphenyl, methoxycarbonylphenyl, allyloxycarbonylphenyl, chlorophenoxycarbonylphenyl, carbamoylphenyl, N-methylcarbamoylphenyl, N,N-dipropylcarbamoylphenyl, N-(methoxyphenyl)carbamoylphenyl, N-methyl-N-(sulfophenyl)carbamoylphenyl, sulfophenyl, sulfonatophenyl, sulfamoylphenyl, N-ethylsulfamoylphenyl, N,N-dipropylsulfamoylphenyl, N-tolylsulfamoylphenyl, N-methyl-N-(phosphonophenyl)sulfamoylphenyl, phosphonophenyl, phosphonatophenyl, diethylphosphonophenyl, diphenylphosphonophenyl, methylphosphonophenyl, methylphosphonatophenyl, tolylphosphonophenyl, tolylphosphonatophenyl, allylphenyl, 1-propenylmethylphenyl, 2-butenylphenyl, 2-methylallylphenyl, 2-methylpropenylphenyl, 2-propynylphenyl, 2-butynylphenyl, 3-butynylphenyl, and so forth.

Specific examples for R₁, R₂, and R₃ of preferred substituted and unsubstituted alkenyl and substituted and unsubstituted aromatic heterocycle residues are the same as those described above for the alkenyl group and heteroaryl group.

The group A in general formula (1) is described in the following. This A represents a possibly substituted aromatic ring group or heterocyclic group, and this possibly substituted aromatic ring group and heterocyclic group are specifically exemplified by the same specific examples of the aryl group and heteroaryl group provided for R₁, R₂, and R₃ in general formula (1).

The sensitizing dye represented by general formula (1) is obtained by a condensation reaction between a substituted or unsubstituted aromatic ring or heterocycle and an active methylene-containing acidic nucleus or acidic nucleus as shown above. In specific terms, synthesis can be carried out with reference to the description in Japanese Examined Patent Publication No. S59-28329.

The following (D1) to (D42) are preferred specific examples of compounds represented by general formula (1). In those instances in which isomers are created due to the double bond connecting the acidic nucleus to the basic nucleus, there is no limitation to either or any isomer.

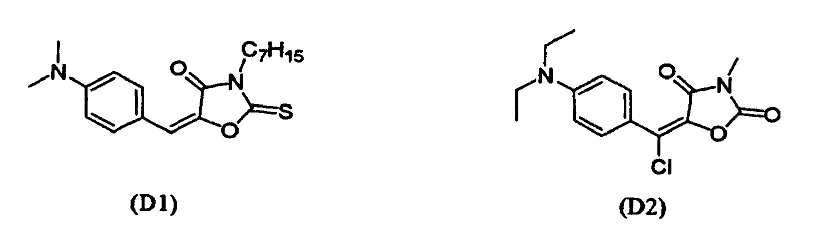

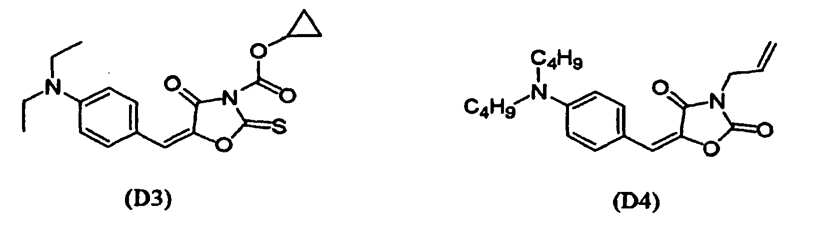

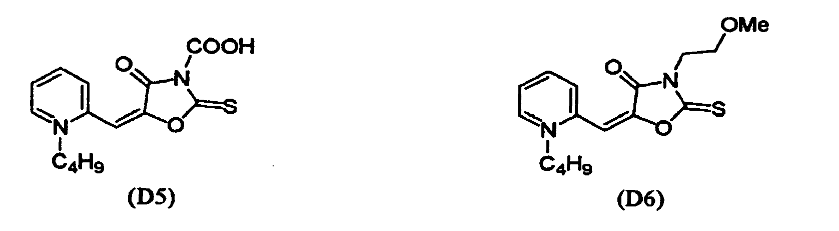

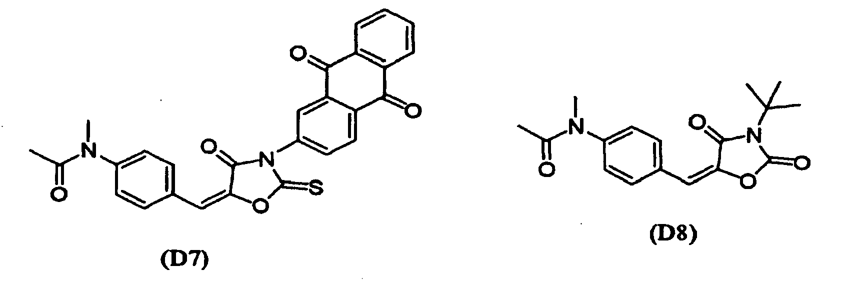

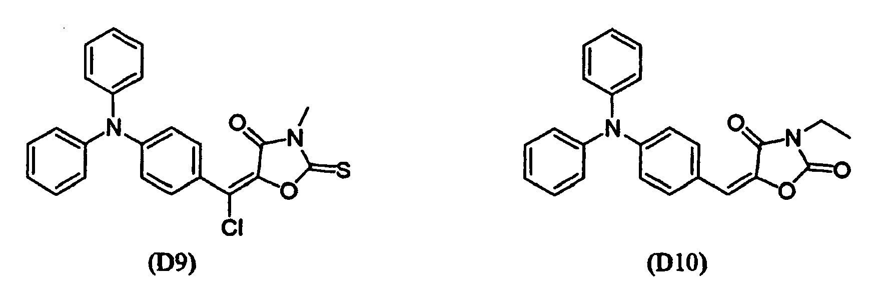

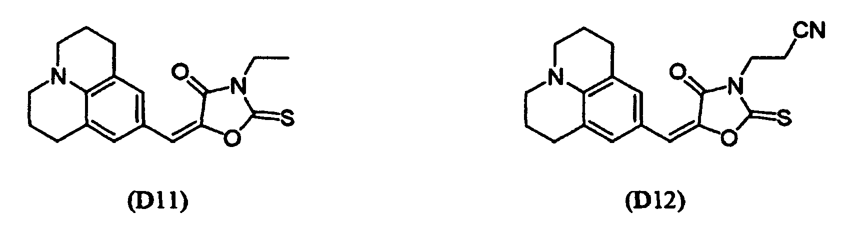

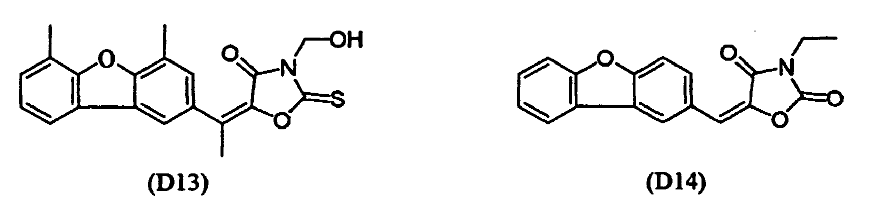

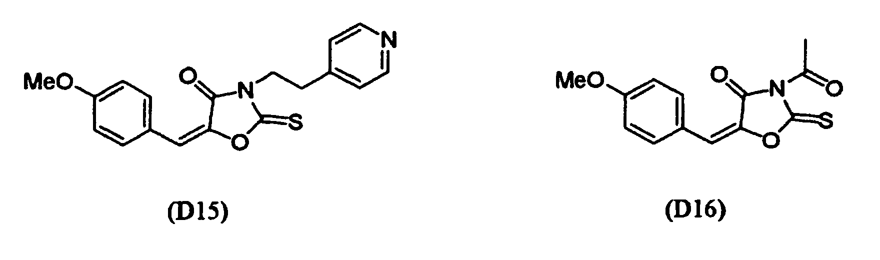

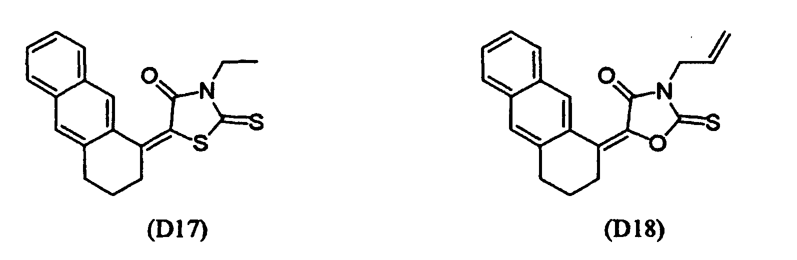

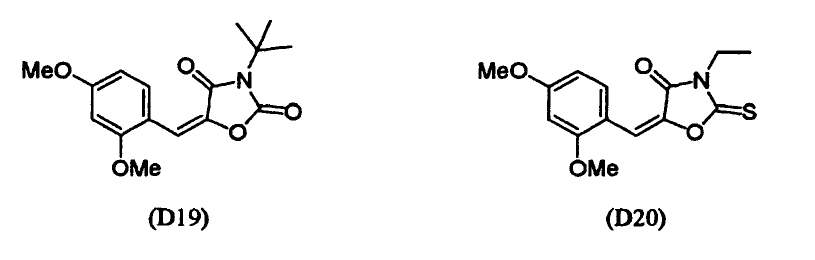

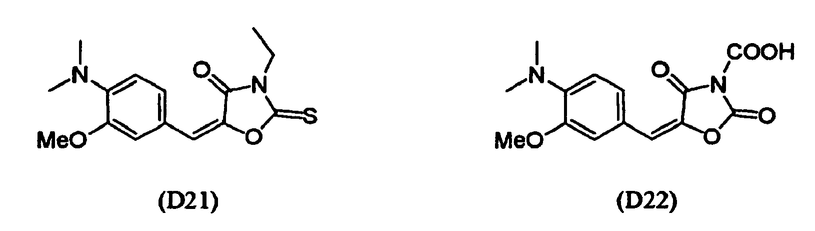

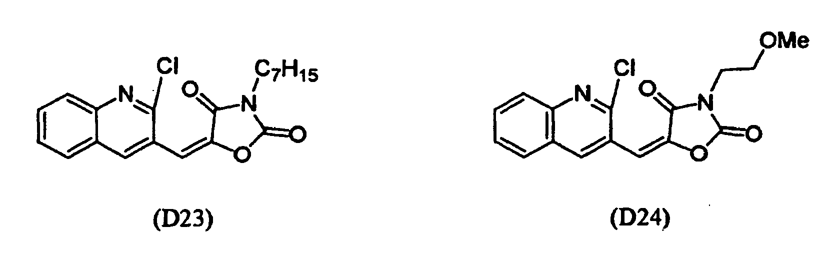

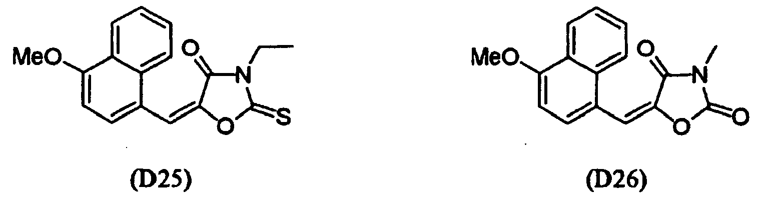

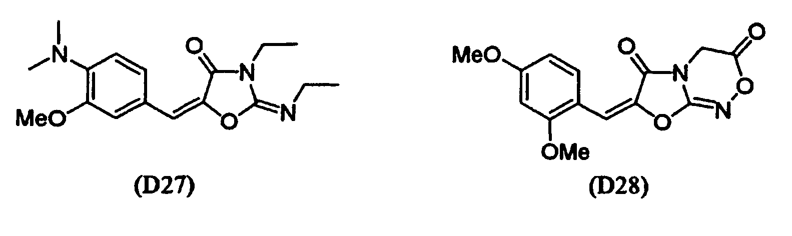

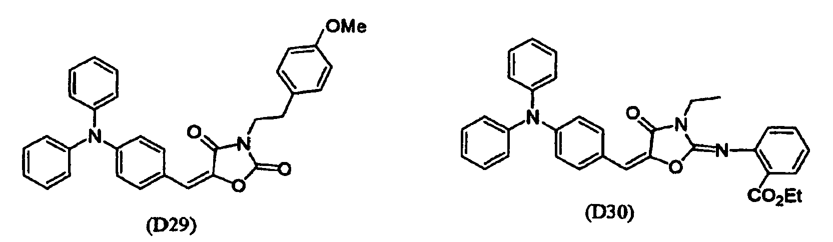

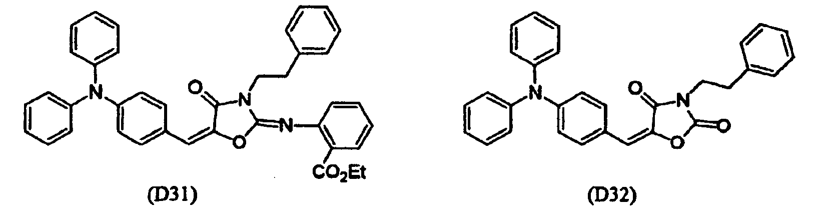

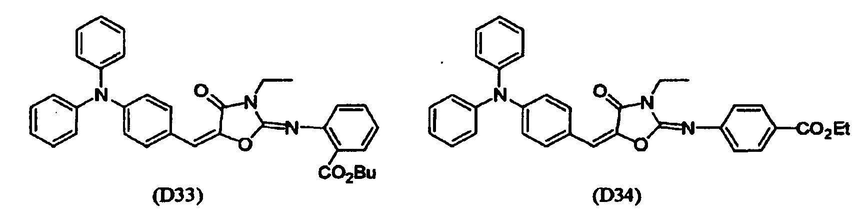

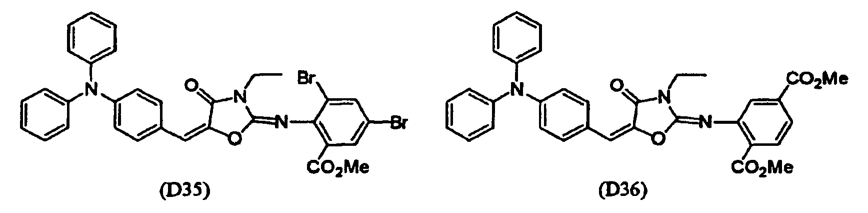

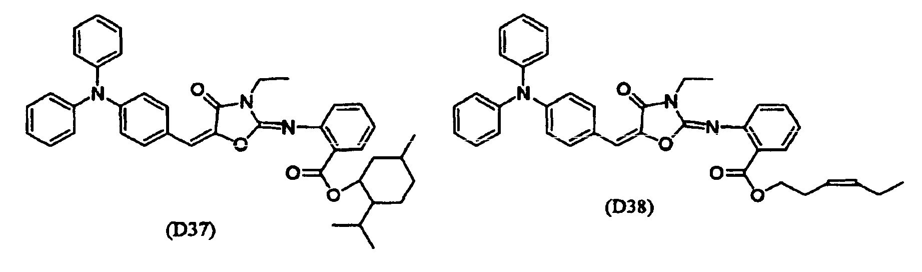

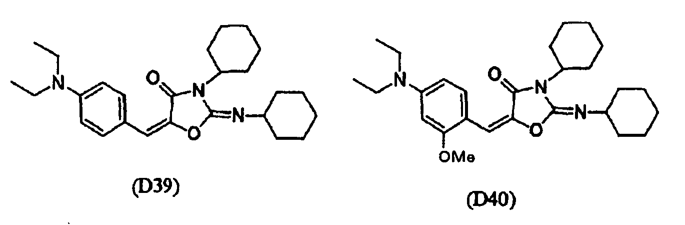

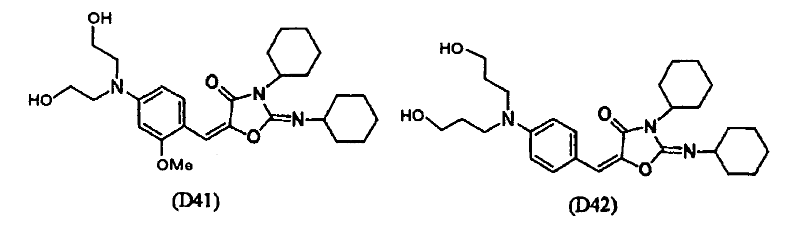

The use is also preferred of sensitizing dyes having the structures given by the following general formulas, as shown in Japanese Patent Application Publication No. 2007-316582.

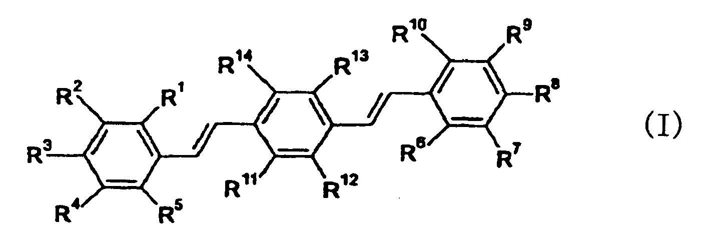

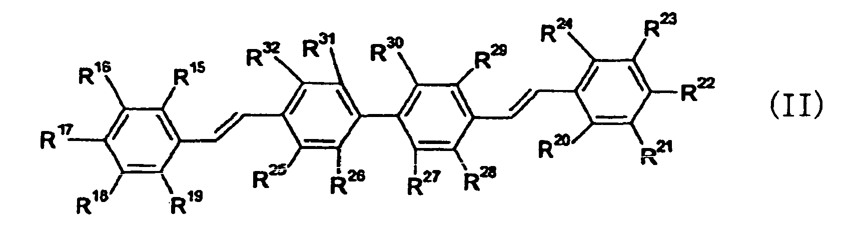

In the preceding formulas, R¹ to R¹⁴ each independently represent the hydrogen atom, alkyl, alkoxy, the cyano group, and halogen. However, at least one of R¹ to R¹⁰ represents alkoxy having at least two carbons.

R¹⁵ to R³² each independently represent the hydrogen atom, alkyl, alkoxy, the cyano group, or halogen. However, at least one of R¹⁵ to R²⁴ represents alkoxy having at least two carbons.

The use is also preferred of sensitizing dyes with the following formula, which are shown in Japanese Patent Application Publication No. 2007-171406.

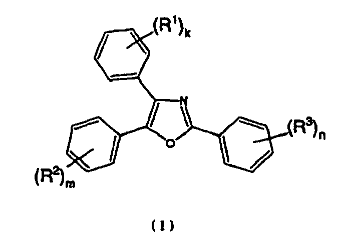

Here, R¹, R², and R³ each independently represent halogen, possibly substituted alkyl, possibly substituted aryl, possibly substituted aralkyl, -NR⁴R⁵, or -OR⁶; R⁴, R⁵, and R⁶ each independently represent the hydrogen atom, possibly substituted alkyl, possibly substituted aryl, or possibly substituted aralkyl; and k, m, and n represent 0 or an integer from 1 to 5.

Due to the fact that the absorption coefficient of the sensitizing dye varies with the structure of the dye, the quantity of dye addition varies as a function of the structure of the sensitizing dye used. A suitable quantity of addition yields a value of 0.6 or less for the absorbance of the photosensitive layer at the wavelength of the laser emission. The quantity of addition preferably provides an absorbance in the range of 0.05 to 0.55, more preferably in the range of 0.1 to 0.3, and even more preferably in the range of 0.1 to 0.45.

### The polymerization initiator

The polymerization initiator used by the present invention can be selected as appropriate from the various photopolymerization initiators and systems of two or more photopolymerization initiators (photopolymerization initiation systems) known, for example, from patents and the literature. In the present invention, the term "photopolymerization initiator" collectively refers to a single photopolymerization initiator as well as systems in which two or more photopolymerization initiators are used in combination.

When, for example, light around 400 nm is used as the light source, benzils, benzoyl ethers, Michler's ketone, anthraquinones, thioxanthones, acridines, phenazines, benzophenones, hexaarylbisimidazole compounds, and so forth, are widely used.

In addition, various photopolymerization initiators have also been introduced for the use as the light source of visible light having a wavelength of 400 nm or more, for example, certain types of photoreducible dyes, for example, rose bengal, eosine, erythrosine, and so forth, as described in U.S. Patent No. 2,850,445; systems that combine a dye and a photopolymerization initiator, for example, a composite initiator system of a dye and an amine (Japanese Examined Patent Publication No. S44-20189); a combined system of a hexaarylbiimidazole, a radical generator, and a dye (Japanese Examined Patent Publication No. S45-37377); a hexaarylbiimidazole + p-dialkylaminobenzylidene ketone system (Japanese Examined Patent Publication No. S47-2528 and Japanese Patent Application Publication No. S54-155292); a cyclic cis-α-dicarbonyl compound + dye system (Japanese Patent Application Publication No. S48-84183); a cyclic triazine + merocyanine dye system (Japanese Patent Application Publication No. S54-151024); a 3-ketocoumarin + activator system (Japanese Patent Application Publication Nos. S52-112681 and S58-15503); a biimidazole + styrene derivative + thiol system (Japanese Patent Application Publication No. S59-140203); an organoperoxide + dye system (Japanese Patent Application Publication Nos. S59-1504, S59-140203, S59-189340, and S62-174203, Japanese Examined Patent Publication No. S62-1641, and U.S. Patent No. 4,766,055); a dye + active halogen compound system (Japanese Patent Application Publication Nos. S63-178105, S63-258903, and H2-63054); a dye + borate compound system (Japanese Patent Application Publication Nos. S62-143044, S62-150242, S64-13140, S64-13141, S64-13142, S64-13143, S64-13144, S64-17048, H1-229003, H1-298348, and H1-138204); a rhodanine ring-containing dye + radical generator system (Japanese Patent Application Publicvation Nos. H2-179643 and H2-244050); and so forth. Hexaarylbisimidazole compounds are preferred photopolymerization initiators.

The various compounds described in, inter alia, EP 24629, EP 107792, U.S. Patent No. 4,410,621, EP 215453, and DE 3211312 can be used as the hexaarylbisimidazole compound. Preferred examples are as follows: 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole, 2,2'-bis(2,6-difluorophenyl)-4,5,4',5'-tetraphenylbisimidazole, and so forth. Two or more hexaarylbisimidazole compounds may be used in combination.

The hexaarylbisimidazole compound is preferably used at 0.05 to 50 mass parts and preferably 0.2 to 30 mass parts for each 100 mass parts of the total quantity of the addition-polymerizable compound, infra. The hexaarylbisimidazole compound may also be used in combination with another photopolymerization initiator.

It is known that the photoinitiation capacity of a photopolymerization initiator may optionally be further increased by co-use with a hydrogen donor compound, for example, a thiol compound (e.g., 2-mercaptobenzthiazole, 2-mercaptobenzimidazole, 2-mercaptobenzoxazole, and so forth) or an amine compound (N-phenylglycine, N,N-dialkylamino aromatic alkyl ester, and so forth). In particular, mercapto-functional compounds are examples of hydrogen donor compounds that provide a high photoinitiation capacity and are suitable for the present invention.

More suitable examples are the sulfur-containing compounds represented by the following general formulas (2) and (3) (mercapto-functional heterocyclic compounds). The structures of the individual tautomers are shown for general formulas (2) and (3).

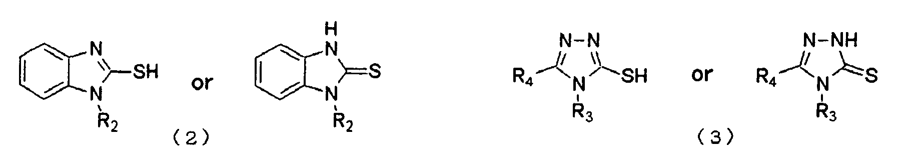

R₂, R₃, and R₄ in the preceding formulas (2) and (3) each independently represent the hydrogen atom, substituted or unsubstituted C₁₋₁₈ straight-chain or branched alkyl, substituted or unsubstituted C₅₋₂₀ alicyclic-type alkyl, or an aromatic group. The substituent can be exemplified by halogen, the hydroxyl group, the amino group, the thiol group, acetyl, the carboxyl group, and so forth.

The following (SH1) to (SH20) are preferred specific examples of the compounds with general formulas (2) and (3), but the present invention is not limited to these specific examples. The following structures show the -SH group-containing structure from the tautomers given above.

Specific examples for general formula (2)

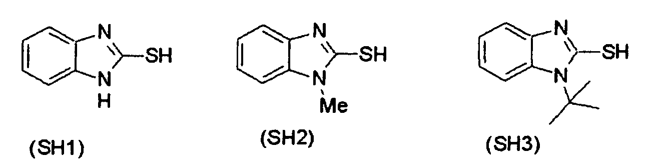

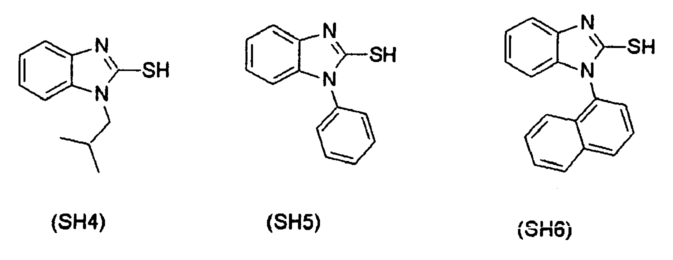

Specific examples for general formula (3)

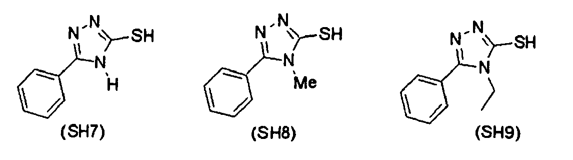

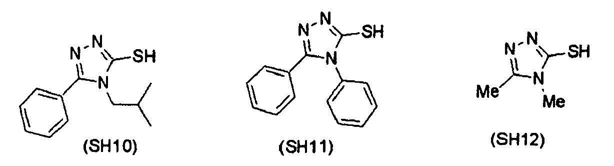

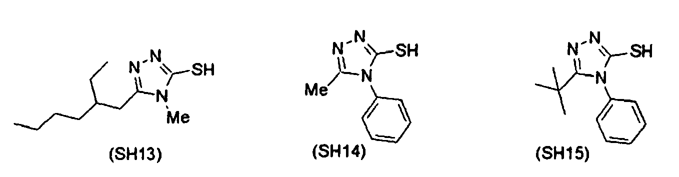

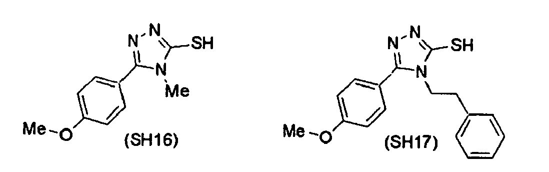

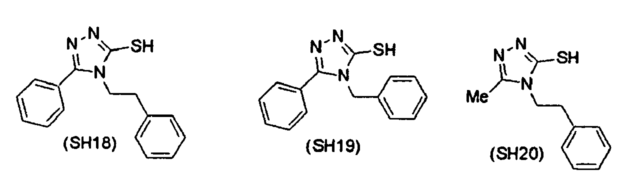

The mercapto-functional heterocyclic compound is used at a ratio preferably of 0.2 to 10.0 mol, more preferably 0.5 to 6.0 mol, and even more preferably 0.5 to 4.0 mol, in each case per 1 mol of the hexaarylbisimidazole compound.

### The radical-polymerizable compound that has an ethylenically unsaturated double bond

The addition-polymerizable compound that has an ethylenically unsaturated double bond used in the present invention can be freely selected from compounds that contain at least 1 and preferably at least 2 ethylenically unsaturated double bond moieties. In terms of its chemical form it may be, for example, a monomer, prepolymer (i.e., dimer or trimer), oligomer, a copolymer of the preceding, or a mixture of the preceding. The monomer can be exemplified by esters between unsaturated carboxylic acids (for example, acrylic acid, methacrylic acid, itaconic acid, crotonic acid, isocrotonic acid, maleic acid, and so forth) and aliphatic polyhydric alcohol compounds and by amides between unsaturated carboxylic acids and aliphatic multifunctional amine compounds.

The following are specific examples of monomers that are esters between an aliphatic polyhydric alcohol compound and an unsaturated carboxylic acid: acrylate esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomer, and so forth;

Examples of methacrylate esters are tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane, bis[p-(methacryloxyethoxy)phenyl]dimethylmethane, and so forth;

Examples of itaconate esters are ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, and so forth.

Examples of crotonate esters are ethylene glycol dicrotonate, tetramethylene glycol dicrotonate, pentaerythritol dicrotonate, sorbitol tetradicrotonate, and so forth.

Examples of isocrotonate esters are ethylene glycol diisocrotonate, pentaerythritol diisocrotonate, sorbitol tetraisocrotonate, and so forth.

Examples of maleate esters are ethylene glycol dimaleate, triethylene glycol dimaleate, pentaerythritol dimaleate, sorbitol tetramaleate, and so forth.

The following are specific examples of monomers that are amides between an aliphatic polyvalent amine compound and an unsaturated carboxylic acid: methylenebisacrylamide, methylenebismethacrylamide, 1,6-hexamethylenebisacrylamide, 1,6-hexamethylenebismethacrylamide, diethylenetriamine trisacrylamide, xylylenebisacrylamide, xylylenebismethacrylamide, and so forth.

Other examples are the urethane acrylates described in Japanese Patent Application Publication No. S51-37193; the polyester acrylates described in Japanese Patent Application Publication No. S48-64183 and Japanese Examined Patent Publication Nos. S49-43191 and S52-30490; and multifunctional acrylates and methacrylates such as the epoxy acrylates obtained by reacting an epoxy resin with (meth)acrylic acid. Also usable are the photocuring monomers and oligomers described in Journal of the Adhesion Society of Japan, Volume 20, Number 7 (1984), pages 300 to 308.

Specific examples are as follows: NK Oligo U-4HA, U-4H, U-6HA, U-6ELH, U-108A, U-1084A, U-200AX, U-122A, U-340A, U-324A, and UA-100 (from Shin-Nakamura Chemical Co., Ltd.); UA-306H, AI-600, UA-101T, UA-101I, UA-306T, and UA-306I (from Kyoeisha Yushi); Art Resin UN-9200A, UN-3320HA, UN-3320HB, UN-3320HC, SH-380G, SH-500, and SH-9832 (from Negami Chemical Industrial Co., Ltd.); and PLEX6661-O (from Degussa (Germany)).

The ethylenically unsaturated double bond-functional addition-polymerizable compound is used preferably in the range of 5 to 90 mass% and more preferably in the range of 20 to 75 mass%, in each case with reference to the total solids fraction in the photosensitive layer.

### The binder polymer

There are no particular limitations on the binder polymer used by the present invention, but acid group-containing organic polymers are preferred from the standpoints of the developability and solubility in weakly basic aqueous solutions, while carboxylic acid-containing organic polymers are more preferred. Such organic polymers can be exemplified by addition polymers that have the carboxylic acid group in side chain position, for example, as described in Japanese Patent Application Publication No. S59-44615, Japanese Examined Patent Publication Nos. S54-34327, S58-12577, and S54-25957, and Japanese Patent Application Publication Nos. S54-92723, S59-53836, and S59-71048, i.e., methacrylic acid copolymers, acrylic acid copolymers, itaconic acid copolymers, crotonic acid copolymers, maleic acid copolymers, and partially esterified maleic acid copolymers.

Other examples are acidic cellulose derivatives having the carboxylic acid group in side chain position and the products yielded by the addition of a cyclic acid anhydride to an hydroxyl-functional addition polymer.

In addition, the polyurethane resins described in the following are also useful as binders that are soluble or swellable in weakly basic aqueous solutions: Japanese Examined Patent Publication Nos. H 7-120040, H 7-120041, H 7-120042, and H 8-12424 and Japanese Patent Application Publication Nos. S63-287944, S63-287947, H1-271741, and H11-352691.

Acrylic resins, methacrylic resins, and urethane resins are preferably used as the binder polymer.

A very suitable example of the binder polymer used by the present invention is copolymer that contains (a) a carboxylic acid-functional repeat unit and (b) a repeat unit that confers radical crosslinkability. The structures shown in the following (a-1) to (a-13) are specific examples of the carboxylic acid-functional repeat unit (a) (also referred to below as repeat unit (a)), but the present invention is not limited to these.

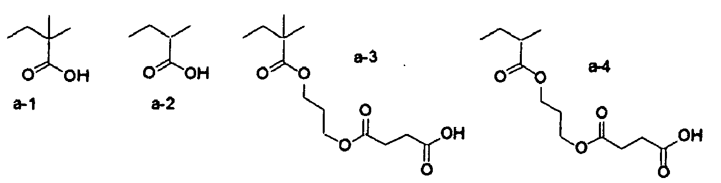

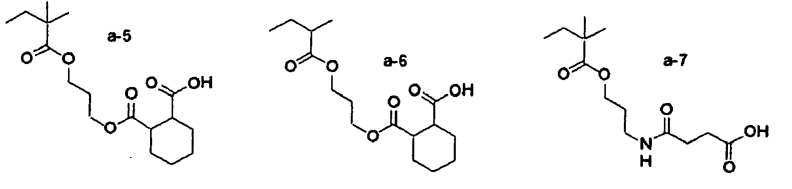

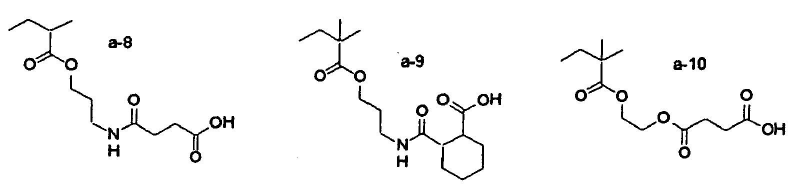

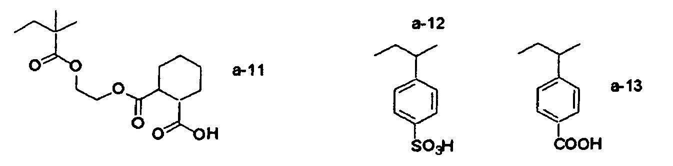

Assigning a value of 100 to the total number of repeat units, the content of repeat unit (a) is 5 to 50 thereof and preferably is 5 to 25 and more preferably is 5 to 15 thereof.

The structures shown in the following (b-1) to (b-11) are specific examples of the repeat unit that confers radical crosslinkability (b) (also referred to below as repeat unit (b)), but the present invention is not limited to these.

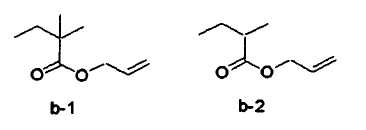

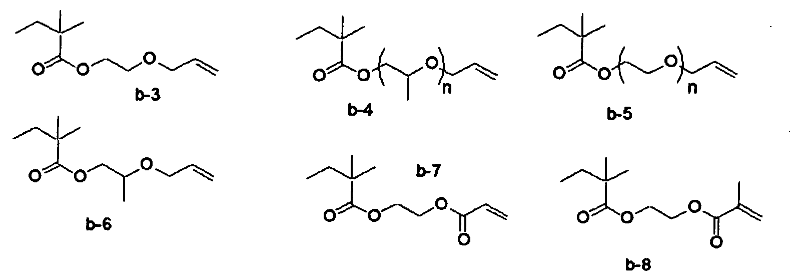

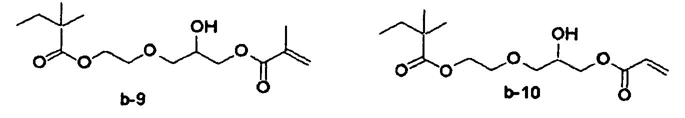

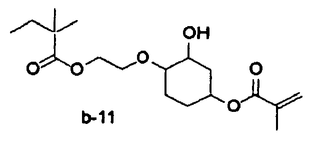

Assigning a value of 100 to the total number of repeat units, the content of repeat unit (b) is 5 to 90 thereof and preferably is 20 to 85 and more preferably is 40 to 80 thereof.

The binder polymer in the present invention may also contain the repeat unit represented by formula (1) below (also referred to below as repeat unit (1)).

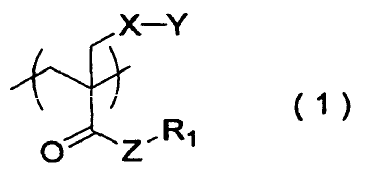

In formula (1), X represents the oxygen atom, sulfur atom, or -NH- group and Y represents the hydrogen atom, C₁₋₁₂ alkyl, C₅₋₁₂ alicyclic-type alkyl, or a C₆₋₂₀ group containing an aromatic ring. Z represents the oxygen atom, sulfur atom, or -NH- group and R₁ represents C₁₋₁₈ alkyl, C₅₋₂₀ alkyl containing an alicyclic structure, or a C₆₋₂₀ group containing an aromatic ring.

The structures shown by (1-1) to (1-9) below are specific examples of the repeat unit (1), but the present invention is not limited to these.

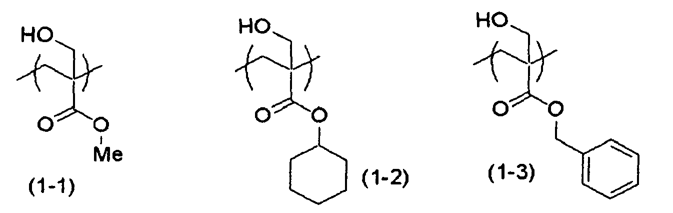

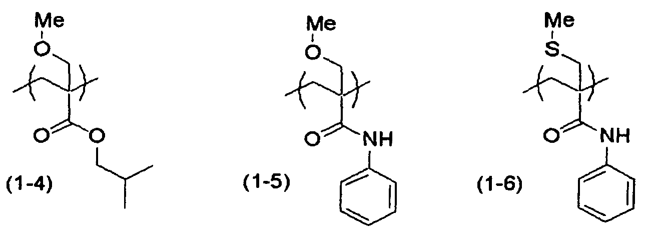

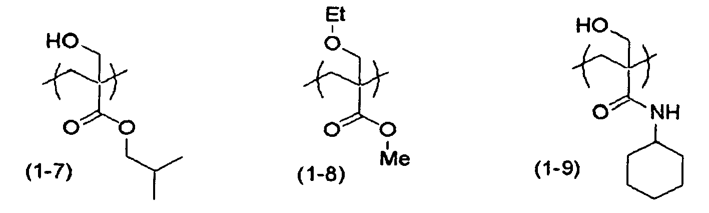

Letting 100 be the total number of repeat units, the content of repeat unit (1) therein is 1 to 40, preferably 3 to 25, and more preferably 5 to 15.

Specific examples of suitable combinations of repeat units (a), (b), and (1) are shown below as (PP-1) to (PP-11) in Table 1, but the present invention is not limited to these. With regard to the acid value of these acrylic resins, the carboxyl group is present at 0.2 to 4.0 meq/g, preferably at 0.3 to 3.0 meq/g, more preferably at 0.4 to 2.0 meq/g, particularly preferably at 0.5 to 1.5 meq/g, and most preferably at 0.6 to 1.2 meq/g.

**Table 1.**

| specific example no. | repeat unit (1) | repeat unit (a) | repeat unit (b) |
|---|---|---|---|
| PP-1 | 1-3 | a-1 | b-1 |
| PP-2 | 1-3 | a-1 | b-8 |
| PP-3 | 1-2 | a-1 | b-1 |
| PP-4 | 1-2 | a-1 | b-8 |
| PP-5 | 1-2 | a-1 | b-11 |
| PP-6 | 1-9 | a-5 | b-1 |
| PP-7 | 1-5 | a-3 | b-1 |
| PP-8 | 1-5 | a-3 | b-8 |
| PP-9 | 1-1 | a-3 | b-1 |
| PP-10 | 1-1 | a-5 | b-8 |
| PP-11 | 1-9 | a-3 | b-1 |

| | | | |
|---|---|---|---|
| (The copolymerization molar ratio for (a), (b), and (1) is, for example, 14 : 76 : 10.) | | | |

Urethane resin used as the binder polymer in the present invention preferably contains a crosslinking group. This crosslinking group denotes a group that crosslinks the binder polymer by a radical polymerization reaction process that is induced in the image recording layer when the lithographic printing plate precursor undergoes exposure to light. This crosslinking group may be any group that has such a capacity and is not otherwise particularly limited, and in the sphere of functional groups that can undergo an addition polymerization reaction may be exemplified by the epoxy group, the amino group, and groups that contain an ethylenically unsaturated bond. This crosslinking group may also be a functional group that can form a radical upon exposure to light. Crosslinking groups of this nature can be exemplified by the thiol group, halogen groups, onium salt structures, and so forth. Groups that contain an ethylenically unsaturated bond are preferred among the preceding, and the functional groups represented by the following general formulas (1A) to (3A) are particularly preferred.

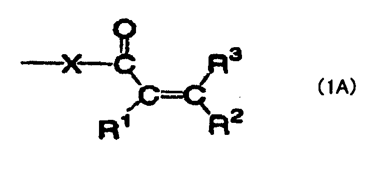

R¹ to R³ in general formula (1A) each independently represent the hydrogen atom or a monovalent organic group. R¹ is preferably, for example, the hydrogen atom or a possibly substituted alkyl group, whereamong the hydrogen atom and methyl group are preferred because they have a high radical reactivity. R² and R³ are each independently exemplified by the hydrogen atom, halogen atoms, the amino group, the carboxyl group, alkoxycarbonyl, the sulfo group, the nitro group, the cyano group, possibly substituted alkyl, possibly substituted aryl, possibly substituted alkoxy, possibly substituted aryloxy, possibly substituted alkylamino, possibly substituted arylamino, possibly substituted alkylsulfonyl, possibly substituted arylsulfonyl, and so forth. Preferred thereamong are the hydrogen atom, the carboxyl group, alkoxycarbonyl, possibly substituted alkyl, and possibly substituted aryl because they have a high radical reactivity.

X represents the oxygen atom, sulfur atom, or -N(R¹²)-wherein R¹² represents the hydrogen atom or a monovalent organic group. The monovalent organic group encompassed by R¹² can be exemplified by possibly substituted alkyl. Preferred for R¹² among the preceding are the hydrogen atom, methyl, ethyl, and isopropyl because they have a high radical reactivity.

Examples of the substituents that can be introduced are alkyl, alkenyl, alkynyl, aryl, alkoxy, aryloxy, halogen atoms, the amino group, alkylamino, arylamino, the carboxyl group, alkoxycarbonyl, the sulfo group, the nitro group, the cyano group, the amide group, alkylsulfonyl, arylsulfonyl, and so forth.

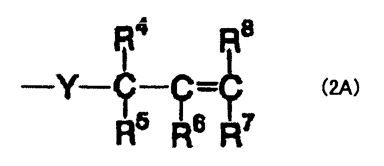

In general formula (2A), R⁴ to R⁸ each independently represent the hydrogen atom or a monovalent organic group. Preferred examples of R⁴ to R⁸ are the hydrogen atom, halogen atoms, the amino group, dialkylamino, the carboxyl group, alkoxycarbonyl, the sulfo group, the nitro group, the cyano group, possibly substituted alkyl, possibly substituted aryl, possibly substituted alkoxy, possibly substituted aryloxy, possibly substituted alkylamino, possibly substituted arylamino, possibly substituted alkylsulfonyl, possibly substituted arylsulfonyl, and so forth. Preferred thereamong are the hydrogen atom, the carboxyl group, alkoxycarbonyl, possibly substituted alkyl, and possibly substituted aryl.

The substituents that can be introduced are exemplified by the same substituents as for general formula (1A). Y represents the oxygen atom, the sulfur atom, or -N(R¹²)-. This R¹² has the same definition as R¹² in general formula (1A) and its preferred examples are also the same.

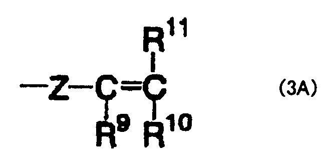

R⁹ to R¹¹ in general formula (3A) each independently represent the hydrogen atom or a monovalent organic group. R⁹ is preferably, for example, the hydrogen atom or a possibly substituted alkyl group, whereamong the hydrogen atom and methyl group are preferred because they have a high radical reactivity. R¹⁰ and R¹¹ are each independently exemplified by the hydrogen atom, halogen atoms, the amino group, dialkylamino, the carboxyl group, alkoxycarbonyl, the sulfo group, the nitro group, the cyano group, possibly substituted alkyl, possibly substituted aryl, possibly substituted alkoxy, possibly substituted aryloxy, possibly substituted alkylamino, possibly substituted arylamino, possibly substituted alkylsulfonyl, possibly substituted arylsulfonyl, and so forth. Preferred thereamong are the hydrogen atom, the carboxyl group, alkoxycarbonyl, possibly substituted alkyl, and possibly substituted aryl because they have a high radical reactivity.

The substituents that can be introduced are exemplified by the same substituents as for general formula (1A). Z represents the oxygen atom, the sulfur atom, -N(R¹²)-, or a possibly substituted phenylene group. This R¹² has the same definition as R¹² in general formula (1A) and its preferred examples are also the same.

In addition to the crosslinking group, polyurethane used in the present invention preferably contains, in side chain position, a group soluble in weakly basic aqueous solution, for example, the carboxyl group. Polyurethane resin is preferred on several points: it can prevent development damage in the photoexposed regions without causing a reduction in the developability of the nonphotoexposed regions even when the image recording layer has a low acid value; it can provide both an excellent scumming behavior and a high printing durability.

Polyurethane preferred for use in the present invention is a resin obtained by the polyaddition reaction of (i) a diisocyanate compound, (ii) a carboxyl group-containing diol compound, (iii) a crosslinking group-containing diisocyanate compound, and optionally (iv) a diol compound that does not contain the carboxyl group.

The diisocyanate compounds and diol compounds that are starting materials for the polyurethane resin are described in the following.

### (i) The diisocyanate compound

The diisocyanate compound can be, for example, a diisocyanate compound represented by formula (4).

OCN - L - NCO (4)

In formula (4), L represents possibly substituted divalent aliphatic or aromatic hydrocarbyl. L may optionally have another functional group that does not react with the isocyanate group; this other functional group can be exemplified by carbonyl, ester, urethane, amide, and ureido. In more specific terms, L represents a single bond or divalent aliphatic or aromatic hydrocarbyl that may be substituted (for example, alkyl, aralkyl, aryl, alkoxy, and halogeno are preferred groups). L preferably represents C₁₋₂₀ alkylene or C₆₋₁₅ arylene and more preferably represents C₁₋₈ alkylene. The other, non-isocyanate-reactive functional group optionally present in L can be exemplified by carbonyl, ester, urethane, amide, ureido, and ether.

Specific examples are as follows: aromatic diisocyanate compounds such as 2,4-tolylene diisocyanate, 2,4-tolylene diisocyanate dimer, 2,6-tolylene diisocyanate, p-xylylene diisocyanate, m-xylylene diisocyanate, 4,4'-diphenylmethane diisocyanate, 1,5-naphthylene diisocyanate, 3,3'-dimethylbiphenyl-4,4'-diisocyanate, and so forth; aliphatic diisocyanate compounds such as hexamethylene diisocyanate, trimethylhexamethylene diisocyanate, lysine diisocyanate, dimer acid diisocyanate, and so forth; alicyclic diisocyanate compounds such as isophorone diisocyanate, 4,4'-methylenebis(cyclohexyl isocyanate), methylcyclohexane-2,4-(or -2,6-)diisocyanate, 1,3-(isocyanatomethyl)cyclohexane, and so forth; and diisocyanate compounds that are the reaction product of a diol with a diisocyanate, such as the adduct of 1 mole 1,3-butylene glycol with 2 moles tolylene diisocyanate.

A single diisocyanate compound may be used or two or more diisocyanate compounds may be used in combination. Viewed from the standpoint of balancing printing durability with scumming behavior, the use of a combination of two or more is preferred and the use of at least one selection from each of aromatic diisocyanate compounds (L = aromatic group) and aliphatic diisocyanate compounds (L = aliphatic group) is particularly preferred.

The diisocyanate is used in a quantity that provides a value preferably of 0.8 to 1.2 and more preferably of 0.9 to 1.1 for the molar ratio relative to the diol compound. In those instances in which the isocyanate group remains at the polymer terminals due to the use of the diisocyanate compound in excess relative to the diol compound, the synthesis preferably proceeds through treatment, for example, with an alcohol or amine, after completion of the urethanation reaction in order to avoid the presence of residual isocyanate groups at the end of the synthesis.

### (ii) The diol compound containing at least one carboxyl group

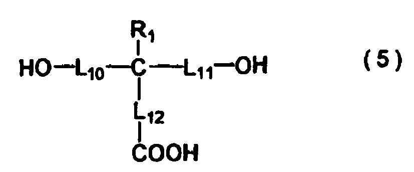

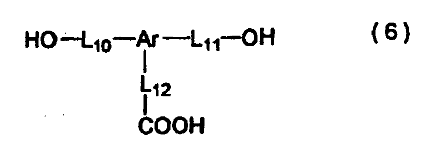

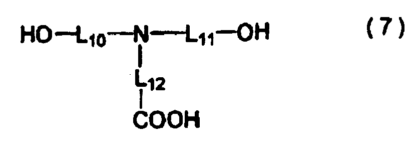

The diol compound containing at least one carboxyl group can be exemplified by the diol compounds with formulas (5), (6), and (7) and/or by compounds yielded by the ring-opening of a tetracarboxylic dianhydride with a diol compound. Diol compounds that are used to effect the ring-opening of carboxylic dianhydrides can be used.

R₁ represents the hydrogen atom or possibly substituted alkyl, aralkyl, aryl, alkoxy, or aryloxy (wherein the substituent encompasses, for example, groups such as cyano, nitro, halogen (-F, -Cl, -Br, -I), -CONH₂, -COOR₁₁₃, - OR₁₁₃, -NHCONHR₁₁₃, -NHCOOR₁₁₃, -NHCOR₁₁₃, and -OCONHR₁₁₃ (this R₁₁₃ represents C₁₋₁₀ alkyl or C₇₋₁₅ aralkyl)) and preferably represents the hydrogen atom, C₁₋₈ alkyl, or C₆₋₁₅ aryl. L₁₀, L₁₁, and L₁₂ each independently represent a single bond or divalent aliphatic or aromatic hydrocarbyl that may be substituted (for example, the substituent is preferably any of alkyl, aralkyl, aryl, alkoxy, and halogen), and preferably represent C₁₋₂₀ alkylene or C₆₋₁₅ arylene and more preferably represent C₁₋₈ alkylene. L₁₀, L₁₁, and L₁₂ may optionally have another, non-isocyanate-reactive functional group, for example, carbonyl, ester, urethane, amide, ureido, or ether. Two or three selections from R₁, L₁₀, L₁₁, and L₁₂ may form a ring. Ar represents possibly substituted trivalent aromatic hydrocarbyl and preferably represents a C₆₋₁₅ aromatic group.

Specific examples of the carboxyl group-containing diol compound represented by formulas (5), (6), and (7) include the following:
3,5-dihydroxybenzoic acid, 2,2-bis(hydroxymethyl)propionic acid, 2,2-bis(2-hydroxyethyl)propionic acid, 2,2-bis(3-hydroxypropyl)proplonic acid, bis(hydroxymethyl)acetic acid, bis(4-hydroxyphenyl)acetic acid, 2,2-bis(hydroxymethyl)butyric acid, 4,4-bis(hydroxyphenyl)pentanoic acid, tartaric acid, N,N-dlhydroxyethylglycine, N,N-bis(2-hydroxyethyl)-3-carboxypropionamide, and so forth.

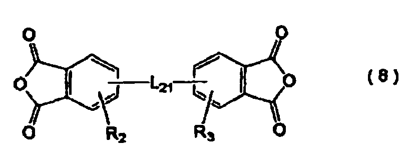

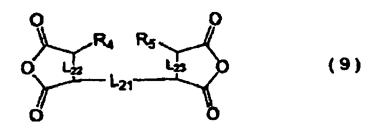

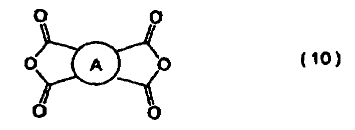

The tetracarboxylic dianhydrides represented by formulas (8), (9), and (10) are examples of tetracarboxylic dianhydrides preferred for use in the production of at least one diol compound that contains at least one carboxyl group.

In these formulas, L₂₁ represents a single bond, possibly substituted divalent aliphatic or aromatic hydrocarbyl (for example, the substituent is preferably any of alkyl, aralkyl, aryl, alkoxy, halogen, ester, and amide), -CO-, - SO-, -SO₂-, -O-, or -S- and preferably represents a single bond, C₁₋₁₅ divalent aliphatic hydrocarbyl, -CO-, -SO₂-, -O-, or -S-. R₂ and R₃ each independently represent the hydrogen atom, alkyl, aralkyl, aryl, alkoxy, and halogeno and preferably represent the hydrogen atom, C₁₋₈ alkyl, C₆₋₁₅ aryl, C₁₋₈ alkoxy, or halogeno. In addition, two selections from L₂₁, R₂, and R₃ may be bonded to each to form a ring. R₄ and R₅ each independently represent the hydrogen atom, alkyl, aralkyl, aryl, or halogen and preferably represent the hydrogen atom, C₁₋₈ alkyl, or C₆₋₁₅ aryl. Two selections from L₂₁, R₄, and R₅ may be bonded to each other to form a ring. L₂₂ and L₂₃ each independently represent a single bond, a double bond, or divalent aliphatic hydrocarbyl and preferably represent a single bond, double bond, or methylene. The group A represents a single nucleus or a polynuclear aromatic ring and preferably represents a C₆₋₁₈ aromatic ring.

Specific examples of the compounds represented by the preceding formulas (8), (9), and (10) include the following:
aromatic tetracarboxylic dianhydrides such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl) ether dianhydride, 4,4'-[3,3'-(alkylphosphoryldiphenylene)bis(iminocarbonyl)]diphthalic dianhydride, the adduct of hydroquinone diacetate and trimellitic anhydride, the adduct of diacetyldiamine and trimellitic anhydride, and so forth; alicyclic tetracarboxylic dianhydrides such as 5-(2,5-dioxotetrahydrofuryl)-3-methyl-3-cyclohexene-1,2-dicarboxylic anhydride (Epiclon B-4400 from Dainippon Ink and Chemicals, Incorporated), 1,2,3,4-cyclopentanetetracarboxylic dianhydride, 1,2,4,5-cyclohexanetetracarboxylic dianhydride, tetrahydrofurantetracarboxylic dianhydride, and so forth; and aliphatic tetracarboxylic dianhydrides such as 1,2,3,4-butanetetracarboxylic dianhydride, 1,2,4,5-pentanetetracarboxylic dianhydride, and so forth.

The (ii) diol compound containing at least one carboxyl group can be synthesized by ring-opening of the aforementioned tetracarboxylic dianhydride with a diol compound. However, the polyurethane resin of the present invention may also be synthesized by first reacting a diol compound with the (i) diisocyanate compound and then reacting this reaction product with a tetracarboxylic dianhydride as described above, and this method is also included from the perspective of the present invention. That is, the following methods can be used for the introduction into the polyurethane resin of a structural unit originating from a tetracarboxylic dianhydride and a diol compound.
a) The method of ring-opening the tetracarboxylic dianhydride with a diol compound and reacting the obtained alcohol-terminated compound with a diisocyanate compound.
b) The method of reacting a tetracarboxylic dianhydride with an alcohol-terminated urethane compound itself obtained by reacting a diisocyanate compound with excess diol compound.

Among diol compounds that contain at least one carboxyl group, compounds represented by general formula (5) are more preferred because they exhibit a high solvent solubility and are easy to synthesize. In addition, the diol compound containing at least one carboxyl group is introduced into the polyurethane resin binder in a quantity such that the polyurethane resin binder contains the carboxyl group in the range of 0.2 to 4.0 meq/g, preferably 0.3 to 3.0 meq/g, more preferably 0.4 to 2.0 meq/g, particularly preferably 0.5 to 1.5 meq/g, and most preferably 0.6 to 1.2 meq/g. Thus, the content in the polyurethane resin binder of the structure originating from the diol compound containing at least one carboxyl group is selected as appropriate in accordance with the number of carboxyl groups, the nature of any other diol component, the acid value and molecular weight of the obtained polyurethane resin binder, the composition and pH of the development liquid, and so forth, and is, for example, 5 to 45 mol%, preferably 10 to 40 mol%, and more preferably 15 to 35 mol%.

### (iii) The crosslinking group-containing diisocyanate compound

The crosslinking group-containing diisocyanate compound can be the product obtained, for example, by an addition reaction between a triisocyanate compound and one equivalent of a crosslinking group-containing monofunctional alcohol or monofunctional amine compound.

The triisocyanate compound can be exemplified by the following, but is not limited to the following.

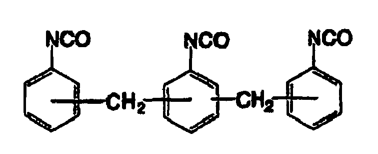

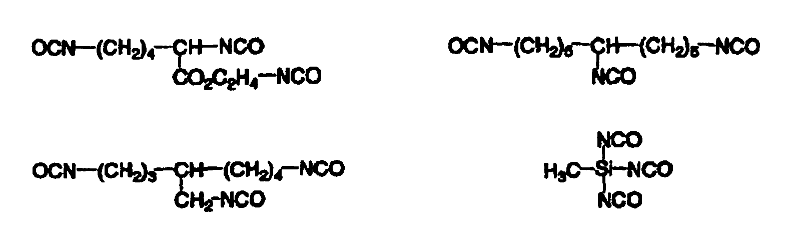

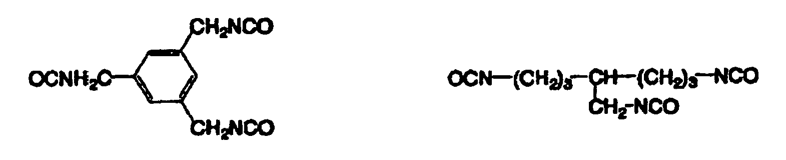

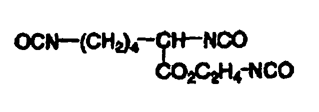

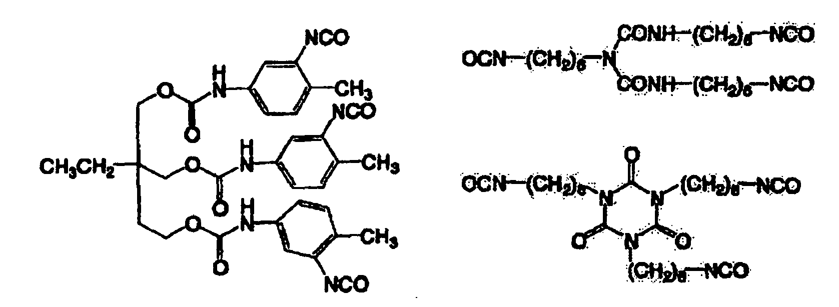

The crosslinking group-containing monofunctional alcohol and the crosslinking group-containing monofunctional amine compound can be exemplified by the following, but are not limited to the following.

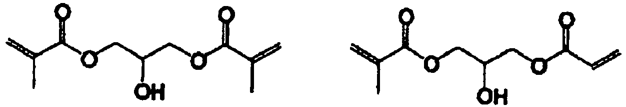

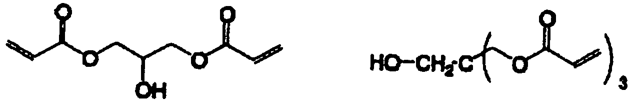

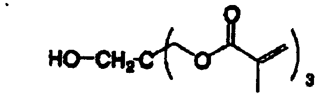

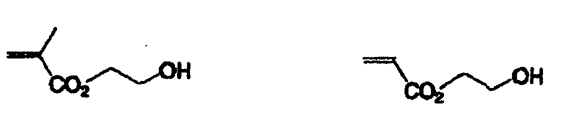

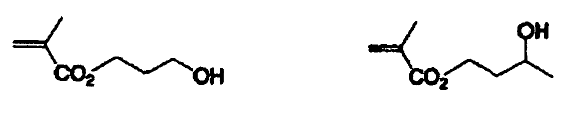

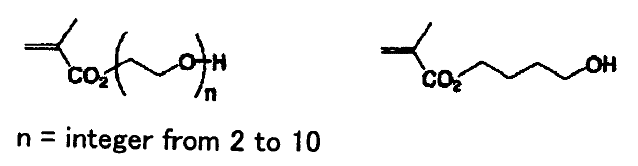

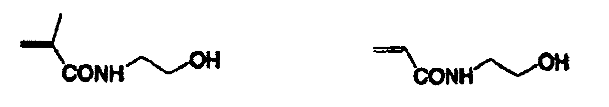

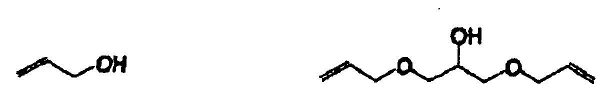

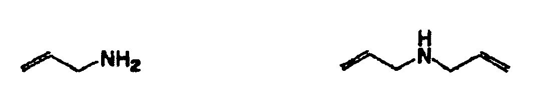

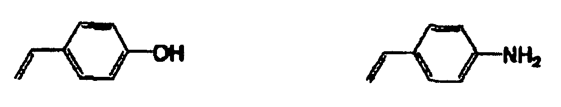

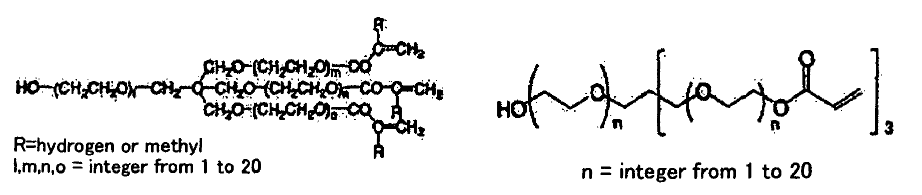

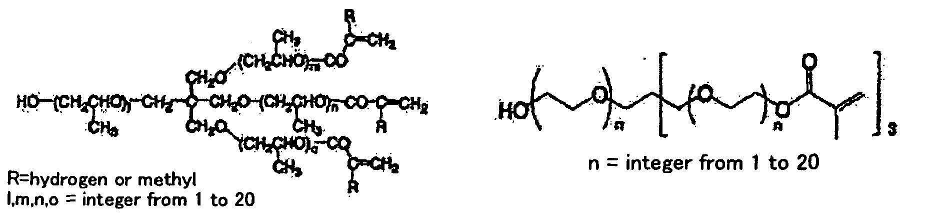

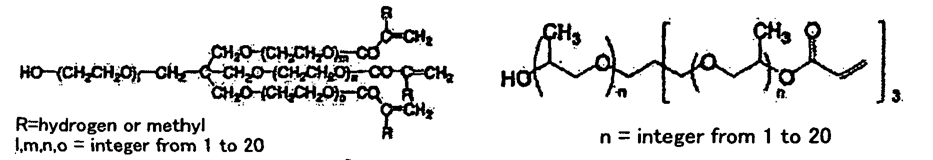

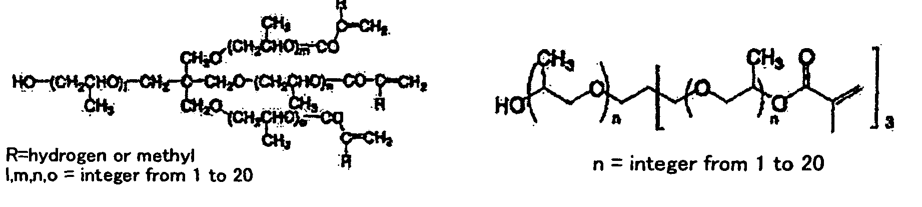

In a suitable method of introducing the crosslinking group into the side chain of the polyurethane resin, a diisocyanate compound having a crosslinking group in side chain position is used as a starting material in production of the polyurethane resin. The following are examples of diisocyanate compounds that have a crosslinking group in side chain position and that can be obtained by an addition reaction between a triisocyanate compound and one equivalent of a crosslinking group-containing monofunctional alcohol or crosslinking group-containing monofunctional amine compound; however, this diisocyanate compound is not limited to the following.

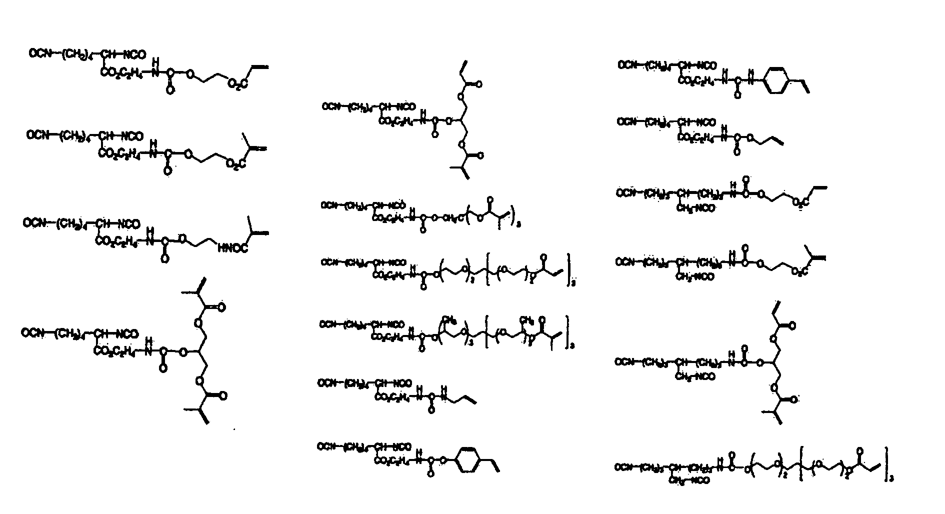

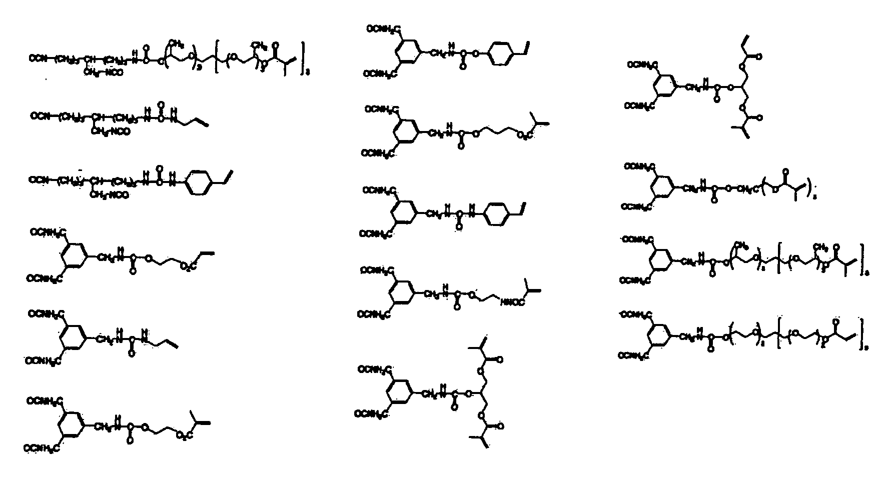

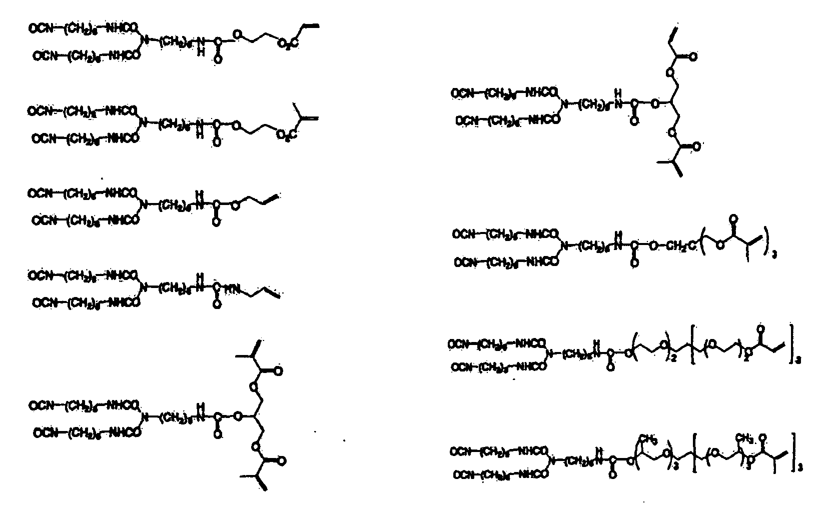

### (iv) Other diol compounds

In addition to the method described above, another suitable method for introducing an unsaturated group into side position in the polyurethane resin is to use a diol compound that contains an unsaturated group in side chain position. A diol compound of this nature may be, for example, a commercially available diol compound such as trimethylolpropane monoallyl ether or may be a compound that is readily produced by the reaction of a halogenated diol compound, a triol compound, or an amino diol compound with an unsaturated group-containing carboxylic acid, acid chloride, isocyanate, alcohol, amine, thiol, or halogenated alkyl compound. These compounds can be specifically exemplified by the compounds shown below but are not limited to the compounds shown below.

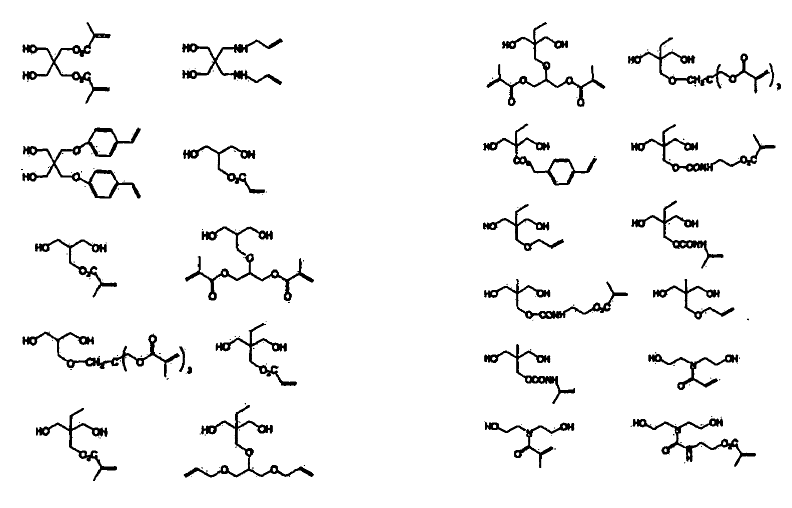

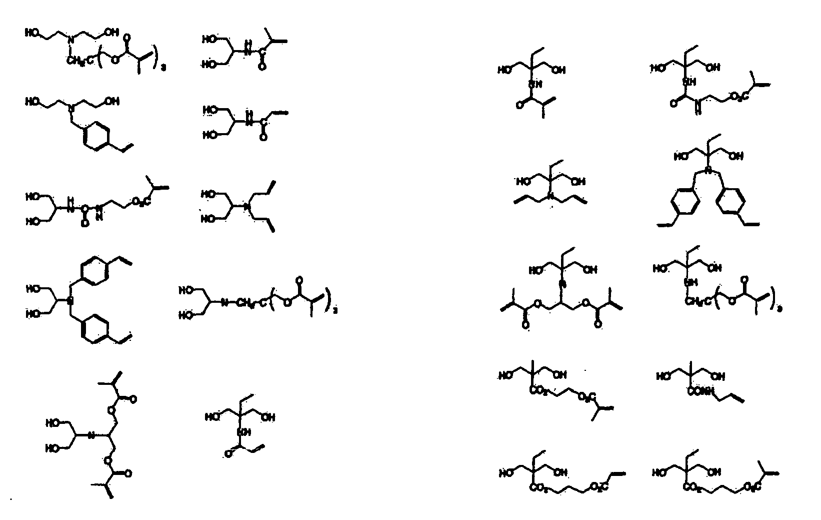

The other diol compound may be further exemplified by ethylene glycol compounds represented by the following general formula (A').

HO-(CH₂CH₂O)n-H (A')

(n in the formula is an integer with a value of at least 1.)

Other examples are hydroxyl-terminated ethylene oxide/propylene oxide random and block copolymers.

The following are also usable: ethylene oxide adducts of bisphenol A (number of ethylene oxides added = 27 (inclusive) to 100 (inclusive)), ethylene oxide adducts of bisphenol F (number of ethylene oxides added = 22 (inclusive) to 100 (inclusive)), ethylene oxide adducts of hydrogenated bisphenol A (number of ethylene oxides added = 23 (inclusive) to 100 (inclusive)), and ethylene oxide adducts of hydrogenated bisphenol F (number of ethylene oxides added = 18 (inclusive) to 100 (inclusive)). More specifically, the ethylene glycol compounds represented by general formula (A') are preferred from the standpoint of the scumming behavior, while ethylene glycol compounds in which n is 2 to 50 are more preferred, ethylene glycol compounds in which n is 3 to 30 are even more preferred, and ethylene glycol compounds in which n is 4 to 10 are particularly preferred.

The following are specific examples: 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol with an average molecular weight of 400, polypropylene glycol with an average molecular weight of 700, polypropylene glycol with an average molecular weight of 1000, polypropylene glycol with an average molecular weight of 2000, polypropylene glycol with an average molecular weight of 3000, polypropylene glycol with an average molecular weight of 4000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, ethylene oxide adducts of bisphenol A (number of ethylene oxides added = no more than 26), ethylene oxide adducts of bisphenol F (number of ethylene oxides added = no more than 21), ethylene oxide adducts of hydrogenated bisphenol A (number of ethylene oxides added = no more than 22), ethylene oxide adducts of hydrogenated bisphenol F (number of ethylene oxides added = no more than 17), propylene oxide adducts of bisphenol A, propylene oxide adducts of bisphenol F, propylene oxide adducts of hydrogenated bisphenol A, propylene oxide adducts of hydrogenated bisphenol F, hydroquinone dihydroxyethyl ether, p-xylylene glycol, dihydroxyethyl sulfone, bis(2-hydroxyethyl)-2,4-tolylene dicarbamate, 2,4-tolylenebis(2-hydroxyethylcarbamide), bis(2-hydroxyethyl)-m-xylylene dicarbamate, and bis(2-hydroxyethyl) isophthalate.

Also suitable for use are the polyether diol compounds represented by formulas (a), (b), (c), (d), and (e).

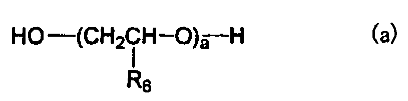

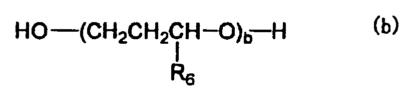

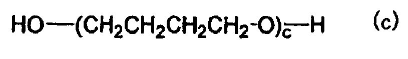

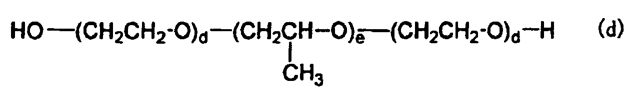

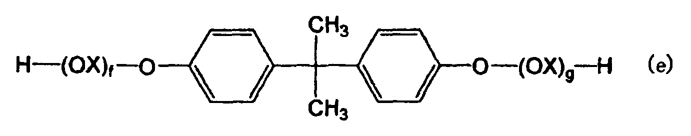

R₆ in formulas (a) and (b) represents the hydrogen atom or methyl group. However, R₆ in formula (a) represents the methyl group. In addition, X represents the following groups.

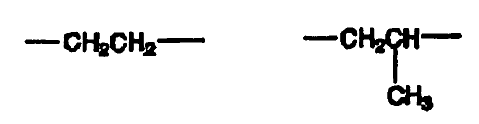

a, b, c, d, e, f, and g are each integers with a value of at least 2. They are preferably integers from 2 to 100.

Other specific examples are the polyester diol compounds represented by formulas (11) and (12).

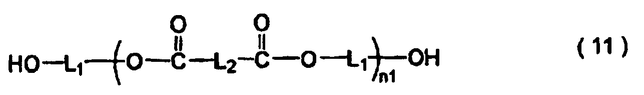

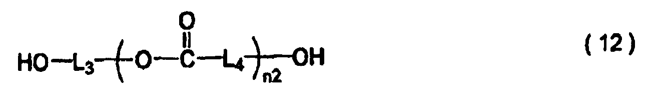

L₁, L₂, and L₃ in these formulas each independently represent divalent aliphatic or aromatic hydrocarbyl, while L₄ represents divalent aliphatic hydrocarbyl. L₁, L₂, and L₃ each preferably represent alkylene, alkenylene, alkynylene, or arylene while L₄ preferably represents alkylene. In addition, L₁, L₂, L₃, and L₄ may contain another, non-isocyanate-reactive group, for example, ether, carbonyl, ester, cyano, olefin, urethane, amide, ureido, or a halogen atom. n1 and n2 are each integers with a value of at least 2 and preferably are integers from 2 to 100.

Other specific examples are the polycarbonate diol compounds represented by formula (13).

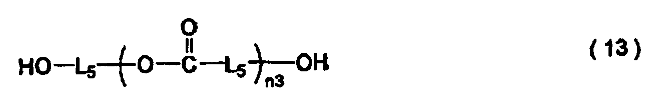

The L₅ groups in formula (13) each independently represent divalent aliphatic or aromatic hydrocarbyl. L₅ preferably represents alkylene, alkenylene, alkynylene, or arylene. In addition, L₅ may contain another, non-isocyanate-reactive group, for example, ether, carbonyl, ester, cyano, olefin, urethane, amide, ureido, or a halogen atom. n3 is an integer with a value of at least 2 and preferably is an integer from 2 to 100.

Specific examples of the diol compounds represented by formulas (11), (12), and (13) include the following. n in these specific examples is an integer with a value of least 2.

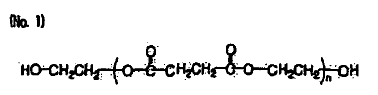

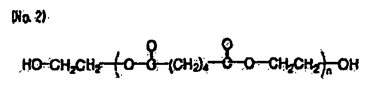

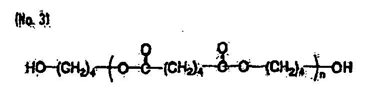

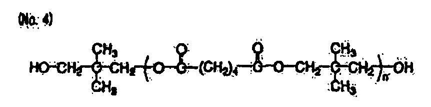

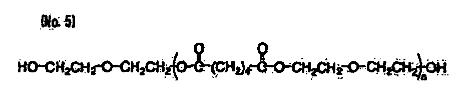

The diols indicated below are also preferred for use.

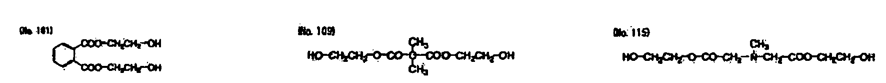

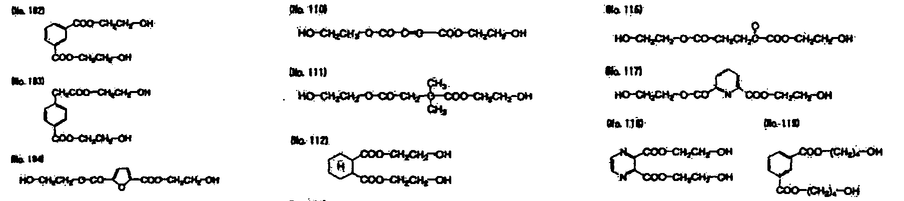

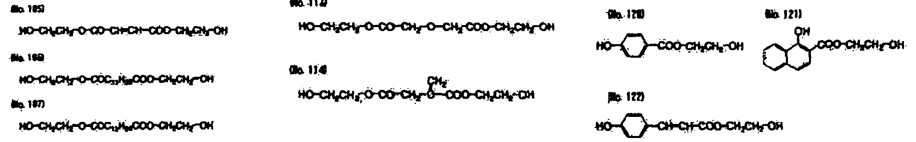

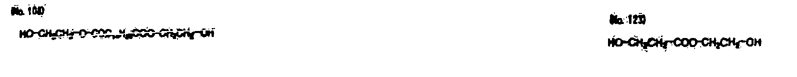

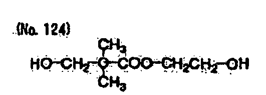

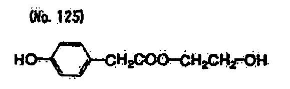

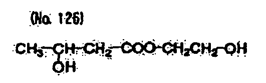

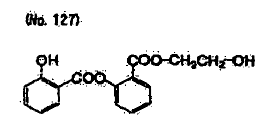

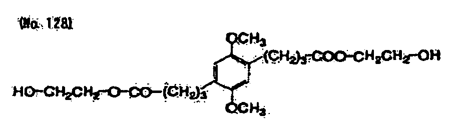

The diols indicated below can also be suitably used.

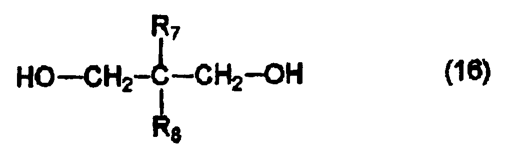

HO-CH₂-C≡C-CH₂-OH (17)

HO-CH₂-CH=CH-CH₂-OH (18)

R₇ and R₈ in formula (16) independently represent possibly substituted alkyl and preferably represent C₁₋₁₀ alkyl that may be substituted by, for example, any of cyano, nitro, halogen (-F, -Cl, -Br, -I), -CONH₂, -COOR, -OR, and so forth (wherein this R independently represents C₁₋₁₀ alkyl, C₇₋₁₅ aryl, or aralkyl).

The following are specific examples of diol compounds represented by formula (16).

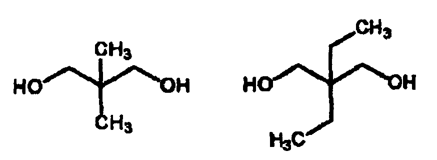

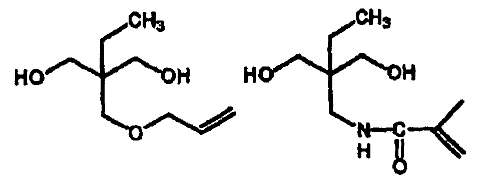

Formula (17) can be exemplified by 2-butyne-1,4-diol, while formula (18) can be exemplified by cis-2-butene-1,4-diol and trans-2-butene-1,4-diol.

The diol compounds represented by the following formulas (19) and (20) are also suitable for use.

HO-L₈-NH-CO-L₉-CO-NH-L₈-OH (19)

HO-L₉-CO-NH-L₈-OH (20)

L₈ and L₉ in the formulas each independently represent a possibly substituted divalent aliphatic hydrocarbyl, aromatic hydrocarbyl, or heterocyclic group wherein the substituent encompasses, for example, any of alkyl, aralkyl, aryl, alkoxy, aryloxy, halogen (-F, -Cl, -Br, -I), and so forth. L₈ and L₉ may also optionally contain another, non-isocyanate-reactive functional group, for example, carbonyl, ester, urethane, amide, ureido, and so forth. A ring may also be formed by L₈ and L₉.

Specific examples of the compounds represented by formulas (19) and (20) include the following.

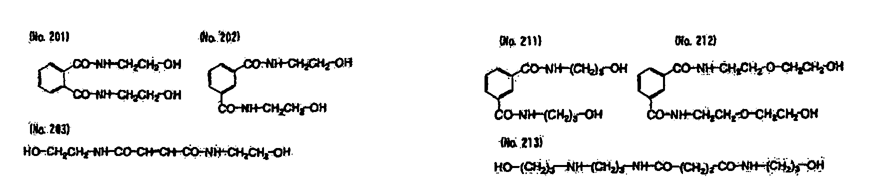

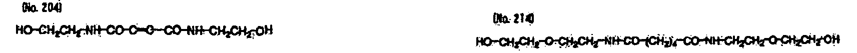

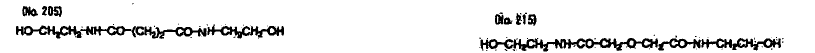

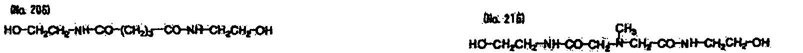

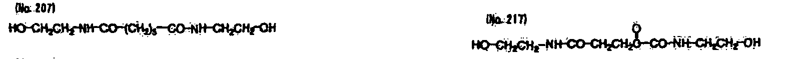

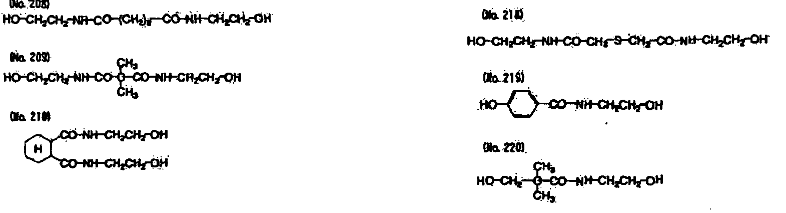

The diol compounds represented by the following formulas (21) and (22) are also suitable for use.

HO-Ar₂-(L₁₆-Ar₃)ₙ-OH (21)

HO-Ar₂-L₁₆-OH (22)

L₁₆ in the formulas represents possibly substituted divalent aliphatic hydrocarbyl wherein the substituent is preferably, for example, any of alkyl, aralkyl, aryl, alkoxy, aryloxy, or halogeno. L₁₆ may also optionally contain another, non-isocyanate-reactive functional group, for example, ester, urethane, amide, or ureido.

Ar₂ and Ar₃ each independently represent possibly substituted divalent aromatic hydrocarbyl and preferably represent a C₆₋₁₅ aromatic group. n represents an integer from 0 to 10.

Specific examples of diol compounds represented by formulas (21) and (22) include the following:
Catechol, resorcinol, hydroquinone, 4-methylcatechol, 4-t-butylcatechol, 4-acetylcatechol, 3-methoxycatechol, 4-phenylcatechol, 4-methylresorcinol, 4-ethylresorcinol, 4-t-butylresorcinol, 4-hexylresorcinol, 4-chlororesorcinol, 4-benzylresorcinol, 4-acetylresorcinol, 4-carbomethoxyresorcinol, 2-methylresorcinol, 5-methylresorcinol, t-butylhydroquinone, 2,5-di-t-butylhydroquinone, 2,5-di-t-amylhydroquinone, tetramethylhydroquinone, tetrachlorohydroquinone, methylcarboaminohydroquinone, methylureidohydroquinone, methylthiohydroquinone, benzonorbornene-3,6-dial, bisphenol A, bisphenol S, 3,3'-dichlorobisphenol S, 4,4'-dihydroxybenzophenone, 4,4'-dihydroxydiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dlhydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl 4-hydroxybenzoate, 2-hydroxyethyl-4-hydroxyphenyl acetate, resorcinol mono-2-hydroxyethyl ether, and so forth. The diol compounds indicated below can also be suitably used.

### (v) Other amino group-containing compounds

A urea structure may be formed and incorporated in the structure of the polyurethane resin in the polyurethane resin binder for the present invention by the addition of an amino group-containing compound represented by the following formula (31) or (32) and its reaction with the diisocyanate compound.

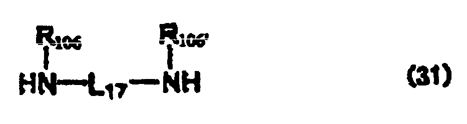

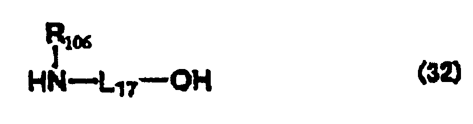

R₁₀₆ and R₁₀₆, in the formulas each independently represent the hydrogen atom or possibly substituted alkyl, aralkyl, or aryl wherein the substituent encompasses, for example, any of alkoxy, halogen (-F, -Cl, -Br, -I), ester, the carboxyl group, and so forth. R₁₀₆ and R₁₀₆, in the formulas preferably represent the hydrogen atom or possibly substituted C₁₋₈ alkyl or C₆₋₁₅ aryl that may be substituted by the carboxyl group. L₁₇ represents a possibly substituted divalent aliphatic hydrocarbyl, aromatic hydrocarbyl, or heterocyclic group wherein the substituent encompasses, for example, any of alkyl, aralkyl, aryl, alkoxy, aryloxy, halogen (-F, -Cl, -Br, -I), the carboxyl group, and so forth. L₁₇ may also optionally contain another, non-isocyanate-reactive functional group, for example, carbonyl, ester, urethane, amide, and so forth. Two selections from R₁₀₆, L₁₇, and R₁₀₆, may form a ring.

Specific examples of compounds represented by formulas (31) and (32) include the following:
Aliphatic diamine compounds such as ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-methylpiperidine, N,N-dimethylethylenediamine, lysine, L-cystine, isophoronediamine, and so forth; aromatic diamine compounds such as o-phenylenediamine, m-phenylenediamine, p-phenylenediamine, 2,4-tolylenediamine, benzidine, o-ditoluldine, o-dianisidine, 4-nitro-m-phenylenediamine, 2,5-dimethoxy-p-phenylenediamine, bis(4-aminophenyl) sulfone, 4-carboxy-o-phenylenediamine, 3-carboxy-m-phenylenediamine, 4,4'-diaminophenyl ether, 1,8.naphthalenediamine, and so forth; heterocyclic amine compounds such as 2-aminolmidazole, 3-aminotriazole, 5-amino-1H-tetrazole, 4-aminopyrazole, 2-aminobenzimidazole, 2-amino-5-carboxytriazole, 2,4-diamino-6-methyl-s-triazine, 2,6-diaminopyridine, L-histidine, DL-tryptophan, adenine, and so forth; and amino alcohol and aminophenol compounds such as ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-I-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol, L-tyrosine, and so forth.

In addition to the previously described polyurethane resin obtained by the introduction of a crosslinking group in side chain position during polyurethane synthesis, the binder polymer in the present invention may also be a polyurethane resin obtained by the introduction, by a polymer reaction, of a crosslinking group into a carboxyl-functional polyurethane, as described in Japanese Patent Application Publication No. 2003-270775.

Particularly preferred for use in the present invention is the combination of a monomer having a melting point of at least 45°C with a urethane resin containing a crosslinking group as described above. Specific examples of such a urethane resin are indicated below, but the present invention is not limited to these.

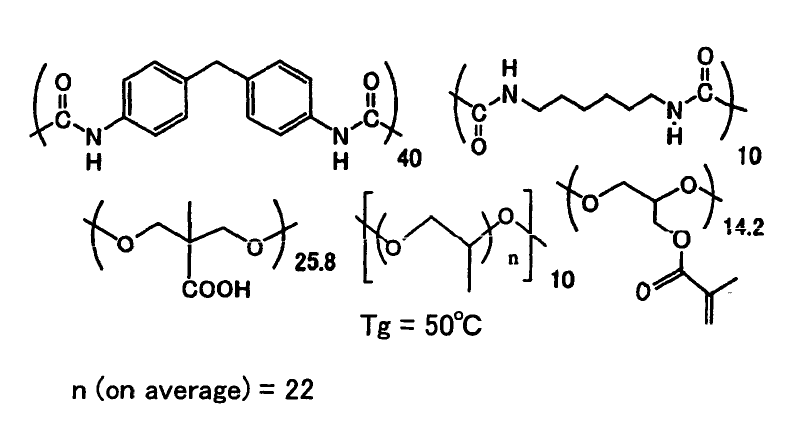

The binder polymer used preferably has a molecular weight suitable for maintaining the developability of the photosensitive layer, and a mass-average molecular weight of 5,000 to 300,000 is preferred while the more preferred range is 20,000 to 150,000.

The binder polymer may be present in the photosensitive layer in a freely selected quantity, but because in some instances preferred effects, e.g., in terms of the strength of the image that is formed and so forth, may not be provided when the binder polymer content exceeds 90 mass%, 10 to 90 mass% is preferred and 30 to 80 mass% is more preferred.

In addition to the fundamental components described above, the photosensitive layer used by the present invention may contain other components as required. For example, the photosensitive layer may contain a dye or pigment capable of absorbing light at ± 50 nm with respect to the wavelength of the laser emission used for imagewise photoexposure. However, these dyes and pigments differ from the sensitizing dye in that they do not possess the capacity to transmit energy to the photopolymerization initiator.

There are no particular limitations on the aforementioned dye or pigment other than that it should have the ability to absorb light in the wavelength interval that is ± 50 nm with respect to the wavelength of laser emission. However, a dye or pigment that has an absorption maximum in the ± 50 nm interval with respect to the wavelength of laser emission is preferred, while a dye or pigment that has an absorption maximum in the ± 20 nm interval with respect to the wavelength of laser emission is more preferred and a dye or pigment that has an absorption maximum at the same wavelength as the wavelength of laser emission is even more preferred.

Photoexposure by a blue-to-ultraviolet laser that emits light from 350 nm to 450 nm is particularly desirable in the present invention, and a yellow dye or pigment is desirable as the dye or pigment corresponding to such a laser.

Yellow acid dyes are examples of the yellow dyes. Specific examples are the acid dyes described in the Dye Handbook and the C.I. Acid Yellow group. The following are examples of particularly effective dyes: C.I. Acid Yellow 17, C.I. Acid Yellow 19, C.I. Acid Yellow 23, C.I. Acid Yellow 38, C.I. Acid Yellow 42, C.I. Acid Yellow 61, C.I. Acid Yellow 72, and C.I. Acid Yellow 141.

The dyes indicated below are also preferred for use.

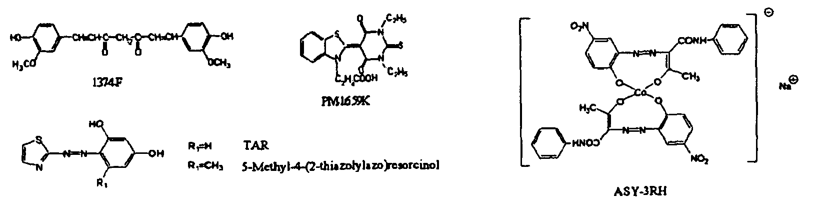

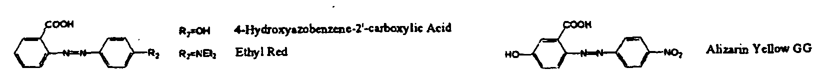

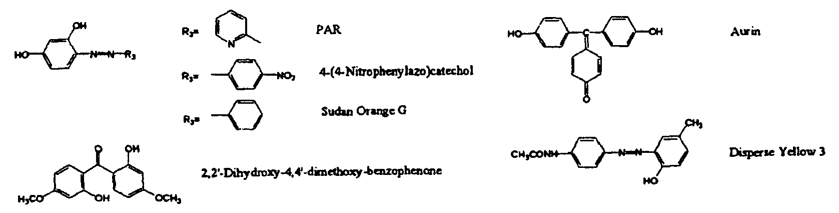

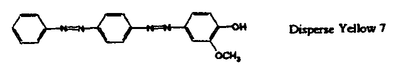

The following are examples of yellow pigments: Novoperm Yellow H2G, Seikafast Yellow 2200, Seikafast Yellow 2300, Seikafast Yellow, HOSTACOPY Y501, Yellow Masterbatch, PV Fast Yellow HG, Novoperm Yellow P-HG, Novoperm Yellow M2R, and so forth.

The use of such a dye or pigment has the effect of preventing the plugging collapse of shadow regions that may arise due to the influence of reflected or scattered laser light and can provide a printing plate that gives high-quality printed matter free of screen tint unevenness in the halftones even in high-definition AM screen printing or FM screen printing and particularly with photoexposure using an FM screen.

The quantity of addition of the aforementioned dye or pigment to the photosensitive layer is preferably at least 0.01 mass% with respect to the mass of the photosensitive layer and more preferably is at least 0.05 mass% with respect to the mass of the photosensitive layer. This quantity of addition is preferably no more than 10 mass% from the perspective of maintaining the quantity of light reaching the photosensitive layer and maintaining the sensitivity in a good range, and is more preferably no more than 5 mass%.

A small quantity of a thermal polymerization inhibitor is desirably added to the photosensitive layer used by the present invention in order to prevent unwanted thermal polymerization of the ethylenically unsaturated double bond-containing addition-polymerizable compound during either production or storage of the composition (photopolymerizable photosensitive composition) used to form the photosensitive layer. Examples of suitable thermal polymerization inhibitors are hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), the cerous salt of N-nitrosophenylhydroxylamine, the aluminum salt of N-nitrosophenylhydroxylamine, and so forth. The quantity of addition of the thermal polymerization inhibitor is preferably approximately 0.01 mass% to approximately 5 mass% of all the components of the aforementioned composition. In addition, in order to prevent the oxygen-induced inhibition of polymerization, behenic acid or a higher aliphatic acid derivative such as behenamide may be added; these segregate to the surface of the photosensitive layer during post-coating drying. The quantity of addition of the higher aliphatic acid derivative is preferably approximately 0.5 mass% to approximately 10 mass% of all the components of the photopolymerizable photosensitive composition.

A colorant may be added in order to colorize the photosensitive layer. This colorant can be exemplified by pigments such as phthalocyanine pigments (C.I. Pigment Blue 15:3, 15:4, 15:6, and so forth), azo pigments, carbon black, titanium oxide, and so forth, and by Ethyl Violet, Crystal Violet, azo dyes, anthraquinone dyes, and cyanine dyes. The quantity of colorant addition is preferably approximately 0.5 mass% to approximately 5 mass% of the total components of the photopolymerizable photosensitive composition.

Additives such as an inorganic filler and a plasticizer (e.g., dioctyl phthalate, dimethyl phthalate, tricresyl phosphate, and so forth) may be added in order to improve the properties of the cured film. The quantity of addition for these additives is preferably no more than 10 mass% of the total components of the photopolymerizable photosensitive composition.

A surfactant may be added to the composition for forming the photosensitive layer in order to improve the quality of the coating surface. Nonionic fluorosurfactants are an example of a suitable surfactant.

The photosensitive layer is formed in the present invention by coating the photosensitive layer-forming composition on the support, infra. The photosensitive layer-forming composition is coated on the support by dissolution in organic solvent to prepare a coating fluid. The following, for example, can be used as the solvent: acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ -butyrolactone, methyl lactate, and ethyl lactate. A single one of these solvents may be used or a mixture of these solvents may be used. The solids concentration in the coating solution is suitably 1 to 50 mass%.

The quantity of photosensitive layer application for the lithographic printing plate precursor of the present invention is preferably in the range of approximately 0.1 g/m² to approximately 10 g/m², more preferably 0.3 to 5 g/m², and even more preferably 0.5 to 3 g/m², in each case as the mass after application and drying.

### The protective layer

An oxygen-blocking protective layer (overcoat layer) is preferably disposed on the photosensitive layer in order to stop the polymerization-inhibiting activity of oxygen.

The protective layer is preferably applied at 0.5 to 3.0 g/m². The sensitivity is reduced at less than 0.5 g/m², while the burden on the treatment process increases at above 3.0 g/m². The range of 0.7 to 2.5 g/m² is preferred.

The protective layer preferably comprises a water-soluble polymer, which can be specifically exemplified by polyvinyl alcohol and its partial esters, ethers, and acetals and by copolymers that contain the unsubstituted vinyl alcohol unit substantially in the quantity that provides the copolymer with the required water solubility. The polyvinyl alcohol suitably has a degree of hydrolysis of 71 to 100% and a degree of polymerization of 300 to 2400. Specific examples are the following products from Kuraray Co., Ltd.: PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, and so forth. Other examples are polyvinyl acetate, chloroacetate, or propionate, as well as polyvinyl formal and polyvinyl acetal, in each case having a degree of hydrolysis of 88% to less than 100%. Other useful water-soluble polymers are polyvinyl pyrrolidone, gelatin, gum arabic, and so forth. A single water-soluble polymer may be used or a plurality may be used in combination.

The use of a degree of hydrolysis of at least 95% for the polyvinyl alcohol is desirable in the present invention in order to obtain particularly good effects.

A modified polyvinyl alcohol can also be used in the protective layer. The use of an acid-modified polyvinyl alcohol is particularly preferred.

### Acid-modified polyvinyl alcohol

The acid-modified polyvinyl alcohol is a vinyl alcohol-type polymer that contains a suitable amount of an acid group but is not otherwise particularly limited. A vinyl alcohol-type polymer containing a suitable amount of a sulfonic acid group or carboxyl group is particularly preferred for use. The former is designated a sulfonic acid-modified polyvinyl alcohol and the latter is designated a carboxylic acid-modified polyvinyl alcohol.

The acid-modified polyvinyl alcohol is preferably synthesized by copolymerizing an acid group-containing monomer with vinyl acetate and thereafter effecting a partial or complete saponification of the vinyl acetate to yield vinyl alcohol; however, synthesis may also be carried out by bonding an acid group-containing compound to the hydroxyl group in a polyvinyl alcohol.

The following are examples of sulfonic acid group-containing monomers: ethylenesulfonic acid, allylsulfonic acid, methallylsulfonic acid, 2-acrylamido-2-methylpropanesulfonic acid, and salts of the preceding. Sulfonic acid group-containing compounds can be exemplified by sulfonic acid group-containing aldehyde derivatives, such as p-sulfonic acid benzaldehyde and its salts, wherein introduction can be carried out by a heretofore known acetalation reaction.

The following are examples of carboxyl group-containing monomers: fumaric acid, maleic acid, itaconic acid, maleic anhydride, phthalic anhydride, trimellitic anhydride, acrylic acid, salts of the preceding, acrylate esters (e.g., methyl acrylate and so forth), and methacrylate esters (e.g., methyl methacrylate and so forth). Carboxyl group-containing compounds can be exemplified by monomers such as acrylic acid, wherein introduction can be carried out by a heretofore known Michael addition reaction.

The acid-modified polyvinyl alcohol may be an acid-modified polyvinyl alcohol synthesized by a suitable method or may be a commercially acquired product.

The acid-modified polyvinyl alcohol can prevent a reduction in the removability of the photosensitive layer by development. Its degree of saponification is preferably at least 91 mol%.

The following are specific examples of such acid-modified polyvinyl alcohols having a high degree of saponification: carboxyl-modified polyvinyl alcohols such as KL-118 (degree of saponification = 97 mol%, average degree of polymerization = 1800), KM-618 (degree of saponification = 94 mol%, average degree of polymerization = 1800), KM-118 (degree of saponification = 97 mol%, average degree of polymerization = 1800), and KM-106 (degree of saponification = 98.5 mol%, average degree of polymerization = 600), all from Kuraray Co., Ltd.; Gohsenol T-330H (degree of saponification = 99 mol%, average degree of polymerization = 1700), Gohsenol T-330 (degree of saponification = 96.5 mol%, average degree of polymerization = 1700), Gohsenol T-350 (degree of saponification = 94 mol%, average degree of polymerization = 1700), Gohsenol T-230 (degree of saponification = 96.5 mol%, average degree of polymerization = 1500), Gohsenol T-215 (degree of saponification = 96.5 mol%, average degree of polymerization = 1300), and Gohsenol T-HS-1 (degree of saponification = 99 mol%, average degree of polymerization = 1300), all from The Nippon Synthetic Chemical Industry Co., Ltd.; and AF-17 (degree of saponification = 96.5 mol%, average degree of polymerization = 1700) and AT-17 (degree of saponification = 93.5 mol%, average degree of polymerization = 1700) from Japan VAM & Poval Co., Ltd.

Sulfonic acid-modified polyvinyl alcohol can be exemplified by SK-5102 (degree of saponification = 98 mol%, average degree of polymerization = 200) from Kuraray Co., Ltd. and Gohseran CKS-50 (degree of saponification = 99 mol%, average degree of polymerization = 300) from The Nippon Synthetic Chemical Industry Co., Ltd.

The use of acid-modified polyvinyl alcohol having an average degree of polymerization of 100 to 800 for the vinyl alcohol unit is particularly preferred from the standpoint of an even more effective inhibition of a reduction in the removability of the photosensitive layer by development. The use of such an acid-modified polyvinyl alcohol having a low degree of polymerization and a high degree of saponification can provide a protective layer that can effectively prevent a reduction in the removability of the photosensitive layer by development while maintaining an excellent oxygen-blocking performance.

The following are preferred for the aforementioned acid-modified polyvinyl alcohol having a low degree of polymerization and a high degree of saponification: sulfonic acid-modified polyvinyl alcohol and carboxyl-modified polyvinyl alcohol modified by itaconic acid or maleic acid, in any case having a degree of saponification of at least 91 mol% and a degree of polymerization for the vinyl alcohol unit of 100 to 800.

The degree of modification of the acid-modified polyvinyl alcohol represents the molar ratio for the acid group-containing unit present in the acid-modified polyvinyl alcohol copolymer. The degree of modification of the acid-modified polyvinyl alcohol is preferably 0.1 to 20 mol% and more preferably is 0.2 to 5 mol%.

Pure water is preferred for the solvent used to prepare the protective layer coating fluid, but a mixture of pure water with an alcohol (e.g., methanol, ethanol, and so forth) or a ketone (acetone, methyl ethyl ketone, and so forth) may also be used. The solids concentration in the coating fluid is suitably 1 to 20 mass%. The protective layer may also contain known additives, for example, surfactant to bring about further improvement in the coatability and water-soluble plasticizer in order to improve the properties of the applied film. The water-soluble plasticizer can be exemplified by propionamide, cyclohexanediol, glycerol, sorbitol, and so forth. A water-soluble (meth)acrylic polymer may also be added. The quantity of protective layer application, expressed as the mass after drying, is preferably in the range of approximately 0.1 g/m² to approximately 15 g/m² and more preferably is 1.0 g/m² to approximately 5.0 g/m².

### The method of producing the lithographic printing plate

A detailed description follows for the method of producing a lithographic printing plate that uses the lithographic printing plate precursor in accordance with the present invention. The inventive method of producing a lithographic printing plate comprises imagewise photoexposing the lithographic printing plate precursor (photoexposure step) and thereafter processing the lithographic printing plate precursor with an aqueous solution having a pH of 8.5 to 10.8 and containing a low molecular weight hydroxycarboxylic acid ion, a pH buffer, and a surfactant (development step). As necessary, a step of subjecting the lithographic printing plate precursor to whole-surface photoexposure and/or heating may be placed between the photoexposure step and the development step and/or after the development step.

The imagewise photoexposure of the lithographic printing plate precursor can be performed by, for example, photoexposure through a transparent original image that bears, for example, a line image, halftone image, and so forth, or by laser scanning from digital data. A desirable wavelength for the photoexposure light source is 350 nm to 450 nm.

The following can be used as available laser light sources emitting at 350 nm to 450 nm: gas lasers such as the Ar ion laser (364 nm, 351 nm, 10 mW to 1 W), the Kr ion laser (356 nm, 351 nm, 10 mW to 1 W), and the He-Cd laser (441 nm, 325 nm, 1 mW to 100 mW); solid state lasers such as the combination of Nd:YAG (YV0₄) and SHG crystal × 2 (355 nm, 5 mW to 1 W) and the combination of Cr:LiSAF and SHG crystal (430 nm, 10 mW); semiconductor laser systems such as the KNbO₃ ring resonator (430 nm, 30 mW), the combination of an AlGaAs or InGaAs semiconductor with a waveguide-type wavelength conversion element (380 nm to 450 nm, 5 mW to 100 mW), the combination of an AlGaInP or AlGaAs semiconductor with a waveguide-type wavelength conversion element (300 nm to 350 nm, 5 mW to 100 mW), and AIGaInN (350 nm to 450 nm, 5 mW to 30 mW); in addition, pulse lasers such as the N₂ laser (337 nm, pulse 0.1 to 10 mJ) and XeF (351 nm, pulse 10 to 250 mJ). Among the preceding, the AIGaInN semiconductor laser (commercially available InGaN-type semiconductor laser, 400 to 410 nm, 5 to 30 mW) is suitable from the perspectives of cost and wavelength characteristics.

With regard to the apparatus for photoexposing the lithographic printing plate precursor in the case of a scanning photoexposure regime, an internal drum configuration, external drum configuration, or flatbed configuration may be used for the photoexposure mechanism, and among the previously described light sources those capable of continuous oscillation are preferably used as the light source.

Other photoexposure light sources usable by the present invention can be exemplified by the various mercury lamps (ultrahigh pressure, high pressure, medium pressure, low pressure), chemical lamps, carbon arc lamps, xenon lamps, metal halide lamps, various types of visible and ultraviolet laser lamps, fluorescent lamps, tungsten lamps, sunlight, and so forth.

The development step will now be described. A conventional processing sequence proceeds as follows: removal of the protective layer by a water prewash process, then execution of base development, removal of the base by a water post-wash process, gumming in a gum application process, and drying in a drying process. In contrast to this, a characteristic feature of the present invention is that development and gumming are carried out at the same time by the use of an aqueous solution having a pH of 8.5 to 10.8 and containing a low molecular weight hydroxycarboxylic acid ion, a pH buffer, and a surfactant. In particular, the water post-wash process and the gum application process are therefore not required and the drying process can be carried out after development and gumming have been carried out with a single liquid in a single development bath. In addition, because removal of the protective layer can also be carried out at the same time as development and gumming, the water prewash process is also rendered unnecessary. In a preferred embodiment, development and gumming are followed by removal of excess processing liquid using, for example, a squeeze roller, and this is followed by drying.

The development step can be suitably executed by an automatic developer equipped with a rubbing member. Automatic developers can be exemplified by the automatic developers described in Japanese Patent Application Publication Nos. H2-220061 and S60-59351, in which the lithographic printing plate precursor is subjected after imagewise photoexposure to a rubbing treatment while undergoing transport, and the automatic developers described in U.S. Patent Nos. 5148746 and 5568768 and British Patent No. 2297719, in which after imagewise photoexposure lithographic printing plate precursor is mounted on a cylinder and a rubbing treatment is carried out while the cylinder is rotated. Among these, a particularly preferred automatic developer uses a rotating brush roll as the rubbing member.

The rotating brush roll used for the present invention can be selected as appropriate based on considerations of preventing damage to the image areas, the rigidity of the support in the lithographic printing plate precursor, and so forth. The rotating brush roll can be a known rotating brush roll in which brush elements are attached to a plastic or metal roll. Examples of usable rotating brush rolls are described in Japanese Patent Application Publication Nos. S58-159533 and H3-100554 and in Examined Utility Model Publication No. S62-167253, which describes a brush roll in which a metal or plastic channel-shaped member having brush elements implanted therein in a row configuration is wound without gaps and in a radiating manner on a core comprising a plastic or metal roll.

A plastic fiber (for example, a synthetic fiber of, for example, a polyester such as polyethylene terephthalate, polybutylene terephthalate, and so forth; a polyamide such as nylon 6.6, nylon 6.10, and so forth; a polyacrylic type such as polyacrylonitrile, poly(alkyl (meth)acrylate), and so forth; or a polyolefin such as polypropylene, polystyrene, and so forth) can be used as the brush element. For example, the diameter of the fiber bristle is suitably 20 to 400 µm and its length is suitably 5 to 30 mm.

The outer diameter of the rotating brush roll is preferably 30 to 200 mm and the peripheral velocity at the end of the brush that rubs the plate surface is preferably 0.1 to 5 m/sec. The use of a plurality of rotating brush rolls is preferred.

The direction of rotation of the rotating brush roll may be the same direction as the direction of transport of the lithographic printing plate precursor or may be the direction opposite from the direction of transport of the lithographic printing plate precursor. However, in a preferred embodiment for the use of at least two rotating brush rolls, at least one rotating brush roll rotates in the same direction and at least one rotating brush roll rotates in the opposite direction. This serves to provide an even more secure and reliable removal of the photosensitive layer in the nonimage areas. Rocking the rotating brush roll along the axis of rotation of the brush roll is also effective.

A continuous or noncontinuous drying step is preferably provided after the development step. Drying may be carried out using, for example, a hot wind, infrared radiation, near infrared radiation, and so forth.

An example of the structure of an automatic developer suitably used in the inventive method of producing a lithographic printing plate is shown schematically in Figure 1. The automatic developer in Figure 1 basically comprises a development section 6 and a drying section 10, wherein a lithographic printing plate precursor 4 is developed and gummed in a development tank 20 and drying is carried out in the drying section 10.

### The pH 8.5 to 10.8 aqueous solution containing low molecular weight hydroxycarboxylic acid ion, pH buffer, and surfactant

The aqueous solution used by the present invention is also referred to in the following as the treatment liquid or development liquid.

The low molecular weight hydroxycarboxylic acid ion employed in the development liquid used by the present invention is a low molecular weight compound that has a molecular weight no greater than 500 wherein the low molecular weight hydroxycarboxylic acid ion is an ion of a hydroxycarboxylic acid that has at least one carboxylic acid group and at least two hydroxyl groups. In order to bring about the presence in the development liquid of the low molecular weight hydroxycarboxylic acid ion, a low molecular weight hydroxycarboxylic acid may be added to the development liquid followed by adjustment of the pH, or the salt of a low molecular weight hydroxycarboxylic acid may be added to the development liquid. In the case of a low molecular weight hydroxycarboxylic acid that contains at least two carboxylic acid groups, it is sufficient for at least one of the carboxylic acid groups to assume ionic form in the aqueous solution.

The low molecular weight hydroxycarboxylic acid that is the precursor for the low molecular weight hydroxycarboxylic acid ion can be specifically exemplified by gluconic acid, (glycolic acid, lactic acid, tartronic acid, hydroxybutyric acids (e.g., 2-hydroxybutyric acid, 3-hydroxybutyric acid, and γ -hydroxybutyric acid), malic acid,)* tartaric acid, citramalic acid, citric acid, isocitric acid, leucic acid, mevalonic acid, pantoic acid, (ricinoleic acid, ricinelaidic acid, cerebronic acid, quinic acid, shikimic acid, monohydroxybenzoic acid derivatives (e.g., salicylic acid, creosotic acid (also known as homosalicylic acid and hydroxy(methyl)benzoic acid),)* vanillic acid, and syringic acid*), dihydroxybenzoic acid derivatives (e.g., pyrocatechuic acid, resorcylic acid, protocatechuic acid, gentisic acid, and orsellinic acid), trihydroxybenzoic acid derivatives (e.g., gallic acid), phenylacetic acid derivatives (e.g., mandelic acid, benzilic acid, and atrolactic acid*), and hydrocinnamic acid derivatives (e.g., melilotic acid*, phloretic acid*, coumaric acid*, umbellic acid, caffeic acid, ferulic acid*, and sinapic acid*). Preferred thereamong are low molecular weight hydroxycarboxylic acids that have at least two carboxylic acid groups, wherein the use of tartaric acid is particularly preferred. Compounds marked with a * are mentioned for reference only.

Compounds that have at least one carboxylic acid group and at least two hydroxyl groups are used as the low molecular weight hydroxycarboxylic acid according to the invention. Specific examples of such low molecular weight hydroxycarboxylic acids are gluconic acid, tartaric acid, mevalonic acid, pantoic acid, quinic acid, shikimic acid, dihydroxybenzoic acid derivatives, trihydroxybenzoic acid derivatives, umbellic acid, caffeic acid, dimethylolpropionic acid, and carminic acid. The use is preferred thereamong of gluconic acid, tartaric acid, mevalonic acid, shikimic acid, gallic acid, dimethylolpropionic acid, and carminic acid. The use is also preferred of low molecular weight hydroxycarboxylic acids that have at least four hydroxyl groups. Preferred examples thereof are gluconic acid and carminic acid.

There are no particular limitations on the low molecular weight hydroxycarboxylic acid salt, but the alkali metal salts are preferred. The alkali metal salts can be exemplified by lithium, sodium, and potassium, wherein sodium is particularly preferred. A single one of these may be used or two or more may be used in combination.

The quantity of addition of the low molecular weight hydroxycarboxylic acid ion to the development liquid is suitably 0.05 mol/L to 5 mol/L, wherein 0.2 mol/L to 2 mol/L is more preferred and 0.25 mol/L to 0.75 mol/L is most preferred. A satisfactory inhibition of fingerprint scumming is obtained when this quantity of addition is 0.05 mol/L or more. The use, on the other hand, of no more than 5 mol/L serves to inhibit the production of sediment and crystals and also inhibits gelation during neutralization during treatment of the waste effluent from the development liquid, thus avoiding problems with waste liquid treatment.

The development liquid used by the present invention also contains a pH buffer and a surfactant.

This pH buffer is a basic buffer and can be exemplified by (a) the carbonate ion and bicarbonate ion, (b) the borate ion, (c) a water-soluble amine compound and an ion of this amine compound, and combinations of the preceding. Thus, for example, (a) the carbonate ion/bicarbonate ion combination, (b) the borate ion, or (c) the combination of a water-soluble amine compound with an ion of this amine compound, develops a pH-buffering activity in the development liquid and can inhibit pH variations - even during long-term use of the development liquid - and can thereby inhibit pH variation-induced reductions in developability, the pH variation-induced generation of development scum, and so forth. The carbonate ion/bicarbonate ion combination is preferred.

In order to bring about the presence of the (a) carbonate ion and bicarbonate ion in the development liquid, a carbonate salt and bicarbonate salt may be added to the development liquid and, after the addition of the carbonate salt and bicarbonate salt, the carbonate ion and bicarbonate ion may be produced by adjusting the pH. There is no particular limitation on the carbonate salt and bicarbonate salt, but alkali metal salts are preferred. The alkali metal can be exemplified by lithium, sodium, and potassium, wherein sodium is particularly preferred. A single one of these may be used or two or more may be used in combination.

In order to bring about the presence of the (b) borate ion in the development liquid, boric acid or a borate salt is added to the development liquid followed by the generation of a suitable amount of borate ion achieved through adjustment of the pH using a base or a base and acid.

There are no particular limitations on the boric acid and borate salt used here; the boric acid can be exemplified by orthoboric acid, metaboric acid, and tetraboric acid, wherein orthoboric acid and tetraboric acid are preferred thereamong. The borate salt can be exemplified by alkali metal salts and alkaline-earth metal salts and by the orthoborate salts, diborate salts, metaborate salts, tetraborate salts, pentaborate salts, octaborate salts, and so forth, whereamong the orthoborate salts and tetraborate salts are preferred and the alkali metal salts of tetraboric acid are particularly preferred. Preferred tetraborate salts are sodium tetraborate, potassium tetraborate, and lithium tetraborate, whereamong sodium tetraborate is preferred. Two or more of these borate salts may be used in combination.

The boric acid or borate salt used in the present invention is particularly preferably orthoboric acid or tetraboric acid or sodium tetraborate. A boric acid and a borate salt may be used in combination in the development liquid.

The (c) ion of a water-soluble amine compound can be produced in an aqueous solution of the water-soluble amine compound: acid or base can be added to an aqueous solution of the water-soluble amine compound or a compound that is already the salt of the amine compound can be added to provide the ion in aqueous solution.

There are no particular limitations on the water-soluble amine compound, but a water-soluble amine compound that has a group that promotes water solubility is preferred. Groups that promote water solubility can be exemplified by the carboxylic acid group, sulfonic acid group, sulfinic acid group, phosphonic acid group, and the hydroxyl group. A plurality of these groups may be combined in the water-soluble amine compound.

The promotion of the water solubility of the amine compound by the carboxylic acid group, sulfonic acid group, sulfinic acid group, or phosphonic acid group corresponds to the use of an amino acid. Amino acids participate in an equilibrium in aqueous solution; this equilibrium is as shown below for the example of the use of the carboxylic acid group as the acid group. For the purposes of the present invention, the amino acid refers to state B while the amino acid ion refers to state C. The counterion in state C is preferably the sodium ion or the potassium ion.

### The amino acid equilibrium (acid group = carboxyl group)

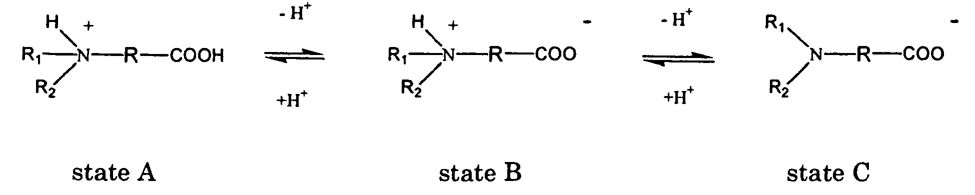

(For example, R₁ and R₂ each independently represent the hydrogen atom, alkyl, or aryl and R represents a linking group.)

The following are specific examples of water-soluble amine compounds that contain the carboxylic acid group, sulfonic acid group, or sulfinic acid group: amino acids such as glycine, iminodiacetic acid, lysine, threonine, serine, aspartic acid, para-hydroxyphenylglycine, dihydroxyethylglycine, alanine, anthranilic acid, tryptophan, and so forth; sulfamic acid; cyclohexylsulfamic acid; aliphatic amine sulfonic acids such as taurine and so forth; and aliphatic amine sulfinic acids such as aminoethanesulfinic acid and so forth. Glycine and iminodiacetic acid are preferred among the preceding.

The following are specific examples of water-soluble amine compounds that contain the phosphonic acid group (also including the phosphinic acid group): 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, ethylenediaminopentamethylenephosphonic acid, and so forth. 2-aminoethylphosphonic acid is particularly preferred.

The water-soluble amine compound that contains the hydroxyl group as the group promoting water solubility refers to an alkylamine that has the hydroxyl group in the alkyl moiety (state B below), while the corresponding ion refers to the ammonium ion originating from the amino group (state A below). 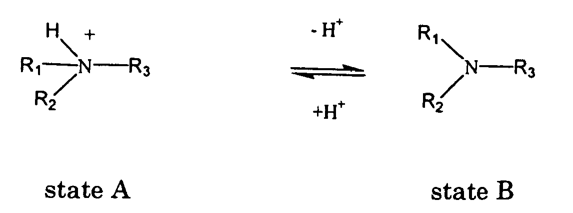 (For example, R₁, R₂, and R₃ each independently represent the hydrogen atom, alkyl, or aryl wherein at least one of these is hydroxyl-containing alkyl.)

Specific examples of hydroxyl-functional water-soluble amine compounds are monoethanolamine, diethanolamine, trimethanolamine, triethanolamine, tripropanolamine, triisopropanolamine, and so forth. Triethanolamine and diethanolamine are preferred among the preceding. The counterion for the ammonium ion is preferably the chlorine ion.

Bases that can be used to adjust the pH as described above can be exemplified by sodium hydroxide, potassium hydroxide, lithium hydroxide, sodium carbonate, potassium carbonate, ammonium carbonate, sodium bicarbonate, potassium bicarbonate, ammonium bicarbonate, organic bases, and combinations of the preceding. Inorganic acids can be used as the acid, for example, hydrochloric acid, sulfuric acid, nitric acid, and so forth. Fine adjustments in the pH can be made by the addition of this base or acid.

The pH of the development liquid used by the present invention is in the range of pH 8.5 to 10.8. A pH of at least 8.5 makes it possible to obtain good developability in the nonimage areas, while a pH no greater than 10.8 provides a resistance to the influence of atmospheric carbon dioxide and can inhibit the decline in processing capacity caused by the influence of carbon dioxide. The range of pH 8.8 to 10.2 is more preferred and the range of pH 9.0 to 10.0 is particularly preferred.

For the use as the pH buffer of the (a) carbonate ion and bicarbonate ion combination, the total quantity of the carbonate ion and bicarbonate ion is preferably 0.05 to 5 mol/L, more preferably 0.1 to 2 mol/L, and particularly preferably 0.2 to 1 mol/L, in each case with reference to the total mass of the aqueous solution. The developability and processing capacity do not decline when this total quantity is at least 0.05 mol/L. The use of 5 mol/L or less inhibits the production of precipitate and crystals and inhibits gelation during neutralization during treatment of the waste effluent from the development liquid, thus avoiding problems with waste liquid treatment.

A base, for example, an organic base, may also be used on an auxiliary basis with the goal of assisting very fine adjustments in the base concentration and assisting dissolution of the photosensitive layer in the nonimage areas. This organic base can be exemplified by monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide, and so forth. A single such base may be used or two or more may be used in combination.

For the use of the (b) borate ion as the pH buffer, the total quantity of the borate ion is preferably 0.05 to 5 mol/L, more preferably 0.1 to 2 mol/L, and particularly preferably 0.2 to 1 mol/L, in each case with reference to the total mass of the aqueous solution. The developability and processing capacity do not decline when the total quantity of borate salt is at least 0.05 mol/L. The use of 5 mol/L or less inhibits the production of precipitate and crystals and inhibits gelation during neutralization during treatment of the waste effluent from the development liquid, thus avoiding problems with waste liquid treatment.

For the use as the pH buffer of the (c) water-soluble amine compound and ion of the amine compound, the total quantity of the water-soluble amine compound and ion of the amine compound is preferably 0.01 to 1 mol/L with reference to the total mass of the aqueous solution. When the pH is in this range, the developability and processing capacity do not decline while the waste effluent is easily treated. The range of 0.03 to 0.7 mol/L is more preferred, while the range of 0.05 to 0.5 mol/L is particularly preferred.

The surfactant employed in the development liquid used by the present invention can be an anionic surfactant, nonionic surfactant, cationic surfactant, or amphoteric surfactant.

The anionic surfactant can be exemplified by fatty acid salts, abietic acid salts, hydroxyalkanesulfonic acid salts, alkanesulfonic acid salts, dialkyl sulfosuccinate salts, straight-chain alkylbenzenesulfonic acid salts, branched alkylbenzenesulfonic acid salts, alkylnaphthalenesulfonic acid salts, alkylphenoxy polyoxyethylenepropylsulfonic acid salts, polyoxyethylene alkylsulfophenyl ether salts, sodium N-methyl-N-oleyltaurate, N-alkylsulfosuccinic acid monoamide disodium salts, petroleum sulfonic acid salts, sulfated castor oil, sulfated beef tallow oil, salts of sulfate esters of alkyl esters of fatty acids, salts of alkyl sulfates, salts of sulfate esters of polyoxyethylene alkyl ethers, salts of sulfate esters of fatty acid monoglycerides, salts of sulfate esters of polyoxyethylene alkylphenyl ethers, salts of sulfate esters of polyoxyethylene styrylphenyl ethers, alkyl phosphate ester salts, salts of phosphate esters of polyoxyethylene alkyl ethers, salts of phosphate esters of polyoxyethylene alkylphenyl ethers, partially saponified styrene/maleic anhydride copolymers, partially saponified olefin/maleic anhydride copolymers, naphthalenesulfonate/formaldehyde condensates, the salts of aromatic sulfonic acids, aromatic-substituted polyoxyethylenesulfonate salts, and so forth. The use is particularly preferred among the preceding of dialkyl sulfosuccinate salts, salts of alkyl sulfates, and alkylnaphthalenesulfonic acid salts.

There are no particular limitations on the cationic surfactant and the heretofore known cationic surfactants may be used. Examples are alkylamine salts, quaternary ammonium salts, polyoxyethylenealkylamine salts, and derivatives of polyethylenepolyamines.

The nonionic surfactant can be exemplified by polyethylene glycol types such as higher alcohol/ethylene oxide adducts, alkylphenol/ethylene oxide adducts, the polyethylene glycol adducts of aromatic compounds, fatty acid/ethylene oxide adducts, the ethylene oxide adducts of polyhydric alcohol/fatty acid esters, the ethylene oxide adducts of higher alkylamines, the ethylene oxide adducts of fatty acid amides, the ethylene oxide adducts of fats and oils, the ethylene oxide adducts of polypropylene glycol, dimethylsiloxane-ethylene oxide block copolymers, dimethylsiloxane-(propylene oxide-ethylene oxide) block copolymers, and so forth, as well as polyhydric alcohol types such as fatty acid/glycerol esters, pentaerythritol/fatty acid esters, the fatty acid esters of sorbitol and sorbitan, the fatty acid esters of sucrose, alkyl ethers of polyhydric alcohols, the fatty acid amides of alkanolamines, and so forth.

The use of the following in the present invention is more preferred: polyethylene glycol types such as higher alcohol/ethylene oxide adducts, the polyethylene glycol adducts of aromatic compounds, the ethylene oxide adducts of the fatty acid esters of sorbitol and/or sorbitan, polypropylene glycol/ethylene oxide adducts, dimethylsiloxane-ethylene oxide block copolymers, dimethylsiloxane-(propylene oxide-ethylene oxide) block copolymers, and the fatty acid esters of polyhydric alcohols.

Viewed from the standpoint of a stable solubility or turbidity in water, the hydrophile-lipophile balance (HLB) for the nonionic surfactant preferably has a value of at least 6 and more preferably at least 8. Also similarly usable are such surfactants as the oxyethylene adducts of acetylene glycols, the oxyethylene adducts of acetylene alcohols, fluorine systems, and silicone systems.

A single surfactant may be used or a combination of surfactants may be used. The surfactant content in the development liquid is preferably 0.01 to 10 mass% and more preferably 0.01 to 5 mass%.

As is well known in the surfactant field, an amphoteric surfactant is a compound that has both an anionic moiety and a cationic moiety in the same molecule and encompasses amphoteric surfactants such as amino acids, betaines, amine oxides, and so forth. Compounds with the following formula < 1 > and compounds with the following formula < 2 > are preferred for the amphoteric surfactant employed in the development liquid used by the present invention.

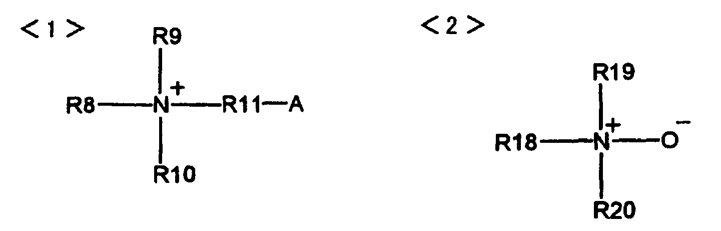

In formula < 1 >, R8 represents alkyl; R9 and R10 each represent the hydrogen atom or alkyl; R11 represents alkylene; and A represents a carboxylic acid ion or sulfonic acid ion.

In formula < 2 >, R18, R19, and R20 each represent the hydrogen atom or alkyl. However, R18, R19, and R20 may not all represent the hydrogen atom.

In formula < 1 >, the alkyl represented by R8, R9, and R10 and the alkylene represented by R11 may be straight chain or branched chain, may have a linking group in the chain, and may bear a substituent or substituents. Linking groups that contain a heteroatom are preferred, for example, the ester bond, amide bond, ether bond, and so forth. The substituent is preferably, for example, the hydroxyl group, ethylene oxide group, phenyl group, amide group, a halogen atom, and so forth.

The compound with formula < 1 > presents a large hydrophobic moiety at large values for the total number of carbons, which substantially impairs solubility in the aqueous development liquid. While this situation may be improved by the addition of a dissolution assistant, for example, an organic solvent such as an alcohol, dissolution of the surfactant may not be possible within an acceptable mixing range when the total number of carbons becomes excessively large. The sum total of the number of carbons in R8 to R11 is therefore preferably 8 to 25 and more preferably 11 to 21.

In formula < 2 >, the alkyl represented by R18, R19, and R20 may be straight chain or branched chain, may have a linking group in the chain, and may bear a substituent or substituents. Linking groups that contain a heteroatom are preferred, for example, the ester bond, amide bond, ether bond, and so forth. The substituent is preferably, for example, the hydroxyl group, ethylene oxide group, phenyl group, amide group, a halogen atom, and so forth.

The compound with formula < 2 > presents a large hydrophobic moiety at large values for the total number of carbons, which substantially impairs solubility in the aqueous development liquid. While this situation may be improved by the addition of a dissolution assistant, for example, an organic solvent such as an alcohol, dissolution of the surfactant may not be possible within an acceptable mixing range when the total number of carbons becomes excessively large. The sum total of the number of carbons in R18 to R20 is therefore preferably 8 to 22 and more preferably 10 to 20.

The total number of carbons in the amphoteric surfactant is affected by the material used in the photosensitive layer and in particular by the properties of the binder. In terms of the associated trends, a relatively lower total number of carbons is preferred when the binder has a higher hydrophilicity, while a larger value for the total number of carbons is preferred when the binder used has a lower hydrophilicity.

Preferred specific examples of amphoteric surfactants for use in the development liquid are provided below, but the present invention is not limited to these.

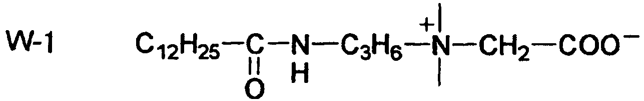

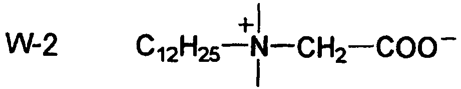

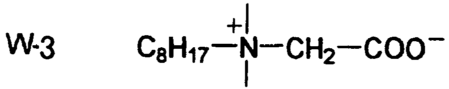

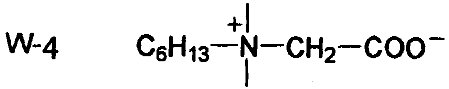

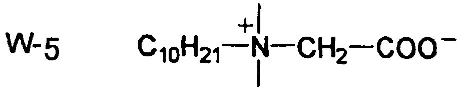

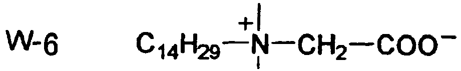

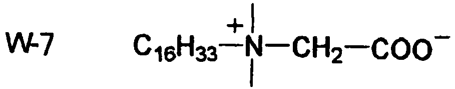

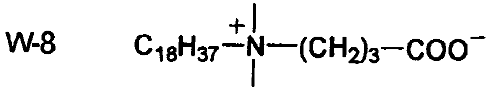

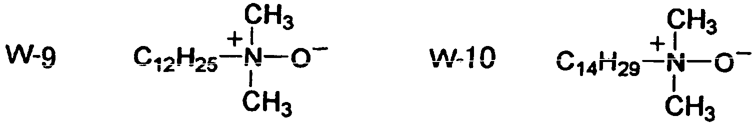

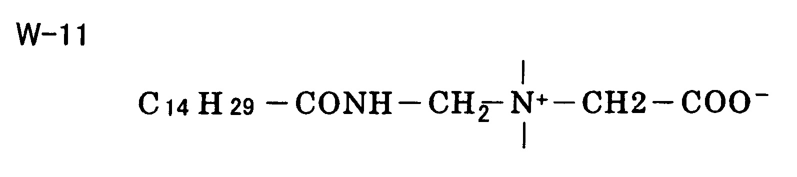

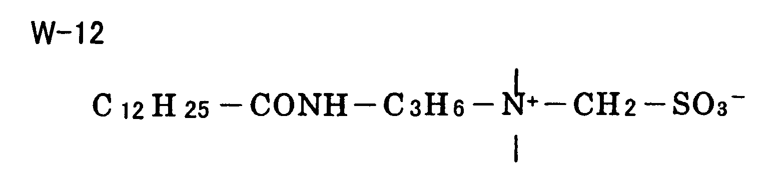

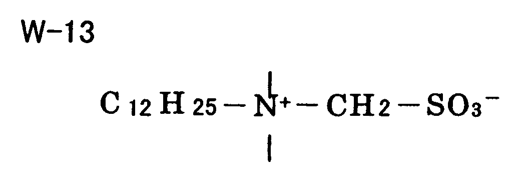

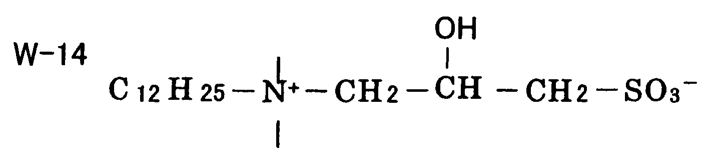

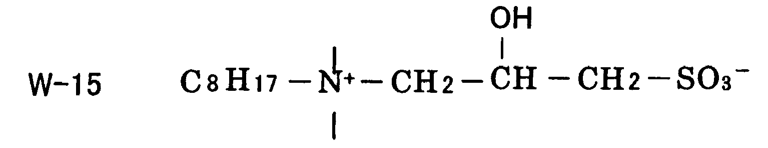

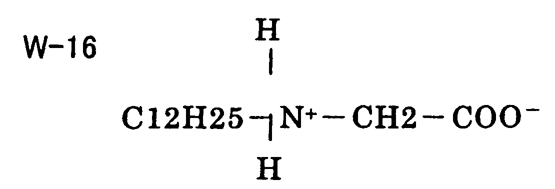

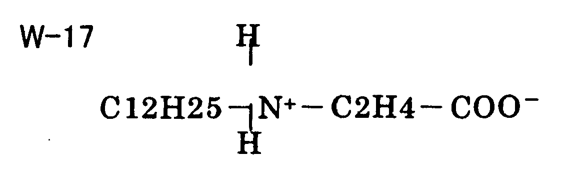

In addition to the preceding, the development liquid used by the present invention may contain, for example, a wetting agent, preservative, chelating compound, defoamer, organic solvent, inorganic acid, inorganic salt, water-soluble resin, and so forth.

Ethylene glycol, propylene glycol, triethylene glycol, butylene glycol, hexylene glycol, diethylene glycol, dipropylene glycol, glycerol, trimethylolpropane, diglycerol, and so forth, are suitably used as the wetting agent. A single one of these wetting agents may be used or two or more may be used in combination. The wetting agent is generally used in a quantity that is 0.1 to 5 mass% based on the total mass of the development liquid.

The following, inter alia, are preferably used as the preservative: phenol and derivatives thereof; formalin; imidazole derivatives; sodium dehydroacetate; 4-isothiazolin-3-one derivatives; benzoisothiazolin-3-one; 2-methyl-4-isothiazolin-3-one; benztriazole derivatives; amidine guanidine derivatives; quaternary ammonium salts; derivatives of pyridine, quinoline, guanidine, and so forth; diazine; triazole derivatives; oxazole; oxazine derivatives; and nitrobromo alcohol types such as 2-bromo-2-nitropropane-1,3-diol, 1,1-dibromo-1-nitro-2-ethanol, and 1,1-dibromo-1-nitro-2-propanol. The use of two or more preservatives in combination is preferred in order to provide efficacy against a variety of mold and bacteria. The preservative is added in a quantity that develops a stable efficacy against bacteria, mold, yeast, and so forth. While the quantity of preservative addition will also vary as a function of the species of bacteria, mold, and yeast, this quantity of addition is preferably 0.01 to 4 mass% with reference to the development liquid.

The chelating compound can be exemplified by ethylenediaminetetraacetic acid and its potassium and sodium salts; diethylenetriaminepentaacetic acid and its potassium and sodium salts; triethylenetetraminehexaacetic acid and its potassium and sodium salts; hydroxyethylethylenediaminetriacetic acid and its potassium and sodium salts; nitrilotriacetic acid and its sodium salt; and organophosphonic acids and phosphonoalkanetricarboxylic acids, e.g., 1-hydroxyethane-1,1-diphosphonic acid and its potassium and sodium salts, aminotri(methylenephosphonic acid) and its potassium and sodium salts, and so forth. In addition to the sodium and potassium salts, the salts of these chelating agents with organic amines are also effective. A chelating agent is selected that is stable in the processing liquid composition and that does not impair the printing characteristics. The quantity of addition is suitably 0.001 to 1.0 mass% with reference to the development liquid.

A silicone-based self-emulsifying type or emulsifying type or a nonionic compound with an HLB no greater than 5 can generally be used as the defoamer. Silicone defoamers are preferred, among which either an emulsion/dispersion type or a solubilizing type can be used. A defoamer content in the range of 0.001 to 1.0 mass% with reference to the development liquid is optimal.

The organic solvent can be exemplified by aliphatic hydrocarbons (e.g., hexane, heptane, "ISOPAR E, H, G" (from Esso Chemical Ltd.) or gasoline, kerosene, and so forth), aromatic hydrocarbons (e.g., toluene, xylene, and so forth), halogenated hydrocarbons (methylene dichloride, ethylene dichloride, triclene, monochlorobenzene, and so forth), and polar solvents.

The polar solvent can be exemplified by alcohols (e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, methylamyl alcohol, and so forth), ketones (e.g., acetone, methyl ethyl ketone, ethyl butyl ketone, methyl isobutyl ketone, cyclohexanone, and so forth), esters (e.g., ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate, and so forth), and others (triethyl phosphate, tricresyl phosphate, N-phenylethanolamine, N-phenyldiethanolamine, and so forth).

In those instances in which the aforementioned organic solvent is insoluble in water, it may still be used through solubilization in the water using, for example, a surfactant. When the development liquid does contain an organic solvent, the solvent concentration is desirably less than 40 mass% based on safety and flammability considerations.

The inorganic acid and inorganic salt can be exemplified by phosphoric acid, metaphosphoric acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium bisulfate, nickel sulfate, and so forth. The content of the inorganic salt is preferably 0.01 to 0.5 mass% based on the total mass of the development liquid.

Water-soluble resins that may be present in the development liquid used by the present invention can be exemplified by soy polysaccharides, modified starches, gum arabic, dextrin, cellulose derivatives (e.g., carboxymethyl cellulose, carboxyethyl cellulose, methyl cellulose, and so forth) and their modifications, pullulan, polyvinyl alcohol and derivatives thereof, polyvinylpyrrolidone, polyacrylamide and acrylamide copolymers, vinyl methyl ether/maleic anhydride copolymers, vinyl acetate/maleic anhydride copolymers, styrene/maleic anhydride copolymers, and so forth. The water-soluble resin preferably has an acid value of 0 to 3.0 meq/g.

Heretofore known soy polysaccharides can be used as the soy polysaccharide; an example here is the commercial product Soyafibe (Fuji Oil Co., Ltd.), and various grades may be used. Soy polysaccharide preferred for use has a viscosity for its 10 mass% aqueous solution of 10 to 100 mPa · sec.

The modified starch can be exemplified by modified starch with the following general formula (III). The starch represented by general formula (III) can be from, for example, corn, potato, tapioca, rice, wheat, and so forth. The modification of this starch can be carried out, for example, by degradation with acid or an enzyme to the range of 5 to 30 glucose residues per molecule and then adding oxypropylene in base.

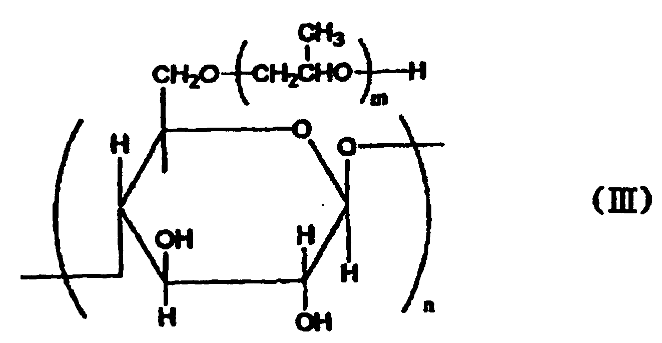

The degree of etherification (degree of substitution) in formula (III) is in the range of 0.05 to 1.2 per glucose unit while n is an integer from 3 to 30 and m is an integer from 1 to 3.

The modified starches and their derivatives can be exemplified by the following: roasted starches such as British gum; enzyme-modified dextrins such as enzymatically produced dextrin and Schardinger dextrin; oxidized starches represented by solubilized starch; pregelatinized starches such as modified pregelatinized starch and unmodified pregelatinized starch; esterified starches such as starch phosphate, fatty starch, starch sulfate, starch nitrate, starch xanthate, and starch carbamate; etherized starches such as carboxyalkyl starch, hydroxyalkyl starch, sulfoalkyl starch, cyanoethyl starch, allyl starch, benzyl starch, carbamylethyl starch, and dialkylamino starch; crosslinked starches such as methylol-crosslinked starch, hydroxyalkyl-crosslinked starch, phosphate-crosslinked starch, and dicarboxylic acid-crosslinked starch; and graft polymerized starches such as starch/polyacrylamide copolymers, starch/polyacrylic acid copolymers, starch/polyvinyl acetate copolymers, starch/polyacrylonitrile copolymers, cationic starch/polyacrylate ester copolymers, cationic starch/vinyl polymer copolymers, starch/polystyrene/maleic acid copolymers, starch/polyethylene oxide copolymers, and starch/polypropylene copolymers.

The following, inter alia, are preferred water-soluble resins: soy polysaccharides, modified starches, gum arabic, dextrin, carboxymethyl cellulose, and polyvinyl alcohol.

Two or more water-soluble resins can be used in combination. The water-soluble resin content in the processing liquid is preferably 0.1 to 20 mass% and more preferably is 0.5 to 10 mass%.

The development temperature is generally no higher than 60°C and preferably is about 15 to 40°C. Since the development liquid becomes exhausted in correspondence to the processing load during the development process using an automatic developer, the processing capacity may be restored using replenisher or using fresh processing liquid.

The entire surface may as necessary be heated at some point during the interval following photoexposure and up to development in the inventive method of producing a lithographic printing plate. This heating promotes the image-forming reactions in the image recording layer and accrues the advantages of improving the sensitivity and printing durability as well as stabilizing the sensitivity.

The heating conditions can be established as appropriate in the range in which the aforementioned effects occur. The heating means can be exemplified by conventional convection ovens, IR radiators, IR lasers, microwave devices, Wisconsin ovens, and so forth. For example, heating can be carried out by maintaining the temperature attained by the plate surface in the range of 70 to 150°C for from 1 second to 5 minutes. 80°C to 140°C for 5 minutes to 1 minute is preferred and 90°C to 130°C for 10 seconds to 30 seconds is more preferred. The previously described effects are efficiently obtained in these ranges, which are also preferred because they do not exhibit such negative effects as heat distortion of the printing plate.

The heat treatment means used for the heat treatment preferably comprises an automatic and continuous treatment in which the platesetter used in the photoexposure step is connected to the development apparatus used in the development processing step. A specific example is a platemaking line in which the development apparatus is connected with the platesetter by a transport means such as a conveyor. The heat treatment means may be inserted between the platesetter and the development apparatus, and the heating means and development apparatus may be integrated into a single device.

In those instances in which the lithographic printing plate precursor used is easily influenced by the ambient light in the working environment, the aforementioned platemaking line is preferably protected from light by, for example, a filter or cover.

In addition, after development the whole surface of the printing plate may be exposed to active light, for example, ultraviolet radiation, in order to promote curing in the image regions. The light source for this flood exposure can be exemplified by carbon arc lamps, mercury lamps, gallium lamps, metal halide lamps, xenon lamps, tungsten lamps, and various types of laser light. In order to obtain a satisfactory printing durability, the photoexposure dose is preferably at least 10 mJ/cm² and more preferably is at least 100 mJ/cm².

Heating may be performed at the same time as this flood exposure, and an additional improvement in the printing durability due to the heating will be recognized. The heating device can be exemplified by conventional convection ovens, IR radiators, IR lasers, microwave devices, Wisconsin ovens, and so forth. When this heating is in fact carried out, the plate temperature is preferably 30°C to 150°C, more preferably 35°C to 130°C, and even more preferably 40°C to 120°C. In specific terms, the method described in Japanese Patent Application Publication No. 2000-89478 can be used.

In addition, after development the printing plate can be very strongly heated with the goal of improving, inter alia, the printing durability. This heating temperature is generally in the range of 200°C to 500°C. Lower temperatures fail to provide a satisfactory image strengthening action, while higher temperatures risk problems such as a deterioration in the support and thermal degradation of the image regions.

The lithographic printing plate obtained in the described manner is mounted in an offset press and used to print a large number of copies.

### EXAMPLES

### < Examples 1 to 70 and Comparative Examples 1 to 10 >

### Preparation of the support

The following surface treatments were carried out on 0.03 mm-thick aluminum sheet (JIS A1050).

### (a) Mechanical surface roughening treatment

A mechanical surface roughening treatment was carried out using rotating roller-shaped nylon brushes; this was carried out while feeding a suspension of water and a polishing agent (pumice) with a specific gravity of 1.12 as a polishing slurry to the surface of the aluminum sheet. The average particle size in the polishing agent was 30 µm and the maximum particle size was 100 µm. The nylon brushes were nylon 6 · 10; the bristle length was 45 mm; and the bristle diameter was 0.3 mm. The bristles in the nylon brush were densely implanted in holes in a 300 mmφ stainless steel cylinder. Three rotating brushes were used. The gap between the two support rollers (200 mmφ) underneath a brush was 300 mm. The brush rollers were pressed down until the load on the drive motor rotating the brush reached +7 kW with respect to the load prior to the application of the brush roller to the aluminum sheet. The direction of brush rotation was the same as the transport direction of the aluminum sheet. The brushes were rotated at 200 rpm.

### (b) Alkali etching treatment

The aluminum sheet was etched by spraying with an aqueous solution (70°C) containing 2.6 mass% sodium hydroxide and 6.5 mass% aluminum ion. 10 g/m² of the aluminum sheet was dissolved. This was followed by a water rinse by spraying.

### (c) Desmutting

Desmutting was carried out by spraying with a 1 mass% aqueous nitric acid solution (contained 0.5 mass% aluminum ion) at 30°C; this was followed by a water rinse by spraying. The aqueous nitric acid solution used for desmutting was the waste effluent from the electrochemical surface roughening process, described below, that used alternating current in an aqueous nitric acid solution.

### (d) Electrochemical surface roughening process

Continuous electrochemical surface roughening was carried out using 60 Hz alternating-current voltage. The electrolyte solution was a 10.5 g/L aqueous nitric acid solution (contained 5 g/L aluminum ion and 0.007 mass% ammonium ion); the liquid temperature was 50°C. The electrochemical surface roughening was carried out using a trapezoidal square wave alternating current with a TP (time required for the current value to go from zero to the peak) of 0.8 msec and a duty ratio of 1 : 1 and using a carbon electrode as the counterelectrode. Ferrite was used as an auxiliary anode. A radial cell type was used for the electrolysis tank. The current density was 30 A/dm² at the current peak value, and the amount of electricity was 220 C/dm² as the sum of the amount of the electricity when the aluminum sheet was operating as an anode. 5% of the current flowing from the power source was branched to the auxiliary anode. This process was followed by a water rinse by spraying.

### (e) Alkali etch

Etching was carried out at 32°C by spraying the aluminum sheet with an aqueous solution that had a sodium hydroxide concentration of 26 mass% and an aluminum ion concentration of 6.5 mass%. 0.50 g/m² of the aluminum sheet was dissolved. This step removed the smut component, which consisted mainly of aluminum hydroxide produced during the electrochemical surface roughening treatment carried out in the preceding step using alternating current; this step also dissolved the edge region of the produced pits and thereby smoothed these edge regions. This step was followed by a water rinse by spraying.

### (f) Desmutting

Desmutting was carried out by spraying with a 30°C aqueous solution having a nitric acid concentration of 15 mass% (contained 4.5 mass% aluminum ion); this was followed by a water rinse by spraying. The aqueous nitric acid solution used for this desmutting was the waste effluent from the step of electrochemical surface roughening that used alternating current in aqueous nitric acid solution.

### (g) Electrochemical surface roughening treatment

Continuous electrochemical surface roughening was carried out using 60 Hz alternating-current voltage. The electrolyte solution was a 5.0 g/L aqueous hydrochloric acid solution (contained 5 g/L aluminum ion); the liquid temperature was 35°C. The electrochemical surface roughening was carried out using a trapezoidal square wave alternating current with a TP (time required for the current value to go from zero to the peak) of 0.8 msec and a duty ratio of 1 : 1 and using a carbon electrode as the counterelectrode. Ferrite was used as an auxiliary anode. The current density was 25 A/dm² at the current peak value, and the amount of electricity was 50 C/dm² as the sum of the amount of the electricity when the aluminum sheet was operating as an anode. This process was followed by a water rinse by spraying.

### (h) Anodic oxidation

An anodic oxidation treatment was carried out using an anodic oxidation apparatus operating according to a two-stage power feed electrolysis procedure (first and second electrolysis sections, length = 6 m each; first and second power feed sections, length = 3 m each; first and second feed electrode sections, length = 2.4 m each). The electrolyte bath supplied to the first and second electrolysis sections had a sulfuric acid concentration of 50 g/L (contained 0.5 mass% aluminum ion) in both cases, and the temperature was 20°C. This was followed by a water rinse by spraying. The final oxidation film weight was 2.7 g/m².

Aluminum sheet subjected to all of the preceding steps (a) to (h) was designated support 1; aluminum sheet subjected to only steps (d) to (h) was designated support 2; and aluminum sheet subjected to only steps (d) to (f) and (h) was designated as support 3. The center line average roughness (represents Ra according to JIS B0601) was measured using a stylus with a diameter of 2 µm with the following results: 0.52 µm for support 1; 0.28 µm for support 2; and 0.25 µm for support 3.

Each of supports 1 to 3 was dipped for 10 seconds in a 40°C aqueous solution containing 4 g/L polyvinylphosphonic acid, followed by rinsing for 2 seconds with 20°C tapwater and then drying to produce supports 4 to 6.

The undercoat fluid 1 described below was applied using a bar coater to each of supports 1 to 3 to provide a dry coating weight of 2 mg/m²; drying for 20 seconds at 80°C then yielded supports 7 to 9.

### Undercoat fluid 1

| | |
|---|---|
| polymer (SP1), see below | 0.3 g |
| pure water | 60.0 g |
| methanol | 939.7 g |

polymer (SP1) (weight-average molecular weight=50,000)

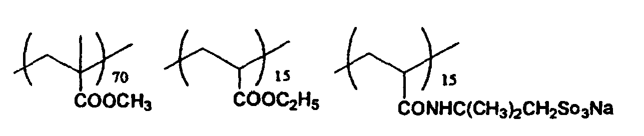

The undercoat fluid 2 described below was applied using a bar coater to each of supports 1 to 3 to provide a dry coating weight of 20 mg/m²; drying for 20 seconds at 80°C then yielded supports 10 to 12.

### Undercoat fluid 2

- the sol described below 200 g
- methanol 800 g

### sol

- Phosmer PE (Unichemical Co., Ltd.) 52 g
- methanol 44 g
- water 14 g
- 85 mass% phosphoric acid 11 g
- tetraethoxysilane 36 g
- 3-methaeryloxypropyltrimethoxysilane 12 g

The undercoat fluid 3 described below was applied using a bar coater to each of supports 1 to 3 to provide a dry coating weight of 2 mg/m²; drying for 20 seconds at 80°C then yielded supports 13 to 15.

### Undercoat fluid 3

| | |
|---|---|
| polymer (SP2), see below | 0.3 g |
| pure water | 60.0 g |
| methanol | 939.7 g |

polymer (SP2) (weight-average molecular weight=100,000)

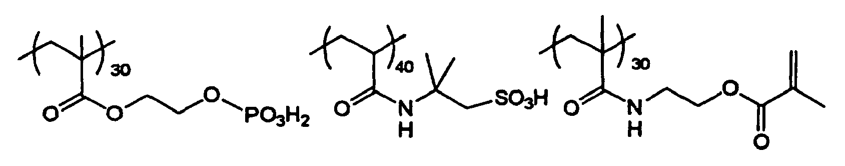

### Formation of the photosensitive layer

### < Photosensitive layer 1 >

Photosensitive layer 1 was formed by coating photosensitive layer coating fluid 1 (composition given below) on the support using a bar coater and then drying for 1 minute at 90°C. The dry coating weight for the photosensitive layer was 1.35 g/m².

### (Photosensitive layer coating fluid 1)

| | | |
|---|---|---|
| polymerizable compound, PLEX6661-O (Degussa) | | 1.69 mass parts |
| binder polymer PP-3 (see Table 1 above) | | 1.87 mass parts |
| | (molar ratio for copolymerized monomer a-1 : b-1 1-2 = 14 : 76 : 10, weight-average molecular weight = 90,000) | |
| sensitizing dye (D40), see above | | 0.13 mass part |
| polymerization initiator, infra | | 0.46 mass part |
| | (Kurogane Kasei Co., Ltd.) | |
| 25% MEK dispersion of | | 1.70 mass parts |
| | ε-phthalocyanine (F1), infra | |
| mercapto-functional heterocyclic | | 0.34 mass part |
| | compound (SH-8), see above | |
| Megaface F-780F nonionic fluorosurfactant | | 0.03 mass part |
| | (Dainippon Ink and Chemicals, Incorporated) | |
| Cupferron AL (10% tricresyl phosphate | | 0.12 mass part |
| | solution, Wako Pure Chemical Industries, Ltd.) | |
| methyl ethyl ketone | | 27.0 mass parts |
| propylene glycol monomethyl ether | | 26.7 mass parts |
| Novoperm Yellow H2G (Clariant) | | 0.20 mass part |
| | ε-phthalocyanine (F1) | |

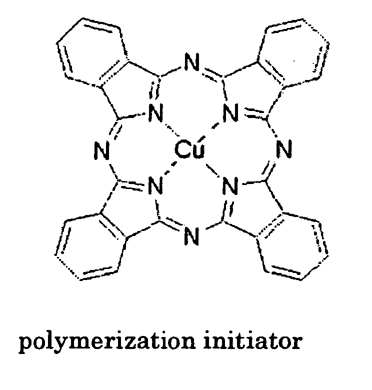

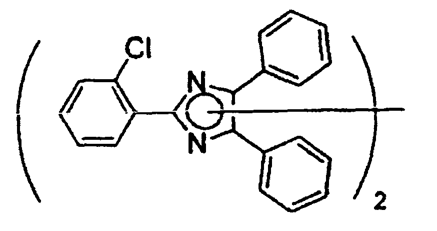

### < Photosensitive layer 2 >

Photosensitive layer 2 was formed by coating photosensitive layer coating fluid 2 (composition given below) on the support so as to provide a dry coating mass of 1.4 g/m² and then drying for 1 minute at 100°C.

### (Photosensitive layer coating fluid 2)

| | | |
|---|---|---|
| polymerizable compound (compound A) | | 4.0 mass parts |
| binder polymer (binder A, | | |
| | weight-average molecular weight: 47,000) | 2.0 mass parts |
| sensitizing dye (C-1), see below | | 0.32 mass part |
| polymerization initiator (D-1), see below | | 0.61 mass part |
| chain transfer agent (E-1) | | 0.57 mass part |
| N-nitrosophenylhydroxylamine, aluminum salt | | 0.020 mass part |
| ε-phthalocyanine pigment dispersion | | 0.71 mass part |
| | (pigment: 15 mass parts, dispersant: polymer (1) below | |
| | (weight-average molecular weight=30,000): 10 mass parts, solvent: cyclohexanone/methoxypropyl acetate/1-methoxy-2-propanol= 15 mass parts/20 mass parts/40 mass parts) | |
| Megaface F780 nonionic fluorosurfactant | | 0.016 mass part |
| | (Dainippon Ink and Chemicals, Incorporated) | |
| methyl ethyl ketone | | 47 mass parts |
| propylene glycol monomethyl ether | | 45 mass parts |

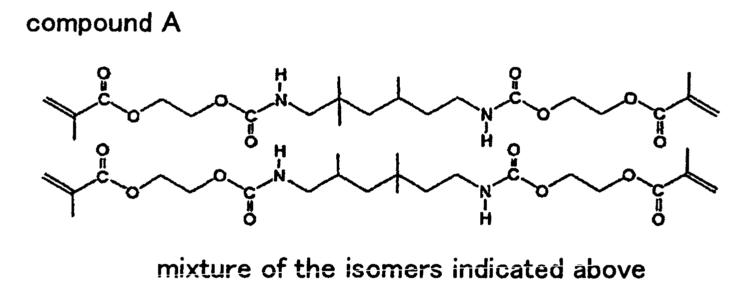

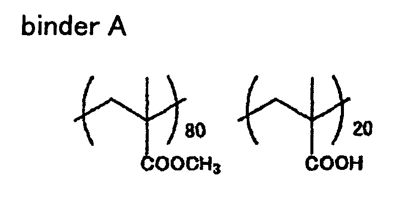

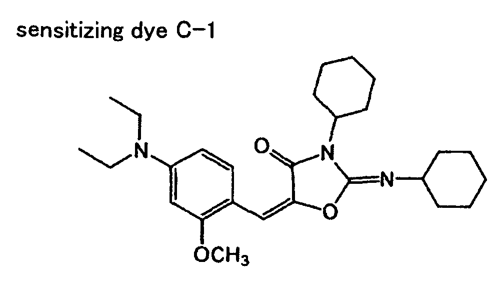

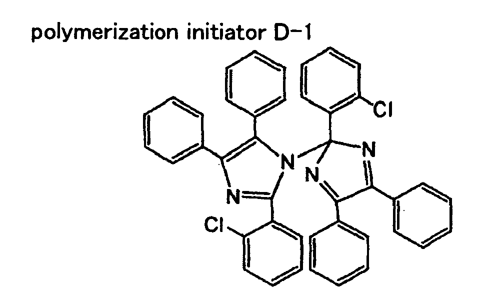

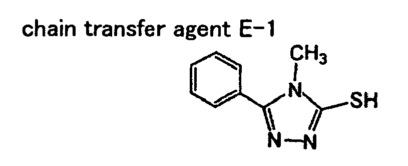

### < Photosensitive layer 3 >

A photosensitive layer with a dry coating weight of 1.3 g/m² was formed by bar coating photosensitive layer coating fluid 3 on the support and thereafter drying in an oven at 100°C for 44 seconds.

### (Photosensitive layer coating fluid 3)

| | | |
|---|---|---|
| binder polymer PU-A, see below | | 0.45 g |
| polymerizable compound (1), see below | | 0.52 g |
| | (PLEX 6661-O, Degussa Japan) | |
| sensitizing dye (1), see below | | 0.04 g |
| polymerization initiator (1), see below | | 0.08 g |
| co-sensitizer (1), see below | | 0.05 g |
| ε-phthalocyanine pigment dispersion | | 0.40 g |
| | (pigment: 15 mass parts, dispersant: polymer (1) below | |
| | (weight-average molecular weight=30,000): 10 mass parts, | |
| | solvent: cyclohexanone/methoxypropyl acetate/1-methoxy-2-propanol= | |
| | 15 mass parts/20 mass parts/40 mass parts) | |
| thermal polymerization inhibitor | | 0.006 g |
| | (N-nitrosophenylhydroxylamine, aluminum salt) | |
| fluorosurfactant (1), see below | | 0.002 g |
| | (weight-average molecular weight=10,000) | |
| 1-methoxy-2-propanol | | 8.0 g |
| methyl ethyl ketone | | 8.0 g |

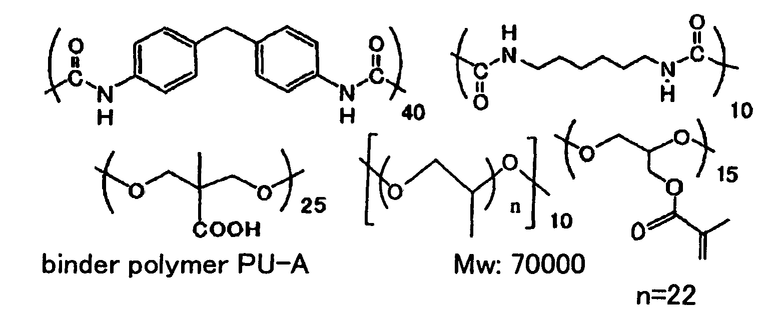

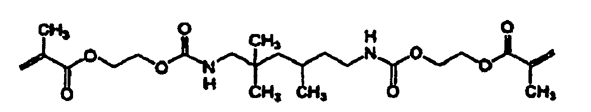

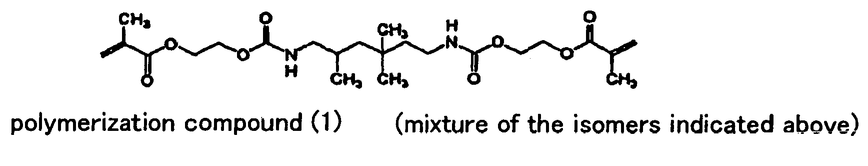

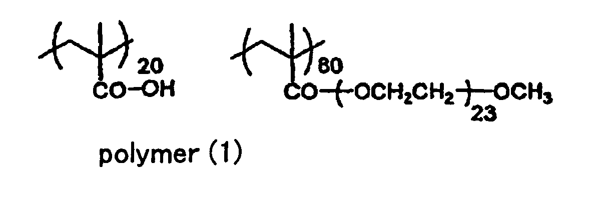

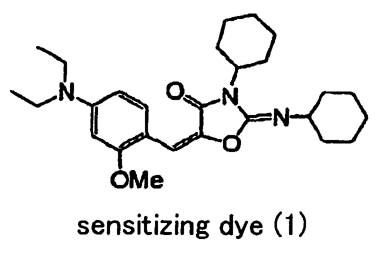

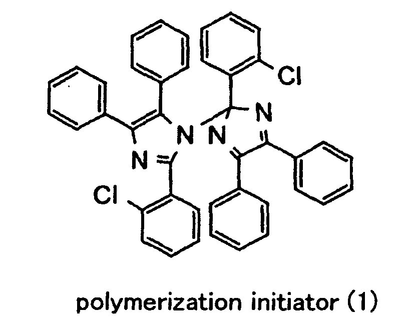

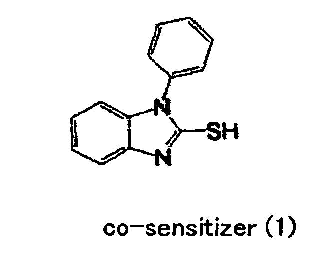

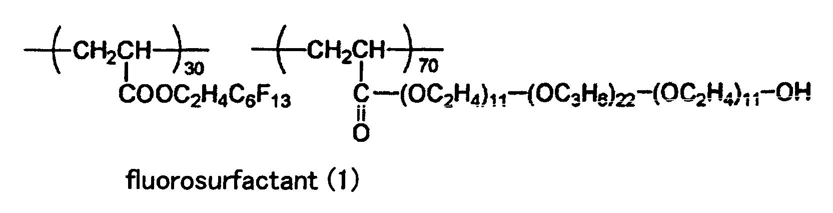

### < Photosensitive layer 4 >

A photosensitive layer 4 was formed by proceeding in the same manner as for the previously described photosensitive layer 1, but changing the sensitizing dye used in photosensitive layer coating fluid 1 to the sensitizing dye with the following structure.

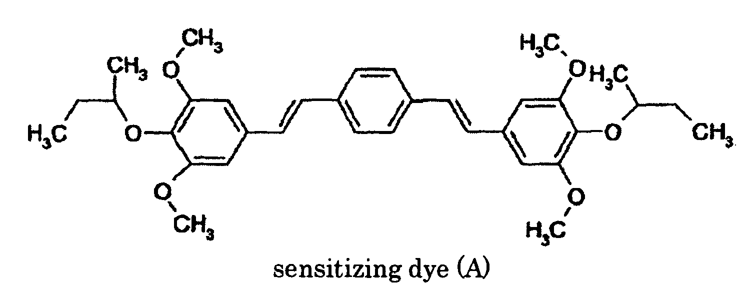

### < Photosensitive layer 5 >

A photosensitive layer 5 was formed by proceeding in the same manner as for the previously described photosensitive layer 1, but changing the sensitizing dye used in photosensitive layer coating fluid 1 to the sensitizing dye with the following structure.

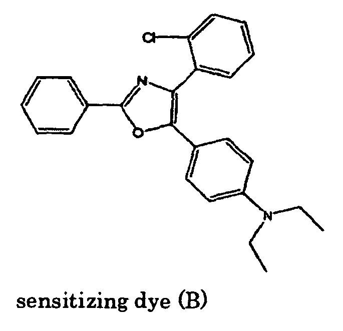

### Protective layer formation

### < Protective layer 1 >

A protective layer 1 was formed on the photosensitive layer by bar coater application of the protective layer coating fluid with the following composition so as to give a dry coating mass of 2.5 g/m², followed by drying for 1 minute at 120°C.

### (Protective layer coating fluid)

| | | |
|---|---|---|
| PVA105 (degree of saponification = 98 mol%, | | 1.80 mass parts |
| | Kuraray Co., Ltd.) | |
| polyvinylpyrrolidone (PVP K-30 from ISP (Japan) Ltd.) | | 0.40 mass part |
| EMALEX 710 (nonionic surfactant from | | 0.04 mass part |
| | Nihon Emulsion Co., Ltd.) | |
| Pionin D230 (surfactant from | | 0.05 mass part |
| | Takemoto Oil & Fat Co., Ltd.) | |
| Luviskol V64W (BASF) | | 0.06 mass part |
| 13% aqueous solution of the polymer | | 0.36 mass part |
| | indicated below | |
| pure water | | 36.0 mass parts |

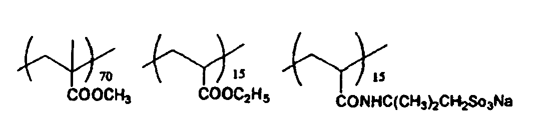

### < Protective layer 2 >

Protective layer 2 was formed in the same manner as for the formation of protective layer 1, but changing the PVA105 in protective layer 1 to Gohseran CKS-50 (from The Nippon Synthetic Chemical Industry Co., Ltd., degree of saponification: 99 mol%, average degree of polymerization: 300, degree of modification: approximately 0.4 mol%).

### < Protective layer 3 >

Protective layer 3 (dry coating weight = 2.45 g/m²) was formed on the photosensitive layer by the application with a wire bar of a 2 mass% mixed aqueous solution of 80 mass% polyvinyl alcohol (degree of saponification = 98 mol%, degree of polymerization = 500), 17 mass% polyvinylpyrrolidone (Luviskol K-30, BASF), 1.0 mass% of the fluorosurfactant described in the following table, and Pionin D230 surfactant (Takemoto Oil & Fat Co., Ltd.), followed by drying for 75 seconds at 125°C in a convection dryer.

### < Protective layer 4 >

A protective layer with a dry coating weight of 1.25 g/m² was formed on the photosensitive layer by bar coating the protective layer coating fluid with the composition described below followed by drying for 70 seconds at 125°C in an oven.

### (Protective layer coating fluid)

| | | |
|---|---|---|
| mica | dispersion, see below | 0.6 g |
| sulfonic | acid-modified polyvinyl alcohol | 0.8 g |
| | (Gohseran CKS-50, from The Nippon Synthetic Chemical Industry Co., Ltd., degree of saponification: 99 mol%, average degree of polymerization: 300, degree of modification: approximately 0.4 mol%) | |
| poly(vinylpyrrolidone/vinyl acetate (1/1)) | | 0.001 g |
| | (molecular weight: 70,000) | |
| surfactant (EMALEX 710, Nihon Emulsion Co., Ltd.) | | 0.002 g |
| water | | 13 g |

### (The mica dispersion)

32 g of a synthetic mica (Somasif ME-100, from Co-op Chemical Co., Ltd., aspect ratio at least 1000) was added to 368 g water and dispersion was carried out using an homogenizer until the average particle size (laser scattering procedure) reached 0.5 µm to yield the mica dispersion.

Various types of lithographic printing plate precursors were produced using the combinations of the aforementioned supports 4 to 15, photosensitive layers 1 to 5, and protective layers 1 to 4 shown in Tables 2 to 5 below.

### Photoexposure, development, and printing

Each of the aforementioned lithographic printing plate precursors was subjected to imagewise photoexposure using a violet semiconductor laser platesetter (Vx-9600 from FFEI, equipped with an InGaN-type semiconductor laser (emission wavelength 405 nm ± 10 nm/output 30 mW)). Imaging was carried out at a resolution of 2438 dpi using an FM screen (TAFFETA 20 from Fujifilm Corporation) and a light dose at the plate surface of 0.05 mJ/cm².

Then, after preheating for 30 seconds at 100°C, development processing was carried out using a processing liquid with the composition described below and using an automatic developer with a structure as shown in Figure 1. This automatic developer was provided with a 25 L development tank and one brush roll (outer diameter = 50 mm) that was implanted with polybutylene terephthalate fibers (bristle diameter = 200 µm, bristle length = 17 mm), which was rotated at 200 rpm in the same direction as the transport direction (peripheral velocity at the brush ends = 0.52 m/sec). The temperature of the processing liquid was 30°C. The lithographic printing plate precursor was transported at a transport velocity of 100 cm/min. Development processing was followed by drying in the drying section. The drying temperature was 80°C.

### < Processing liquid compositions > (The unit in the following is the gram (g) processing liquids marked with * are mentioned for reference only)

### • Processing liquid No. 1 (pH 9.7)*

| | | |
|---|---|---|
| water | | 9129.8 |
| sodium carbonate | | 130 |
| sodium bicarbonate | | 70 |
| Newcol B13 (nonionic surfactant, aromatic ethylene oxide adduct, | | 500 |
| | Nippon Nyukazai Co., Ltd.) | |
| primary ammonium phosphate | | 20 |
| 2-bromo-2-nitropropane-1,3-diol | | 0.1 |
| 2-methyl-4-isothiazolin-3-one | | 0.1 |
| trisodium citrate | | 150 |

### • Processing liquid No. 2 (pH 9.7)*

| | | |
|---|---|---|
| water | | 8813.8 |
| sodium carbonate | | 200 |
| sodium bicarbonate | | 100 |
| Newcol B4SN (61% aqueous solution) | | 656 |
| | (anionic surfactant, aromatic-substituted polyoxyethylene sulfonate salt Nippon Nyukazai Co., Ltd.) | |
| EDTA 4Na | | 80 |
| 2-bromo-2-nitropropane-1,3-diol | | 0.1 |
| 2-methyl-4-isothiazolin-3-one | | 0.1 |
| trisodium citrate | | 150 |

### • Processing liquid No. 3 (pH 9.7)*

| | | |
|---|---|---|
| water | | 8515 |
| potassium carbonate | | 150 |
| potassium bicarbonate | | 80 |
| Eleminol MON (47% aqueous solution) | | 745 |
| | (anionic surfactant, aromatic sulfonate salt, Sanyo Chamical Industries, Ltd.) | |
| primary ammonium phosphate | | 180 |
| sodium hexametaphosphate | | 180 |
| trisodium citrate | | 150 |

### • Processing liquid No. 4 (pH 9.5)*

| | | |
|---|---|---|
| water | | 8859.8 |
| sodium carbonate | | 200 |
| sodium bicarbonate | | 140 |
| Pionin D3110 | | 450 |
| | (nonionic surfactant, higher alkylamine ethylene oxide adduct Takemoto Oil & Fat Co., Ltd.) | |
| sodium citrate | | 100 |
| primary ammonium phosphate | | 20 |
| propylene glycol | | 80 |
| 2-bromo-2-nitropropane-1,3-diol | | 0.1 |
| 2-methyl-4-isothiazolin-3-one | | 0.1 |
| trisodium citrate | | 150 |

### • Processing liquid No. 5 (pH 9.8)*

| | | |
|---|---|---|
| water | | 8000.8 |
| sodium carbonate | | 200 |
| sodium bicarbonate | | 80 |
| Pelex NBL (35% aqueous solution) | | 1429 |
| | (anionic surfactant, alkylnaphthalenesulfonate salt, Kao Corporation) | |
| citric acid | | 40 |
| primary ammonium phosphate | | 20 |
| propylene glycol | | 80 |
| | 2-bromo-2-nitropropane-1,3-diol | 0.1 |
| | 2-methyl-4-isothiazolin-3-one | 0.1 |
| | trisodium citrate | 150 |

### • Processing liquid No. 6 (pH 9.5)*

| | | |
|---|---|---|
| water | | 8100 |
| sodium carbonate | | 160 |
| sodium bicarbonate | | 160 |
| Pionin C157K | | 1250 |
| | (amphoteric surfactant, Takemoto Oil & Fat Co., Ltd., 40% aqueous solution, W-2 in the Specification) | |
| sodium hexametaphosphate | | 180 |
| trisodium citrate | | 150 |

### • Processing liquid No. 7 (pH 9.4)*

| | | |
|---|---|---|
| water | | 6949.8 |
| sodium carbonate | | 130 |
| sodium bicarbonate | | 70 |
| Takesurf C-157-L | | 2500 |
| | (amphoteric surfactant, Takemoto Fat & Oil Co., Ltd., 30% aqueous solution, W-2 in the Specification) | |
| 2-bromo-2-nitropropane-1,3-diol | | 0.1 |
| 2-methyl-4-isothiazolin-3-one | | 0.1 |
| sodium citrate | | 150 |
| EDTA 4Na | | 50 |
| trisodium citrate | | 150 |

### • Processing liquid No. 8 (pH 8.5)*

| | |
|---|---|
| water | 9129.8 |
| sodium carbonate | 10 |
| sodium bicarbonate | 190 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 9 (pH 9.0)*

| | |
|---|---|
| water | 9129.8 |
| sodium carbonate | 20 |
| sodium bicarbonate | 180 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 10 (pH 9.4)*

| | |
|---|---|
| water | 9129.8 |
| sodium carbonate | 80 |
| sodium bicarbonate | 120 |
| Newcol B13 (nonionic surfactant, aromatic ethylene oxide adduct) Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 11 (pH 10.0)*

| | |
|---|---|
| water | 9129.8 |
| sodium carbonate | 150 |
| sodium bicarbonate | 50 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 12 (pH 10.5)*

| | |
|---|---|
| water | 9129.8 |
| sodium carbonate | 180 |
| sodium bicarbonate | 20 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-dial | 0.1 |
| 2-methyl-4-isothiazolin-3-one | 0.1 |
| trisodium citrate | 150 |

### • Processing liquid No. 13 (pH 9.7)*

| | |
|---|---|
| water | 9129.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| tripotassium citrate | 150 |

### • Processing liquid No. 14 (pH 9.7)*

| | |
|---|---|
| water | 9129.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| citric acid | 150 |

### • Processing liquid No. 15 (pH 9.7)

| | |
|---|---|
| water | 9129.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| disodium tartrate | 150 |

### • Processing liquid No. 16 (pH 9.7)*

| | |
|---|---|
| water | 9129.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitroprop ane-1,3-diol | 0.1 |
| 2-methyl-4-isothiazolin-3-one | 0.1 |
| disodium malate | 150 |

### • Processing liquid No. 17 (pH 9.7)

| | |
|---|---|
| water | 9129.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| sodium gluconate | 150 |

### • Processing liquid No. 18 (pH 9.7)*

| | |
|---|---|
| water | 9155.8 |
| boric acid | 115 |
| sodium hydroxide | 59 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 19 (pH 9.7)*

| | |
|---|---|
| water | 9232.4 |
| glycine | 75 |
| sodium hydroxide | 22.4 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Processing liquid No. 20 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 21 (pH 9.7)*

| | |
|---|---|
| water | 8263.8 |
| sodium carbonate | 200 |
| sodium bicarbonate | 100 |
| Newcol B4SN (61% aqueous solution) (anionic surfactant, aromatic-substituted polyoxyethylene sulfonate salt Nippon Nyukazai Co., Ltd.) | 656 |
| EDTA 4Na | 80 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 22 (pH 9.7)*

| | | |
|---|---|---|
| water | | 7965 |
| potassium carbonate | | 150 |
| potassium bicarbonate | | 80 |
| Eleminol MON (47% aqueous solution) | | 745 |
| | (anionic surfactant, aromatic sulfonate salt, Sanyo Chamical Industries, Ltd.) | |
| primary ammonium phosphate | | 180 |
| sodium hexametaphosphate | | 180 |
| trisodium citrate | | 150 |
| hydroxyalkylated starch (PENON JE66, Nippon Starch Chemical Co., Ltd.) | | 550 |

### • Processing liquid No. 23 (pH 9.5)*

| | | |
|---|---|---|
| water | | 8309.8 |
| sodium carbonate | | 200 |
| sodium bicarbonate | | 140 |
| Pionin D3110 | | 450 |
| | (nonionic surfactant, higher alkylamine ethylene oxide adduct Takamoto Oil & Fat Co., Ltd.) | |
| sodium citrate | | 100 |
| primary ammonium phosphate | | 20 |
| propylene glycol | | 80 |
| 2-bromo-2-nitropropane-1,3-diol | | 0.1 |
| 2-methyl-4-isothiazolin-3-one | | 0.1 |
| trisodium citrate | | 150 |
| hydroxyalkylated starch (PENON JE66, Nippon Starch Chemical Co., Ltd.) | | 550 |

### • Processing liquid No. 24 (pH 9.8)*

| | | |
|---|---|---|
| water | | 7450.8 |
| sodium carbonate | | 200 |
| sodium bicarbonate | | 80 |
| Pelex NBL (35% aqueous solution) | | 1429 |
| | (anionic surfactant, alkylnaphthalenesulfonate salt, Kao Corporation) | |
| citric acid | | 40 |
| primary ammonium phosphate | | 20 |
| propylene glycol | | 80 |
| 2-bromo-2-nitropropane-1,3-diol | | 0.1 |
| 2-methyl-4-isothiazolin-3-one | | 0.1 |
| trisodium citrate | | 150 |
| hydroxyalkylated starch (PENON JE66, Nippon Starch Chemical Co., Ltd.) | | 550 |

### • Processing liquid No. 25 (pH 9.5)*

| | | |
|---|---|---|
| water | | 7550 |
| sodium carbonate | | 160 |
| sodium bicarbonate | | 160 |
| Pionin C157K | | 1250 |
| | (amphoteric surfactant, Takemoto Oil & Fat Co., Ltd., 40% aqueous solution, | |
| | W-2 in the Specification) | |
| sodium hexametaphosphate | | 180 |
| trisodium citrate | | 150 |
| hydroxyalkylated starch (PENON JE66, Nippon Starch Chemical Co., Ltd.) | | 550 |

### • Processing liquid No. 26 (pH 9.4)*

| | | |
|---|---|---|
| water | | 6399.8 |
| sodium carbonate | | 130 |
| sodium bicarbonate | | 70 |
| Takesurf C-157-L | | 2500 |
| | (amphoteric surfactant, Takemoto Fat & Oil Co., Ltd., 30% aqueous solution, W-2 in the Specification) | |
| 2-bromo-2-nitropropane-1,3-diol | | 0.1 |
| 2-methyl-4-isothiazolin-3-one | | 0.1 |
| sodium citrate | | 150 |
| EDTA 4Na | | 50 |
| trisodium citrate | | 150 |
| hydroxyalkylated starch (PENON JE66, Nippon Starch Chemical Co., Ltd.) | | 550 |

### • Processing liquid No. 27 (pH 8.5)*

| | |
|---|---|
| water | 8579.8 |
| sodium carbonate | 10 |
| sodium bicarbonate | 190 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 28 (pH 9.0)*

| | |
|---|---|
| water | 8579.8 |
| sodium carbonate | 20 |
| sodium bicarbonate | 180 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 29 (pH 9.4)*

| | |
|---|---|
| water | 8579.8 |
| sodium carbonate | 80 |
| sodium bicarbonate | 120 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 30 (pH 10.0)*

| | |
|---|---|
| water | 8579.8 |
| sodium carbonate | 150 |
| sodium bicarbonate | 50 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 31 (pH 10.5)*

| | |
|---|---|
| water | 8579.8 |
| sodium carbonate | 180 |
| sodium bicarbonate | 20 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 32 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| tripotassium citrate | 150 |
| hydroxyalkylated starch (PENON JE66, Nippon Starch Chemical Co., Ltd.) | 550 |

### • Processing liquid No. 33 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| citric acid | 150 |
| hydroxyalkylated starch (PENON JE66, Nippon Starch Chemical Co., Ltd.) | 550 |

### • Processing liquid No. 34 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| disodium tartrate | 150 |
| hydroxyalkylated starch (PENON JE66, Nippon Starch Chemical Co., Ltd.) | 550 |

### • Processing liquid No. 35 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| disodium malate | 150 |
| hydroxyalkylated starch (PENON JE66, Nippon Starch Chemical Co., Ltd.) | 550 |

### • Processing liquid No. 36 (pH 9.7)*

| | |
|---|---|
| water | 8579.8 |
| sodium carbonate | 130 |
| sodium bicarbonate | 70 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| sodium gluconate | 150 |
| hydroxyalkylated starch (PENON JE66, Nippon Starch Chemical Co., Ltd.) | 550 |

### • Processing liquid No. 37 (pH 9.7)*

| | |
|---|---|
| water | 8605.8 |
| boric acid | 115 |
| sodium hydroxide | 59 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 38 (pH 9.7)*

| | |
|---|---|
| water | 8682.4 |
| glycine | 75 |
| sodium hydroxide | 22.4 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Processing liquid No. 39 (pH 9.8)

| | | |
|---|---|---|
| water | | 7839.8 |
| anhydrous sodium carbonate | | 100 |
| sodium bicarbonate | | 50 |
| Softazoline LPB-R | | 1860 |
| | (amphoteric surfactant, Kawaken Fine Chemicals Co., Ltd.) | |
| sodium gluconate | | 150 |
| 2-bromo-2-nitropropane-1,3-diol | | 0.1 |
| 2-methyl-4-isothiazolin-3-one | | 0.1 |

### • Processing liquid No. 40 (pH 9.8)

| | | | |
|---|---|---|---|
| water | | | 7619.8 |
| anhydrous sodium carbonate | | | 100 |
| sodium bicarbonate | | | 50 |
| Softazoline LPB-R | | | 1500 |
| Softazoline LAO | | | 360 |
| | (amphoteric surfactant, Kawaken Fine Chemicals Co., Ltd.) | | |
| sodium gluconate | | | 150 |
| TSA739 (from Toshiba Silicone) | | (as effective component solids) | 20 |
| EDDS (ethylenediamine disuccinate) | | (as effective component solids) | 200 |
| 2-bromo-2-nitropropane-1,3-diol | | | 0.1 |
| 2-methyl-4-isothiazolin-3-one | | | 0.1 |

### • Processing liquid No. 41 (pH 9.7)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium gluconate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |
| hydroxyalkylated starch (PENON JE66, Nippon Starch Chemical Co., Ltd.) | | 550 |

### • Processing liquid No. 42 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium shikimate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |

### • Processing liquid No. 43 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium gallate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |

### • Processing liquid No. 44 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium dimethylolpropionate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isathiazolin-3-one | | 0.1 |

### • Processing liquid No. 45 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium carminate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |

### • Processing liquid No. 46 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| sodium mevalonate | | 100 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |

### • Processing liquid No. 47 (pH 9.8)

| | | |
|---|---|---|
| water | | 7069.8 |
| anhydrous sodium carbonate | | 100 |
| sodium bicarbonate | | 50 |
| Softazoline LPB-R | | 1500 |
| Softazoline LAO | | 360 |
| potassium quinate | | 150 |
| TSA739 | (as effective component solids) | 20 |
| EDDS | (as effective component solids) | 200 |
| 2-bromo-2-nitropropane-1,3-diol | | 0.1 |
| 2-methyl-4-isothiazolin-3-one | | 0.1 |

### • Processing liquid No. 48 (pH 9.8)*

| | |
|---|---|
| water | 7839.8 |
| anhydrous sodium carbonate | 100 |
| sodium bicarbonate | 50 |
| Softazoline LPB-R | 1860 |
| sodium 2-hydroxybutyrate | 150 |
| 2-bromo-2-nitropropane-1,3-diol | 0.1 |
| 2-methyl-4-isothiazolin-3-one | 0.1 |

### • Processing liquid No. 49 (pH 9.8)

| | | |
|---|---|---|
| water | | 8769.8 |
| anhydrous sodium carbonate | | 100 |
| sodium bicarbonate | | 50 |
| Newcol B4SN (61% aqueous solution) | | 930 |
| | (anionic surfactant, Nippon Nyukazai Co., Ltd.) | |
| sodium gluconate | | 150 |
| 2-bromo-2-nitropropane-1,3-diol | | 0.1 |
| 2-methyl-4-isothiazolin-3-one | | 0.1 |

### • Comparative processing liquid 1 (pH 9.7)

| | |
|---|---|
| water | 9779.8 |
| sodium carbonate | 130 |
| sodium bicarbonate | 70 |
| primary ammonium phosphate | 20 |
| 2-bromo-2-nitropropane-1,3-diol | 0.1 |
| 2-methyl-4-isothiazolin-3-one | 0.1 |

### • Comparative processing liquid 2 (pH 8)

| | |
|---|---|
| water | 9129.8 |
| sodium bicarbonate | 200 |
| Newcol B13 (nonionic surfactant, aromatic ethylene oxide adduct Nippon Nyukazai Co., Ltd.) | 500 |
| primary ammonium phosphate | 20 |
| 2-bromo-2-nitroprop ane-1,3-diol | 0.1 |
| 2-methyl-4-isothiazolin-3-one | 0.1 |
| trisodium citrate | 150 |

### • Comparative processing liquid 3 (pH 11)

| | |
|---|---|
| water | 9129.8 |
| sodium carbonate | 200 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Comparative processing liquid 4 (pH 9.7)

| | |
|---|---|
| water | 9629.8 |
| sodium carbonate | 130 |
| sodium bicarbonate | 70 |
| primary ammonium phosphate | 20 |
| 2-bromo-2-nitropropane-1,3-diol | 0.1 |
| 2-methyl-4-isothiazolin-3-one | 0.1 |
| sodium acetate | 150 |

### • Comparative processing liquid 5 (pH 11.9)

| | |
|---|---|
| water | 9298.8 |
| potassium carbonate | 17 |
| KOH(48%) | 14 |
| Newcol B13 (nonionic surfactant, aromatic ethylene oxide adduct | 500 |

### Nippon Nyukazai Co., Ltd.)

| | |
|---|---|
| primary ammonium phosphate | 20 |
| 2-bromo-2-nitropropane-1,3-diol | 0.1 |
| 2-methyl-4-isothiazolin-3-one | 0.1 |
| trisodium citrate | 150 |

### • Comparative processing liquid 6 (pH 9.7)

| | |
|---|---|
| water | 9229.8 |
| sodium carbonate | 130 |
| sodium bicarbonate | 70 |
| primary ammonium phosphate | 20 |
| 2-bromo-2-nitropropane-1,3-diol | 0.1 |
| 2-methyl-4-isothiazolin-3-one | 0.1 |
| hydroxyalkylated starch (PENON JE66, Nippon Starch Chemical Co., Ltd.) 550 | |

### • Comparative processing liquid 7 (pH 8)

| | |
|---|---|
| water | 8729.8 |
| sodium bicarbonate | 200 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| hydroxyalkylated starch (PENON JE66, Nippon Starch Chemical Co., Ltd.) | 550 |

### • Comparative processing liquid 8 (pH 11)

| | |
|---|---|
| water | 8579.8 |
| sodium carbonate | 200 |
| Newcol B13 (nonionic surfactant, aromatic ethylene oxide adduct | 500 |
| Nippon Nyukazai Co., Ltd.) | |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

### • Comparative processing liquid 9 (pH 9.7)

| | |
|---|---|
| water | 9079.8 |
| sodium carbonate | 130 |
| sodium bicarbonate | 70 |
| primary ammonium phosphate | 20 |
| 2-bromo-2-nitropropane-1,3-diol | 0.1 |
| 2-methyl-4-isothiazolin-3-one | 0.1 |
| sodium acetate | 150 |
| hydroxyalkylated starch (PENON JE66, Nippon Starch Chemical Co., Ltd.) | 550 |

### • Comparative processing liquid 10 (pH 11.9)

| | |
|---|---|
| water | 8748.8 |
| potassium carbonate | 17 |
| KOH (48%) | 14 |
| Newcol B13 (nonionic surfactant, aromatic ethylene oxide adduct Nippon Nyukazai Co., Ltd.) | 500 |
| primary ammonium phosphate | 20 |
| 2-bromo-2-nitropropane-1,3-diol | 0.1 |
| 2-methyl-4-isothiazolin-3-one | 0.1 |
| trisodium citrate | 150 |
| hydroxyalkylated starch (PENON JE66, Nippon Starch Chemical Co., Ltd.) | 550 |

The resulting lithographic printing plate was mounted in a Heidelberg SOR-M press and printing was performed at a printing rate of 6000 impressions per hour using fountain solution (EU-3 (etching solution from Fujifilm Corporation)/water/isopropyl alcohol = 1/89/10 (volumetric ratio)) and TRANS-G(N) black ink (Dainippon Ink and Chemicals, Incorporated).

### Evaluations

The fingerprint scumming, scumming prevention, processability, coating uniformity of the plate surface, stickiness of the plate surface, and printing durability were evaluated as described below using the individual lithographic printing plate precursors.

### < Fingerprint scumming >

After development by the previously described procedure, the thumb was pressed for ten seconds against a nonimage area of the printing plate and this plate was then held for one day in a room temperature (25°C)/70% humidity environment without protecting the developed printing plate with, for example, a slip sheet. This plate was then used for printing and the presence/absence of print scumming in the thumb application region was evaluated.

| | |
|---|---|
| + + : | scumming does not occur, even when the holding period is extended to 3 days |
| + : | print scumming does not occur |
| Δ : | weak punctiform print scumming is seen, but within an acceptable range |
| × : | finger-shaped print scumming occurs |
| +/Δ : | between + and Δ |

### < Scumming prevention >

Printing was carried out using the particular lithographic printing plate and the conditions described above, and scumming of the blanket in the nonimage areas was visually evaluated after 10,000 impressions. A score of + was rendered when blanket scumming was not present; a score of Δ was rendered when almost no blanket scumming was present; and a score of × was rendered when blanket scumming had occurred.
+/Δ indicates a level in between + and Δ.

### < Processability >

500 m² of the particular lithographic printing plate precursor was developed over a 1 week period under the conditions described above, at which point the extent of production of scum adhering to the tank walls of the automatic developer was visually evaluated. The produced scum originates mainly with the binder in the protective layer.

A score of + was rendered when no scum was produced; a score of Δ was rendered when scum was produced, but the level thereof was still acceptable; and a score of × was rendered when scum production was significant.

### < Coating uniformity of the plate surface >

The coating conditions of the processing liquid on the plate surface were visually evaluated after development. As a relative comparison, a score of + was rendered in the case of uniform coating; a score of A was rendered when some coating unevenness was present, but the level thereof was still acceptable; a score of × was rendered when the coating unevenness was severe; and a score of +/Δ was rendered for a level in between + and Δ.

### < Stickiness of the plate surface >

The last plate from the previously described 500 m² development was contacted with a hand in order to compare the stickiness of the plate surface. As a relative comparison, a score of + was rendered for a smooth, dry result; a score of × was rendered for the presence of stickiness; and a score of Δ was rendered for an intermediate result.

### < Printing durability >

The image in the photosensitive layer formed on the lithographic printing plate gradually undergoes wear and the ink receptivity declines as the number of impressions increases, and this is therefore accompanied by a decline in the ink density of the image on the printed material. The printing durability (immediately after production) was therefore scored based on the number of impressions until the ink density (density by reflection) fell by 0.1 from that at the start of printing. In addition, the lithographic printing plate was held for one week after its production in a 25°C/60% humidity environment, after which printing was carried out under the conditions described above and the printing durability (after one week) was evaluated in the same manner. The results of the evaluations are shown in Tables 2 to 5.

Examples marked with * are reference examples.

**Table 2.**

| Example | support | photosensitive layer | protective layer | processing liquid | fingerprint scumming | scumming prevention | processability | coating uniformity | stickiness | printing durability (× 1000 impressions) | |
|---|---|---|---|---|---|---|---|---|---|---|---|
| | | | | | | | | | | immediately after production | after one week |
| 1 * | 5 | 1 | 2 | 1 | + | + | + | +/Δ | + | 50 | 45 |
| 2 * | 5 | 1 | 2 | 2 | + | + | + | +/Δ | + | 55 | 50 |
| 3 * | 5 | 1 | 2 | 3 | + | + | + | +/Δ | + | 50 | 50 |
| 4 * | 5 | 1 | 2 | 4 | + | + | + | +/Δ | + | 55 | 50 |
| 5 * | 5 | 1 | 2 | 5 | + | + | + | +/Δ | + | 50 | 45 |
| 6 * | 5 | 1 | 2 | 6 | + | + | + | +/Δ | + | 55 | 50 |
| 7 * | 5 | 1 | 2 | 7 | + | + | + | +/Δ | + | 50 | 50 |
| 8 * | 5 | 1 | 2 | 8 | + | Δ | + | +/Δ | + | 60 | 55 |
| 9 * | 5 | 1 | 2 | 9 | + | + | + | +/Δ | + | 55 | 50 |
| 10 * | 5 | 1 | 2 | 10 | + | + | + | +/Δ | + | 55 | 50 |
| 11 * | 5 | 1 | 2 | 11 | + | + | + | +/Δ | + | 55 | 50 |
| 12 * | 5 | 1 | 2 | 12 | + | + | + | +/Δ | + | 50 | 45 |
| 13 * | 5 | 1 | 2 | 13 | + | + | + | +/Δ | + | 55 | 50 |
| 14 * | 5 | 1 | 2 | 14 | + | + | + | +/Δ | + | 55 | 50 |
| 15 | 5 | 1 | 2 | 15 | +/Δ | + | + | +/Δ | + | 55 | 50 |
| 16 * | 5 | 1 | 2 | 16 | +/Δ | + | + | +/Δ | + | 55 | 50 |
| 17 | 5 | 1 | 2 | 17 | + | + | + | +/Δ | + | 55 | 50 |
| 18 * | 5 | 1 | 2 | 18 | + | Δ | + | +/Δ | + | 55 | 50 |
| 19 * | 5 | 1 | 2 | 19 | + | Δ | + | +/Δ | + | 55 | 50 |
| 20 * | 4 | 1 | 2 | 1 | + | + | + | +/Δ | + | 55 | 50 |
| 21 * | 6 | 1 | 2 | 1 | + | + | + | +/Δ | + | 50 | 45 |
| 22 * | 7 | 1 | 2 | 1 | + | + | + | +/Δ | + | 60 | 55 |
| 23 * | 8 | 1 | 2 | 1 | + | + | + | +/Δ | + | 55 | 50 |
| 24 * | 9 | 1 | 2 | 1 | + | + | + | +/Δ | + | 45 | 45 |
| 25 * | 10 | 1 | 2 | 1 | + | + | + | +/Δ | + | 65 | 55 |
| 26 * | 11 | 1 | 2 | 1 | + | + | + | +/Δ | + | 60 | 55 |
| 27 * | 12 | 1 | 2 | 1 | + | + | + | +/Δ | + | 50 | 45 |
| 28 * | 13 | 1 | 2 | 1 | + | + | + | +/Δ | + | 50 | 50 |
| 29 * | 14 | 1 | 2 | 1 | + | + | + | +/Δ | + | 55 | 55 |
| 30 * | 15 | 1 | 2 | 1 | + | + | + | +/Δ | + | 55 | 50 |
| 31 * | 5 | 1 | 1 | 1 | + | + | + | +/Δ | + | 50 | 50 |
| 32 * | 5 | 2 | 3 | 1 | + | + | + | +/Δ | + | 55 | 50 |
| 33 * | 5 | 3 | 4 | 1 | + | + | + | +/Δ | + | 55 | 55 |
| 34 * | 5 | 4 | 2 | 1 | + | + | + | +/Δ | + | 55 | 50 |
| 35 * | 5 | 5 | 2 | 1 | + | + | + | +/Δ | + | 50 | 45 |

**Table 3.**

| Example | support | photosensitive layer | protective layer | processing liquid | fingerprint scumming | scumming prevention | processability | coating uniformity | stickness | printing durability (× 1000 impressions) | |
|---|---|---|---|---|---|---|---|---|---|---|---|
| | | | | | | | | | | immediately after production | after one week |
| 36 * | 5 | 1 | 2 | 20 | + | + | + | + | + | 50 | 45 |
| 37 * | 5 | 1 | 2 | 21 | + | + | + | + | + | 55 | 50 |
| 38 * | 5 | 1 | 2 | 22 | + | + | + | + | + | 50 | 50 |
| 39 * | 5 | 1 | 2 | 23 | + | + | + | + | + | 55 | 50 |
| 40 * | 5 | 1 | 2 | 24 | + | + | + | + | + | 50 | 45 |
| 41 * | 5 | 1 | 2 | 25 | + | + | + | + | + | 55 | 50 |
| 42 * | 5 | 1 | 2 | 26 | + | + | + | + | + | 50 | 50 |
| 43 * | 5 | 1 | 2 | 27 | + | Δ | + | + | + | 60 | 55 |
| 44 * | 5 | 1 | 2 | 28 | + | + | + | + | + | 55 | 50 |
| 45 * | 5 | 1 | 2 | 29 | + | + | + | + | + | 55 | 50 |
| 46 * | 5 | 1 | 2 | 30 | + | + | + | + | + | 55 | 50 |
| 47 * | 5 | 1 | 2 | 31 | + | + | + | + | + | 50 | 45 |
| 48 * | 5 | 1 | 2 | 32 | + | + | + | + | + | 55 | 50 |
| 49 * | 5 | 1 | 2 | 33 | + | + | + | + | + | 55 | 50 |
| 50 * | 5 | 1 | 2 | 34 | +/Δ | + | + | + | + | 55 | 50 |
| 51 * | 5 | 1 | 2 | 35 | +/Δ | + | + | + | + | 55 | 50 |
| 52 * | 5 | 1 | 2 | 36 | Δ | + | + | + | + | 55 | 50 |
| 53 * | 5 | 1 | 2 | 37 | + | Δ | + | + | + | 55 | 50 |
| 54 * | 5 | 1 | 2 | 38 | + | Δ | + | + | + | 55 | 50 |
| 55 * | 4 | 1 | 2 | 20 | + | + | + | + | + | 55 | 50 |
| 56 * | 6 | 1 | 2 | 20 | + | + | + | + | + | 50 | 45 |
| 57 * | 7 | 1 | 2 | 20 | + | + | + | + | + | 60 | 55 |
| 58 * | 8 | 1 | 2 | 20 | + | + | + | + | + | 55 | 50 |
| 59 * | 9 | 1 | 2 | 20 | + | + | + | + | + | 45 | 45 |
| 60 * | 10 | 1 | 2 | 20 | + | + | + | + | + | 65 | 55 |
| 61 * | 11 | 1 | 2 | 20 | + | + | + | + | + | 60 | 55 |
| 62 * | 12 | 1 | 2 | 20 | + | + | + | + | + | 50 | 45 |
| 63 * | 13 | 1 | 2 | 20 | + | + | + | + | + | 50 | 50 |
| 64 * | 14 | 1 | 2 | 20 | + | + | + | + | + | 55 | 55 |
| 65 * | 15 | 1 | 2 | 20 | + | + | + | + | + | 55 | 50 |
| 66 * | 5 | 1 | 1 | 20 | + | + | + | + | + | 50 | 50 |
| 67 * | 5 | 2 | 3 | 20 | + | + | + | + | + | 55 | 50 |
| 68 * | 5 | 3 | 4 | 20 | + | + | + | + | + | 55 | 55 |
| 69 * | 5 | 4 | 2 | 20 | + | + | + | + | + | 55 | 50 |
| 70 * | 5 | 5 | 2 | 20 | + | + | + | + | + | 50 | 45 |

**Table 4.**

| Example | support | photosen sitive layer | protective layer | processing liquid | fingerprint scumming | scumming prevention | processability | coating uniformity | stickiness | printing durability (× 1000 impressions) | |
|---|---|---|---|---|---|---|---|---|---|---|---|
| | | | | | | | | | | immediately after production | after one Week |
| 71 | 5 | 1 | 2 | 39 | ++ | + | + | + | + | 55 | 50 |
| 72 | 5 | 1 | 2 | 40 | ++ | + | + | + | + | 55 | 50 |
| 73 | 5 | 1 | 2 | 41 | ++ | + | + | + | + | 55 | 50 |
| 74 | 5 | 1 | 2 | 42 | ++ | + | + | + | + | 55 | 50 |
| 75 | 5 | 1 | 2 | 43 | ++ | + | + | + | + | 50 | 50 |
| 76 | 5 | 1 | 2 | 44 | ++ | + | + | + | + | 55 | 50 |
| 77 | 5 | 1 | 2 | 45 | ++ | + | + | + | + | 50 | 50 |
| 78 | 5 | 1 | 2 | 46 | ++ | + | + | + | + | 50 | 50 |
| 79 | 5 | 1 | 2 | 47 | ++ | + | + | + | + | 50 | 50 |
| 80 * | 5 | 1 | 2 | 48 | Δ | + | + | + | + | 50 | 50 |
| 81 | 5 | 1 | 2 | 49 | + | + | + | + | + | 50 | 50 |

**Table 5.**

| Comparative Example | support | photosensitive layer | protective layer | processing liquid | fingerprint scumming | scumming prevention | processability | coating uniformity | stickiness | printing durability (× 1000 impressions) | |
|---|---|---|---|---|---|---|---|---|---|---|---|
| | | | | | | | | | | immediately after production | after one week |
| 1 | 5 | 1 | 2 | Comparative 1 | × | + | × | +/Δ | + | 55 | 50 |
| 2 | 5 | 1 | 2 | Comparative 2 | + | × | + | +/Δ | + | 60 | 55 |
| 3 | 5 | 1 | 2 | Comparative 3 | + | + | + | +Δ | + | 40 | 15 |
| 4 | 5 | 1 | 2 | Comparative 4 | × | + | Δ | +/Δ | + | 55 | 50 |
| 5 | 5 | 1 | 2 | Comparative 5 | + | + | Δ | +/Δ | × | 40 | 15 |
| 6 | 5 | 1 | 2 | Comparative 6 | × | + | × | + | + | 55 | 50 |
| 7 | 5 | 1 | 2 | Comparative 7 | + | × | + | + | + | 60 | 55 |
| 8 | 5 | 1 | 2 | Comparative 8 | + | + | + | + | + | 40 | 15 |
| 9 | 5 | 1 | 2 | Comparative 9 | × | + | Δ | + | + | 55 | 50 |
| 10 | 5 | 1 | 2 | Comparative 10 | + | + | Δ | + | × | 40 | 15 |

The results in Tables 2 to 5 show that the method of the present invention for producing a lithographic printing plate inhibits the production of fingerprint scumming, yields a scumming-free printed material, provides an excellent processability, and does not produce scum in the development tank. The inventive method is also free of problems with regard to the coating uniformity of the plate surface and plate surface stickiness and provides almost no decline in printing durability on the part of plates held after development.

## Claims

1. A method of producing a lithographic printing plate, comprising:
imagewise photoexposing a negative-working lithographic printing plate precursor that has an image-recording layer containing the (i), (ii), (iii), and (iv) described below on a hydrophilic support; and
treating thereafter the imagewise-photoexposed negative-working lithographic printing plate precursor with an aqueous solution that has a pH of 8.5 to 10.8 and that contains a low molecular weight hydroxycarboxylic acid ion having a molecular weight of no greater than 500, wherein the low molecular weight hydroxycarboxylic acid ion is an ion of a hydroxycarboxylic acid that has at least one carboxylic acid group and at least two hydroxyl groups, a basic pH buffer, and a surfactant:
(i) sensitizing dye
(ii) polymerization initiator
(iii) an addition-polymerizable compound that has an ethylenically unsaturated double bond
(iv) binder polymer.

2. The method of producing a lithographic printing plate according to claim 1, wherein the aqueous solution contains a water-soluble resin.

3. The method of producing a lithographic printing plate according to claim 1 or 2, wherein the low molecular weight hydroxycarboxylic acid ion is an ion of a hydroxycarboxylic acid that has at least two carboxylic acid groups.

4. The method of producing a lithographic printing plate according to any of claims 1 to 3, wherein the low molecular weight hydroxycarboxylic acid ion is a tartaric acid ion.

5. The method of producing a lithographic printing plate according to claim 1 or 2, wherein the low molecular weight hydroxycarboxylic acid ion is selected from the group of ions of gluconic acid, tartaric acid, mevalonic acid, pantoic acid, quinic acid, shikimic acid, umbellic acid, caffeic acid, dimethylolpropionic acid, carminic acid and gallic acid.

6. The method of producing a lithographic printing plate according to any of claims 1, 2, 3 and 5, wherein the low molecular weight hydroxycarboxylic acid ion is an ion of a hydroxycarboxylic acid that has at least four hydroxyl groups.

7. The method of producing a lithographic printing plate according to any of claims 1 to 6, wherein the surfactant contained in the aqueous solution is an amphoteric surfactant.

8. The method of producing a lithographic printing plate according to any of claims 1 to 7, wherein the pH buffer is at least one type selected from (a) a carbonate ion and a bicarbonate ion, (b) a borate ion, and (c) a water-soluble amine compound and an ion of this water-soluble amine compound.

9. The method of producing a lithographic printing plate according to any of claims 1 to 8, wherein the sensitizing dye (i) has an absorption maximum in the wavelength range of 350 nm to 450 nm.

10. The method of producing a lithographic printing plate according to any of claims 1 to 9, wherein the sensitizing dye (i) is a sensitizing dye represented by any of the following general formulas (1) to (5): 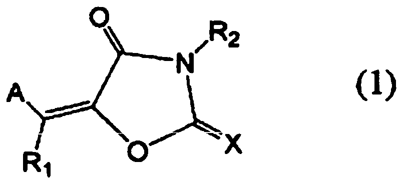 (in formula (1), A represents a possibly substituted aromatic ring or heterocycle; X represents an oxygen atom, sulfur atom, or N-(R₃); R₁, R₂, and R₃ each independently represent a monovalent nonmetal atomic group; A and R₁ may be bonded to each other to form an aliphatic or aromatic ring; and R₂ and R₃ may be bonded to each other to form an aliphatic or aromatic ring) 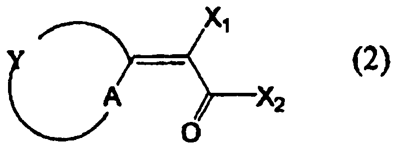 (in formula (2), A represents an S atom or NR₆; R₆ represents a monovalent nonmetal atomic group; Y represents a monovalent nonmetal atomic group that in combination with an adjacent A and an adjacent carbon atom forms the basic nucleus of a dye; X₁ and X₂ each independently represent a monovalent nonmetal atomic group; and X₁ and X₂ may be bonded to each other to form the acidic nucleus of the dye) 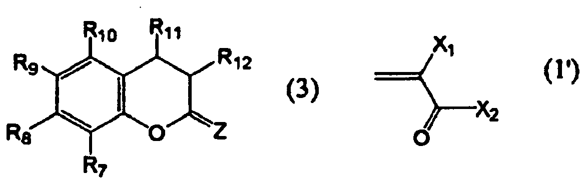 (in formula (3), = Z represents an oxo group, thioxo group, imino group, or the alkylidene group represented by the substructural formula (1') given above; X₁ and X₂ are defined as in general formula (2); and R₇ to R₁₂ each independently represent a monovalent nonmetal atomic group) 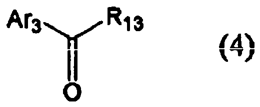 (in formula (4), Ar₃ represents a possibly substituted aromatic group or heteroaromatic group and R₁₃ represents a monovalent nonmetal atomic group, wherein R₁₃ is preferably an aromatic group or a heteroaromatic group and Ar₃ and R₁₃ may be bonded to each other to form a ring) 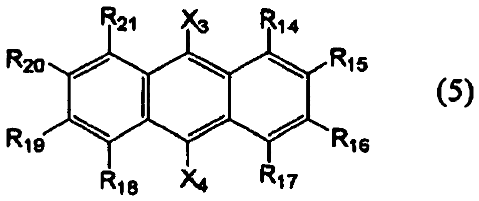 (in formula (5), X₃, X₄, and R₁₄ to R₂₁ each independently represent a monovalent nonmetal atomic group wherein X₃ and X₄ are preferably electron-donating groups that have a negative Hammett substituent constant).

11. The method of producing a lithographic printing plate according to any of claims 1 to 10, wherein the binder polymer (iv) has an acid group in side chain position.

12. The method of producing a lithographic printing plate according to claim 11, wherein the acid group is the carboxylic acid group.

13. The method of producing a lithographic printing plate according to any of claims 1 to 12, wherein the lithographic printing plate precursor has a protective layer on the image-recording layer.

14. The method of producing a lithographic printing plate according to any of claims 1 to 13, which is carried out by a single liquid process using the aqueous solution.

15. A lithographic printing plate obtained by the production method according to any of claims 1 to 14.

## Patentansprüche

1. Verfahren zum Herstellen einer lithografischen Druckplatte, umfassend:
das bildweise Belichten einer negativ arbeitenden lithografischen Druckplattenvorstufe, welche eine Bildaufzeichnungsschicht, die die nachstehend beschriebenen (i), (ii), (iii) und (iv) enthält, auf einem hydrophilen Träger aufweist; und
danach das Behandeln der bildweise belichteten negativ arbeitenden lithografischen Druckplattenvorstufe mit einer wässrigen Lösung, welche einen pH von 8,5 bis 10,8 aufweist und welche ein Ion einer Hydroxycarbonsäure mit niedrigem Molekulargewicht, das ein Molekulargewicht von nicht mehr als 500 aufweist, wobei das Ion einer Hydroxycarbonsäure mit niedrigem Molekulargewicht ein Ion von einer Hydroxycarbonsäure ist, welche wenigstens eine Carbonsäuregruppe und wenigstens zwei Hydroxylgruppen aufweist,
einen basischen pH-Puffer und eine oberflächenaktive Substanz enthält:
(i) einen Sensibilisierungsfarbstoff
(ii) einen Polymerisationsinitiator
(iii) eine Additions-polymerisierbare Verbindung, welche eine ethylenisch ungesättigte Doppelbindung aufweist
(iv) ein Bindemittelpolymer.

2. Verfahren zum Herstellen einer lithografischen Druckplatte nach Anspruch 1, wobei die wässrige Lösung ein wasserlösliches Harz enthält.

3. Verfahren zum Herstellen einer lithografischen Druckplatte nach Anspruch 1 oder 2, wobei das Ion einer Hydroxycarbonsäure mit niedrigem Molekulargewicht ein Ion von einer Hydroxycarbonsäure ist, welche wenigstens zwei Carbonsäuregruppen aufweist.

4. Verfahren zum Herstellen einer lithografischen Druckplatte nach einem der Ansprüche 1 bis 3, wobei das Ion einer Hydroxycarbonsäure mit niedrigem Molekulargewicht ein Weinsäureion ist.

5. Verfahren zum Herstellen einer lithografischen Druckplatte nach Anspruch 1 oder 2, wobei das Ion einer Hydroxycarbonsäure mit niedrigem Molekulargewicht ausgewählt ist aus der Gruppe von Ionen von Gluconsäure, Weinsäure, Mevalonsäure, Pantoinsäure, Chinasäure, Shikimisäure, Umbellsäure, Kaffeesäure, Dimethylolpropionsäure, Carminsäure und Gallussäure.

6. Verfahren zum Herstellen einer lithografischen Druckplatte nach einem der Ansprüche 1, 2, 3 und 5, wobei das Ion einer Hydroxycarbonsäure mit niedrigem Molekulargewicht ein Ion von einer Hydroxycarbonsäure ist, welche wenigstens vier Hydroxylgruppen aufweist.

7. Verfahren zum Herstellen einer lithografischen Druckplatte nach einem der Ansprüche 1 bis 6, wobei die in der wässrigen Lösung enthaltene oberflächenaktive Substanz eine amphotere oberflächenaktive Substanz ist.

8. Verfahren zum Herstellen einer lithografischen Druckplatte nach einem der Ansprüche 1 bis 7, wobei der pH-Puffer wenigstens eine Art ist, ausgewählt aus (a) einem Carbonation und einem Hydrogencarbonation, (b) einem Boration, und (c) einer wasserlöslichen Aminverbindung und einem Ion von dieser wasserlöslichen Aminverbindung.

9. Verfahren zum Herstellen einer lithografischen Druckplatte nach einem der Ansprüche 1 bis 8, wobei der Sensibilisierungsfarbstoff (i) ein Absorptionsmaximum im Wellenlängenbereich von 350 nm bis 450 nm aufweist.

10. Verfahren zum Herstellen einer lithografischen Druckplatte nach einem der Ansprüche 1 bis 9, wobei der Sensibilisierungsfarbstoff (i) ein Sensibilisierungsfarbstoff ist, der durch beliebige der folgenden allgemeinen Formeln (1) bis (5) wiedergegeben ist: 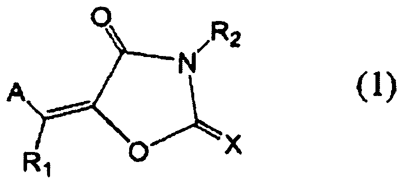 (in Formel (1) bedeutet A einen möglicherweise substituierten aromatischen Ring oder Heterocyclus; X bedeutet ein Sauerstoffatom, Schwefelatom oder N-(R₃); R₁, R₂ und R₃ bedeuten jeweils unabhängig eine einwertige Nichtmetallatomgruppe; A und R₁ können aneinander gebunden sein unter Bildung eines aliphatischen oder aromatischen Rings; und R₂ und R₃ können aneinander gebunden sein unter Bildung eines aliphatischen oder aromatischen Rings) 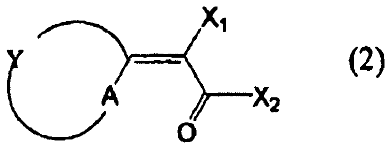 (in Formel (2) bedeutet A ein S-Atom oder NR₆; R₆ bedeutet eine einwertige Nichtmetallatomgruppe; Y bedeutet eine einwertige Nichtmetallatomgruppe, welche in Kombination mit einem benachbarten A und einem benachbarten Kohlenstoffatom den basischen Kern eines Farbstoffs bildet; X₁ und X₂ bedeuten jeweils unabhängig eine einwertige Nichtmetallatomgruppe; und X₁ und X₂ können aneinander gebunden sein unter Bildung des sauren Kerns des Farbstoffs) 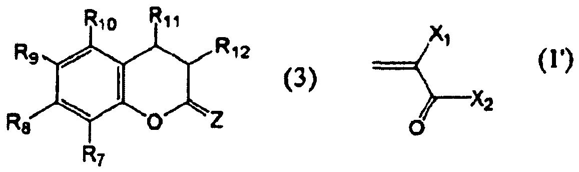 (in Formel (3) bedeutet =Z eine Oxogruppe, Thioxogruppe, Iminogruppe oder die durch die vorstehend angegebene Substrukturformel (1') wiedergegebene Alkylidengruppe; X₁ und X₂ sind wie in der allgemeinen Formel (2) definiert; und R₇ bis R₁₂ bedeuten jeweils unabhängig eine einwertige Nichtmetallatomgruppe) 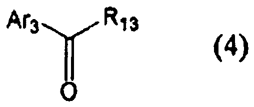 (in Formel (4) bedeutet Ar₃ eine möglicherweise substituierte aromatische Gruppe oder heteroaromatische Gruppe und R₁₃ bedeutet eine einwertige Nichtmetallatomgruppe, wobei R₁₃ vorzugsweise eine aromatische Gruppe oder eine heteroaromatische Gruppe ist und Ar₃ und R₁₃ aneinander gebunden sein können unter Bildung eines Rings) 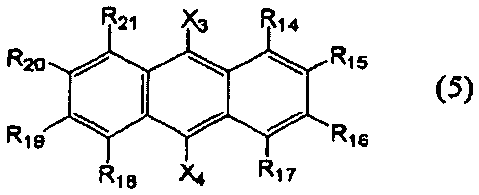 (in Formel (5) bedeuten X₃, X₄ und R₁₄ bis R₂₁ jeweils unabhängig eine einwertige Nichtmetallatomgruppe, wobei X₃ und X₄ vorzugsweise elektronenabgebende Gruppen sind, die eine negative Hammett-Substituentenkonstante aufweisen).

11. Verfahren zum Herstellen einer lithografischen Druckplatte nach einem der Ansprüche 1 bis 10, wobei das Bindemittelpolymer (iv) eine Säuregruppe in Seitenkettenstellung aufweist.

12. Verfahren zum Herstellen einer lithografischen Druckplatte nach Anspruch 11, wobei die Säuregruppe die Carbonsäuregruppe ist.

13. Verfahren zum Herstellen einer lithografischen Druckplatte nach einem der Ansprüche 1 bis 12, wobei die lithografische Druckplattenvorstufe eine Schutzschicht auf der Bildaufzeichnungsschicht aufweist.

14. Verfahren zum Herstellen einer lithografischen Druckplatte nach einem der Ansprüche 1 bis 13, welches durch einen Prozess in einer einzigen Flüssigkeit (single liquid process) ausgeführt wird, bei dem die wässrige Lösung verwendet wird.

15. Lithografische Druckplatte erhalten durch das Herstellungsverfahren nach einem der Ansprüche 1 bis 14.

## Revendications

1. Procédé de fabrication d'une plaque d'impression lithographique, comprenant :
la photoexposition, conformément à une image, d'un précurseur de plaque d'impression lithographique négative qui comporte une couche d'enregistrement d'image contenant les (i), (ii), (iii), et (iv) décrits ci-dessous sur un support hydrophile ; et
le traitement ultérieur du précurseur de plaque d'impression lithographique négative ainsi exposé conformément à une image, avec une solution aqueuse qui a un pH de 8,5 à 10,8 et qui contient un ion d'acide hydroxycarboxylique de faible masse moléculaire dont la masse moléculaire ne dépasse pas 500, cet ion d'acide hydroxycarboxylique de faible masse moléculaire étant un ion d'un acide hydroxycarboxylique qui possède au moins un groupe acide carboxylique et au moins deux groupes hydroxyle, un tampon à pH basique, et un tensioactif :
(i) colorant sensibilisateur
(ii) initiateur de polymérisation
(iii) un composé polymérisable par addition qui possède une double liaison éthyléniquement insaturée
(iv) liant polymère.

2. Procédé de fabrication d'une plaque d'impression lithographique selon la revendication 1, dans lequel la solution aqueuse contient une résine hydrosoluble.

3. Procédé de fabrication d'une plaque d'impression lithographique selon la revendication 1 ou 2, dans lequel l'ion d'acide hydroxycarboxylique de faible masse moléculaire est un ion d'un acide hydroxycarboxylique qui possède au moins deux groupes acide carboxylique.

4. Procédé de fabrication d'une plaque d'impression lithographique selon n'importe lesquelles des revendications 1 à 3, dans lequel l'ion d'acide hydroxycarboxylique de faible masse moléculaire est un ion d'acide tartrique.

5. Procédé de fabrication d'une plaque d'impression lithographique selon la revendication 1 ou 2, dans lequel l'ion d'acide hydroxycarboxylique de faible masse moléculaire est choisi dans le groupe d'ions constitué des ions d'acide gluconique, d'acide tartrique, d'acide mévalonique, l'acide pantoïque, d'acide quinique, d'acide shikimique, d'acide ombellique, d'acide caféique, d'acide diméthylolpropionique, d'acide carminique et d'acide gallique.

6. Procédé de fabrication d'une plaque d'impression lithographique selon n'importe lesquelles des revendications 1, 2, 3 et 5, dans lequel l'ion d'acide hydroxycarboxylique de faible masse moléculaire est un ion d'un acide hydroxycarboxylique qui possède au moins quatre groupes hydroxyle.

7. Procédé de fabrication d'une plaque d'impression lithographique selon n'importe lesquelles des revendications 1 à 6, dans lequel le tensioactif contenu dans la solution aqueuse est un tensioactif amphotère.

8. Procédé de fabrication d'une plaque d'impression lithographique selon n'importe lesquelles des revendications 1 à 7, dans lequel le tampon à pH est au moins un type choisi parmi (a) un ion carbonate et un ion bicarbonate, (b) un ion borate, et (c) un composé d'amine hydrosoluble et un ion de ce composé d'amine hydrosoluble.

9. Procédé de fabrication d'une plaque d'impression lithographique selon n'importe lesquelles des revendications 1 à 8, dans lequel le colorant sensibilisateur (i) présente un maximum d'absorption dans la plage de longueurs d'onde de 350 nm à 450 nm.

10. Procédé de fabrication d'une plaque d'impression lithographique selon n'importe lesquelles des revendications 1 à 9, dans lequel le colorant sensibilisateur (i) est un colorant sensibilisateur représenté par n'importe lesquelles des formules générales (1) à (5) suivantes : 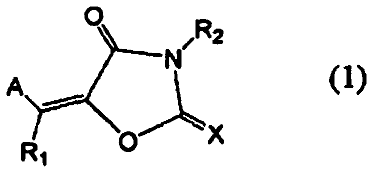 (dans la formule (1), A représente un hétérocycle ou cycle aromatique éventuellement substitué ; X représente un atome d'oxygène, un atome de soufre, ou N-(R₃) ; R₁, R₂, et R₃ représentent chacun indépendamment un groupe d'atomes non métallique monovalent ; A et R₁ peuvent être liés l'un à l'autre pour former un cycle aliphatique ou aromatique ; et R₂ et R₃ peuvent être
liés l'un à l'autre pour former un cycle aliphatique ou aromatique) 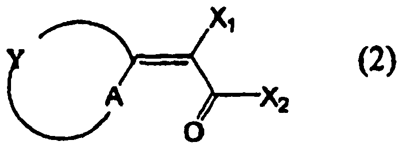 (dans la formule (2), A représente un atome S ou NR₆ ; R₆ représente un groupe d'atomes non métallique monovalent ; Y représente un groupe d'atomes non métallique monovalent qui, en combinaison avec un A adjacent et un atome de carbone adjacent, forme le noyau basique d'un colorant ; X₁ et X₂ représentent chacun indépendamment un groupe d'atomes non métallique monovalent ; et X₁ et X₂ peuvent être liés l'un à l'autre pour former le noyau acide du colorant) 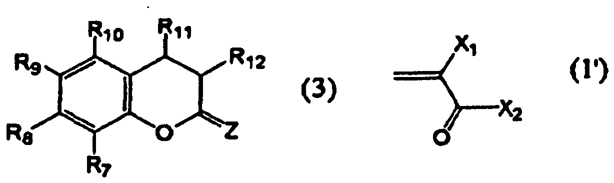 (dans la formule (3), = Z représente un groupe oxo, un groupe thioxo, un groupe imino, ou le groupe alkylidène représenté par la sous-formule développée (1') donnée ci-dessus ; X₁ et X₂ sont définis comme dans la formule générale (2) ; et R₇ à R₁₂ représentent chacun indépendamment un groupe d'atomes non métallique monovalent) 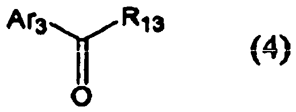 (dans la formule (4), Ar₃ représente un groupe aromatique ou hétéroaromatique éventuellement substitué et R₁₃ représente un groupe d'atomes non métallique monovalent, R₁₃ étant de préférence un groupe aromatique ou hétéroaromatique et Ar₃ et R₁₃ pouvant être liés l'un à l'autre pour former un cycle) 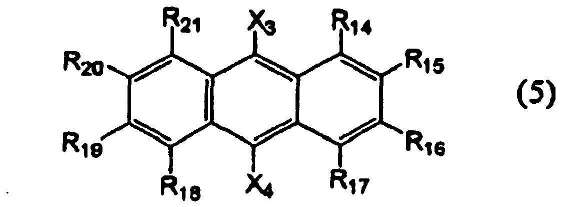 (dans la formule (5), X₃, X₄, et R₁₄ à R₂₁ représentent chacun indépendamment un groupe d'atomes non métallique monovalent, X₃ et X₄ étant de préférence des groupes donneurs d'électrons qui ont une constante de substituant de Hammett négative).

11. Procédé de fabrication d'une plaque d'impression lithographique selon n'importe lesquelles des revendications 1 à 10, dans lequel le liant polymère (iv) a un groupe acide en position de chaîne latérale.

12. Procédé de fabrication d'une plaque d'impression lithographique selon la revendication 11, dans lequel le groupe acide est le groupe acide carboxylique.

13. Procédé de fabrication d'une plaque d'impression lithographique selon n'importe lesquelles des revendications 1 à 12, dans lequel le précurseur de plaque d'impression lithographique comporte une couche protectrice sur la couche d'enregistrement d'image.

14. Procédé de fabrication d'une plaque d'impression lithographique selon n'importe lesquelles
des revendications 1 à 13, qui est réalisé au moyen d'un traitement à un seul liquide à l'aide de la solution aqueuse.

15. Plaque d'impression lithographique obtenue par le procédé de fabrication selon n'importe lesquelles des revendications 1 à 14.
